# EUROPEAN PATENT APPLICATION

(11) **EP 4 761 503 A1**
(43) Date of publication of application: **17.06.2026**
(21) Application number: 25189080.2
(22) Date of filing: 11.07.2025
(51) Int. Cl.: H10D 30/01, H10D 30/47, H10D 62/10, H10D 62/17, H10D 64/00, H10D 62/85, H10D 64/23

(54) **SEMICONDUCTOR DEVICE**

(30) Priority: 12.12.2024 KR 20240185165
(71) Applicant: Samsung Electronics Co., Ltd., Suwon-si, Gyeonggi-do 16677 (KR)
(72) Inventor: PARK, Junhyuk, Suwon-si (KR); KIM, Jongseob, Suwon-si (KR); YANG, Seong Seok, Suwon-si (KR); OH, Jaejoon, Suwon-si (KR); HWANG, In Jun, Suwon-si (KR)
(74) Representative: Marks & Clerk LLP

(57) **Abstract**

A semiconductor device comprises a substrate, a channel layer on the substrate, a barrier layer on the channel layer, a gate electrode on the barrier layer, a source electrode and a drain electrode on opposite sides of the gate electrode, the source electrode and the drain electrode are connected to the channel layer, a first field dispersion layer connected to the source electrode, the first field dispersion layer extending from above the gate electrode toward the drain electrode, and a doping region extending from an upper surface of the barrier layer toward an upper surface of the substrate, wherein one side surface of the doping region is closer to the drain electrode than a side surface of the first field dispersion layer, the one side surface of the doping region is between the gate electrode and the drain electrode.

## Description

### BACKGROUND

The disclosure relates to a semiconductor device.

**In** modern society, semiconductor devices are closely related to our daily lives. In particular, the importance of power semiconductor devices used in various fields such as transportation such as electric vehicles, railways, and electric trams, renewable energy systems such as solar power generation and wind power generation, and mobile devices is gradually increasing. Power semiconductor devices are semiconductor devices used to handle high voltage or high current, and perform functions such as power conversion and control in large power systems or high-power electronic devices. Power semiconductor devices have the ability to handle high power and durability, allowing them to handle large amounts of current and withstand high voltages. For example, power semiconductor devices may handle voltages from hundreds to thousands of volts and currents from tens to thousands of amperes. Power semiconductor devices may improve the efficiency of electrical energy by minimizing or otherwise reducing power loss. In addition, power semiconductor devices may be operated stably even in environments such as high temperatures.

These power semiconductor devices may be classified by material, for example, there are SiC power semiconductor devices and GaN power semiconductor devices. By manufacturing power semiconductor devices using SiC or GaN instead of existing silicon (Si), the shortcomings of silicon, which has unstable characteristics at high temperatures, may be complemented. SiC power semiconductor devices are resistant to high temperatures and have low power loss, making them suitable for electric vehicles and renewable energy systems. GaN power semiconductor devices are expensive but efficient in terms of speed, making them suitable for fast charging of mobile devices.

### SUMMARY

The disclosure provides a semiconductor device capable of reducing an electric field applied around a gate semiconductor layer and a gate electrode when a high voltage is applied.

According to some example embodiments, a semiconductor device comprises a substrate, a channel layer on the substrate, a barrier layer on the channel layer, a gate electrode on the barrier layer, a source electrode and a drain electrode on opposite sides of the gate electrode, the source electrode and the drain electrode are connected to the channel layer, a first field dispersion layer connected to the source electrode, the first field dispersion layer extending from above the gate electrode toward the drain electrode, and a doping region extending from an upper surface of the barrier layer toward an upper surface of the substrate, wherein one side of the doping region is closer to the drain electrode than a side surface of the first field dispersion layer, the one side surface of the doping region is between the gate electrode and the drain electrode.

According to some example embodiments, a semiconductor device comprises a substrate, a channel layer on the substrate, a barrier layer on the channel layer, a gate electrode on the barrier layer, a source electrode and a drain electrode on opposite sides of the gate electrode, the source electrode and the drain electrode are connected to the channel layer, a first field dispersion layer connected to the source electrode, the first field dispersion layer extending from above the gate electrode toward the drain electrode, and a doping region buried below an upper surface of the barrier layer, wherein a distance between the doping region and the drain electrode is shorter than a distance between the first field dispersion layer and the drain electrode.

According to some example embodiments, a semiconductor device comprises a substrate, a channel layer on the substrate, a barrier layer on the channel layer, a gate electrode on the barrier layer, a source electrode and a drain electrode on opposite sides of the gate electrode, the source electrode and the drain electrode are connected to the channel layer, a first field dispersion layer connected to the source electrode, the first field dispersion layer extending from above the gate electrode toward the drain electrode, and a doping region surrounded by the barrier layer, wherein at least a portion of the doping region overlaps the gate electrode in a direction perpendicular to an upper surface of the substrate, wherein an upper surface of the doping region is at a same level as an upper surface of the barrier layer, and wherein one side of the doping region is closer to the drain electrode than a side surface of the first field dispersion layer, the side surface of the first field dispersion layer is between the gate electrode and the drain electrode.

According some example embodiments, a method for manufacturing a semiconductor device may include the steps of forming a channel layer and a barrier layer on a substrate, forming a gate semiconductor layer and a gate electrode extending in a direction parallel to an upper surface of the substrate on the barrier layer, forming a first protective layer covering the gate semiconductor layer and the gate electrode, forming a photoresist pattern including an opening exposing a portion of the first protective layer covering one side surface of the gate semiconductor layer and the gate electrode and a portion of the barrier layer adjacent thereto, injecting a dopant of the same type as the gate semiconductor layer through the opening to form a doping region, removing the photoresist pattern, forming a first source electrode penetrating the first protective layer and the barrier layer and connected to the channel layer, a first field dispersion layer connected to the first source electrode and covering the gate electrode on the first protective layer, and a first drain electrode. The first source electrode and the first drain electrode are positioned on opposite sides of the gate electrode, and one side of the doping region may be closer to the first drain electrode than a side of the first field dispersion layer positioned between the gate electrode and the first drain electrode.

The method for manufacturing a semiconductor device according to some example embodiments may further include the steps of forming a second protective layer covering the first source electrode, the first field dispersion layer, the first protective layer, and the first drain electrode, and forming a second source electrode penetrating the second passivation layer and connected to the first source electrode, a second field dispersion layer connected to the second source electrode and covering the first field dispersion layer on the second protective layer, and a second drain electrode penetrating the second protective layer and connected to the first drain electrode. One side of the doping region may be farther from the first drain electrode than a side of the second field dispersion layer positioned between the gate electrode and the second drain electrode.

In some example embodiments, in the step of forming the doping region, the dopant may be injected in a direction oblique to a direction perpendicular to an upper surface of the substrate.

In some example embodiments, in the step of forming the doping region, a depth of the doping region may be controlled by controlling an energy for injecting the dopant.

According to some example embodiments, a semiconductor device comprising a substrate; a channel layer on the substrate; a barrier layer on the channel layer; a gate electrode on the barrier layer; a source electrode and a drain electrode on opposite sides of the gate electrode, the source electrode and the drain electrode are connected to the channel layer; a first field dispersion layer connected to the source electrode, the first field dispersion layer extending from above the gate electrode toward the drain electrode; and a doping region extending from an upper surface of the barrier layer toward an upper surface of the substrate, the doping region vertically overlapping the first field dispersion layer between the gate electrode and the drain electrode.

According to some example embodiments, an electric field applied around a gate semiconductor layer and a gate electrode of a semiconductor device may be alleviated when a high voltage is applied.

At least some of the above and other features of the invention are set out in the claims.

### BRIEF DESCRIPTION OF THE DRAWINGS

FIG. 1 is a plan view of a semiconductor device according to some example embodiments.
FIG. 2 is a cross-sectional view of a semiconductor device according to some example embodiments taken along line A-A' of FIG. 1.
FIG. 3 is a cross-sectional view of a semiconductor device according to some example embodiments taken along line A-A' of FIG. 1.
FIGS. 4 and 5 are each a plan view of a semiconductor device according to some example embodiments.
FIG. 6 is a plan view of a semiconductor device according to some example embodiments.
FIG. 7 is a cross-sectional view of a semiconductor device according to some example embodiments taken along line B-B' of FIG. 6.
FIG. 8 is a cross-sectional view of a semiconductor device according to some example embodiments taken along line B-B' of FIG. 6.
FIGS. 9 and 10 are each a plan view of a semiconductor device according to some example embodiments.
FIG. 11 is a plan view of a semiconductor device according to some example embodiments.
FIG. 12 is a cross-sectional view of a semiconductor device according to some example embodiments taken along line C-C' of FIG. 11.
FIGS. 13 and 14 are each a cross-sectional view of a semiconductor device according to some example embodiments taken along line C-C' of FIG. 11.
FIGS. 15, 16, and 17 are each a plan view of a semiconductor device according to some example embodiments.
FIG. 18 is a plan view of a semiconductor device according to some example embodiments.
FIG. 19 is a cross-sectional view of a semiconductor device according to some example embodiments taken along line D-D' of FIG. 18.
FIG. 20 is a cross-sectional view of a semiconductor device according to some example embodiments taken along line E-E' of FIG. 18.
FIGS. 21, 22, 23, 24, 25, 26, and 27 are cross-sectional views showing a manufacturing process of a semiconductor device according to some example embodiments.
FIGS. 28, 29, 30, 31, 32, 33, and 34 are cross-sectional views showing a manufacturing process of a semiconductor device according to some example embodiments.
FIG. 35, FIG. 36, FIG. 37, FIG. 38, FIG. 39, FIG. 40, FIG. 41, FIG. 42, FIG. 43, FIG. 44, and FIG. 45 are cross-sectional views showing a manufacturing process of a semiconductor device according to some example embodiments.
FIG. 46, FIG. 47, FIG. 48, FIG. 49, FIG. 50, FIG. 51, FIG. 52, FIG. 53, FIG. 54, FIG. 55, FIG. 56, FIG. 57, FIG. 58, FIG. 59, FIG. 60, and FIG. 61 are cross-sectional views showing a manufacturing process of a semiconductor device according to some example embodiments.

### DETAILED DESCRIPTION

Hereinafter, various example embodiments of the disclosure will be described in detail with reference to the attached drawings so that a person having ordinary skill in the art to which the disclosure pertains may easily implement the example embodiments. The disclosure may be embodied in many different forms and is not limited to the example embodiments described herein.

In order to clearly explain the disclosure, parts irrelevant to the description are omitted, and the same reference numerals are used for identical or similar components throughout the specification.

In addition, a size and a thickness of each component shown in the drawings are arbitrarily shown for convenience of explanation, so the disclosure is not necessarily limited to what is shown. To clearly represent the various layers and areas in the drawings, a thickness is enlarged and shown. In the drawings, for convenience of explanation, thicknesses of some layers and areas are exaggerated.

In addition, when an element such as a layer, film, region, or substrate is referred to as being "on" another element, it may be directly on the other element or intervening elements may also be present. In contrast, when an element is referred to as being "directly on" another element, there are no intervening elements present. Further, when an element is "on" a reference portion, the element is positioned above or below the reference portion, and it does not necessarily mean that the element is positioned "above" or "on" in a direction opposite to gravity.

In addition, throughout the specification, unless explicitly described to the contrary, the word "comprise", and variations such as "comprises" or "comprising", will be understood to imply the inclusion of stated elements but not the exclusion of any other elements.

Further, throughout the specification, "in a plan view" refers to a target part being viewed from above, and "in a cross-sectional view" refers to viewing the cross-section obtained by vertically cutting a target part from the side.

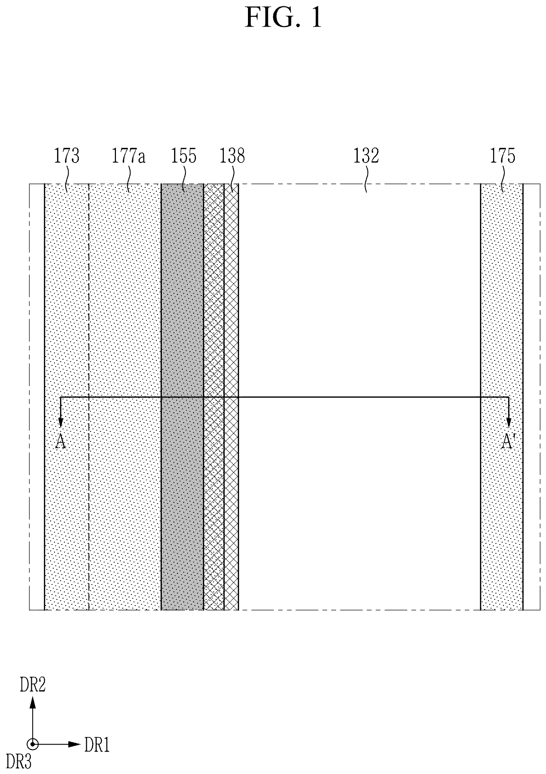

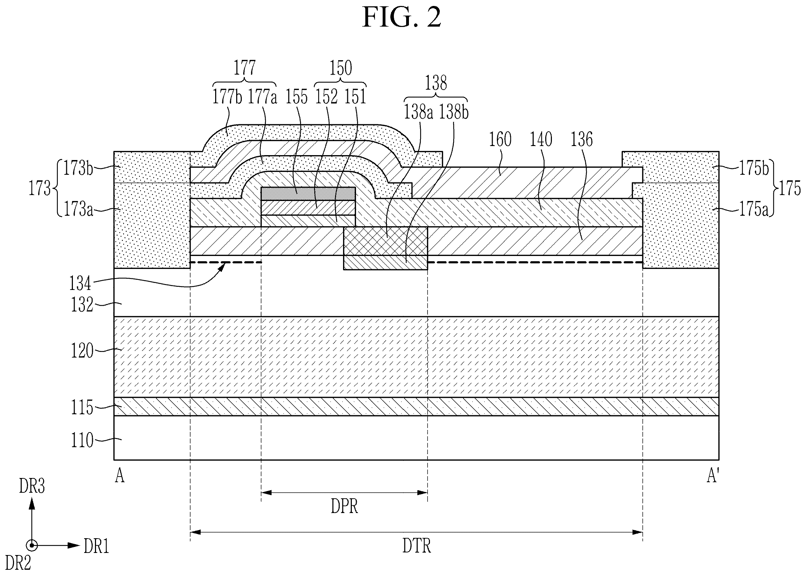

Hereinafter, a semiconductor device according to some example embodiments will be described with reference to FIGS. 1 and 2.

FIG. 1 is a plan view of a semiconductor device according to some example embodiments, and FIG. 2 is a cross-sectional view of the semiconductor device according to some example embodiments taken along line A-A' of FIG. 1. For convenience, only a source electrode 173, a drain electrode 175, a gate electrode 155, a doping region 138, and a first field dispersion layer 177a positioned on the channel layer 132 are illustrated in FIG. 1, and other components are omitted.

Referring to FIGS. 1 and 2, a semiconductor device according to some example embodiments may include a substrate 110, a channel layer 132 positioned on the substrate 110, a barrier layer 136 positioned on the channel layer 132, a gate electrode 155 positioned on the barrier layer 136, a source electrode 173 and a drain electrode 175 positioned on opposite sides of the gate electrode 155 and connected to the channel layer 132, a first field dispersion layer 177a connected to the source electrode 173 and extending from above the gate electrode 155 toward the drain electrode 175, and a doping region 138 extending from the upper surface of the barrier layer 136 toward the upper surface of the substrate 110.

The substrate 110 may include a semiconductor material. For example, the substrate 110 may include Si. For example, the substrate 110 may be a p-type Si substrate doped with p-type impurities, but the example embodiments are not limited thereto. According to some example embodiments, the substrate 110 may be an n-type Si substrate doped with an n-type impurity.

The channel layer 132 may be positioned on the substrate 110. The channel layer 132 is a layer that forms a channel between the source electrode 173 and the drain electrode 175, and a two-dimensional electron gas (2DEG) 134 may be positioned inside the channel layer 132. A two-dimensional electron gas 134 is a charge transport model used in solid-state physics, and refers to a group of electrons that may move freely in two dimensions (e.g., in the x-y plane direction) but may not move in another dimension (e.g., in the z direction) and are tightly bound in the two dimensions. For example, the two-dimensional electron gas 134 may exist in a two-dimensional paper-like form in a three-dimensional space. This two-dimensional electron gas 134 mainly appears in a semiconductor heterojunction structure, and in the semiconductor device according to some example embodiments, it may occur at the interface between the channel layer 132 and the barrier layer 136. For example, the two-dimensional electron gas 134 may be generated in a portion adjacent to the barrier layer 136 in the channel layer 132. The channel layer 132 may include one or more materials selected from group III-V materials, for example, nitrides including Al, Ga, In, B, and/or combinations thereof. The channel layer 132 may be composed of a single layer or multiple layers. The channel layer 132 may be AlₓIn_{y}Ga_{1-x-y}N (0≤x≤1, 0≤y≤1, x + y≤1). For example, the channel layer 132 may include AlN, GaN, InN, InGaN, AlGaN, AlInN, AlInGaN, and/or a combination thereof. The channel layer 132 may be a layer doped with impurities or may be a layer that is not doped with impurities. A thickness of the channel layer 132 may be less than about several hundred nm.

A seed layer 115 and a buffer layer 120 may be positioned between the substrate 110 and the channel layer 132. The substrate 110, the seed layer 115, and the buffer layer 120 are layers for forming the channel layer 132, and may be omitted in some cases. For example, when a substrate made of GaN is used as the channel layer 132, at least one of the substrate 110, the seed layer 115, and the buffer layer 120 may be omitted. Considering that a substrate made of GaN is relatively expensive, a channel layer 132 including GaN may be grown using the substrate 110 made of Si. In this case, as the lattice structure of Si and the lattice structure of GaN are different, it may not be easy to grow the channel layer 132 directly on top of the substrate 110. Accordingly, the seed layer 115 and the buffer layer 120 may be grown first on the substrate 110, and then the channel layer 132 may be grown on the buffer layer 120. Additionally, at least one of the substrate 110, the seed layer 115, and the buffer layer 120 may be removed from the final structure of the semiconductor device after being used in the manufacturing process.

The seed layer 115 may be positioned directly above the substrate 110. However, it is not limited thereto, and another layer may be additionally positioned between the substrate 110 and the seed layer 115. The seed layer 115 is a layer that acts as a seed for growing the buffer layer 120 and the seed layer 115 may be formed of a crystal lattice structure that serves as the seed of the buffer layer 120. The buffer layer 120 may be positioned directly on the seed layer 115. However, it is not limited thereto, and another layer may be additionally positioned between the seed layer 115 and the buffer layer 120. The seed layer 115 may include one or more materials selected from group III-V materials, for example, nitrides including Al, Ga, In, B, and/or combinations thereof. The seed layer 115 may be AlₓIn_{y}Ga_{1-x-y}N (0≤x≤1, 0≤y≤1, x + y≤1). For example, the seed layer 115 may include AlN, GaN, InN, InGaN, AlGaN, AlInN, AlInGaN, and/or a combination thereof.

The buffer layer 120 may be positioned on the seed layer 115. The buffer layer 120 may be positioned between the seed layer 115 and the channel layer 132. The buffer layer 120 may be a layer for alleviating the difference in lattice constant and thermal expansion coefficient between the seed layer 115 and the channel layer 132, or preventing or reducing in likelihood leakage current from flowing through the channel layer 132. The buffer layer 120 may include one or more materials selected from group III-V materials, for example, nitrides including Al, Ga, In, B, and/or a combination thereof. The buffer layer 120 may be AlₓIn_{y}Ga_{1-x-y}N (0≤x≤1, 0≤y≤1, x + y≤1). For example, the buffer layer 120 may include AlN, GaN, InN, InGaN, AlGaN, AlInN, AlInGaN, and/or a combination thereof.

The buffer layer 120 of the semiconductor device may include a superlattice layer positioned on the seed layer 115, and a high-resistance layer positioned on the superlattice layer. The superlattice layer and the high-resistance layer may be sequentially positioned on the substrate 110.

The superlattice layer may be positioned on the seed layer 115. The superlattice layer may be positioned directly on the seed layer 115. However, the example embodiments are not limited to this, and other layers may be additionally positioned between the seed layer 115 and the superlattice layer. The superlattice layer is a layer for alleviating the difference in lattice constant and thermal expansion coefficient between the substrate 110 and the channel layer 132, thereby alleviating or reducing the tensile stress and compressive stress generated between the substrate 110 and the channel layer 132, and alleviating or reducing the stress between all layers formed by growth in the final structure of the semiconductor device according to some example embodiments. The superlattice layer may include one or more materials selected from group III-V materials, for example, nitrides including Al, Ga, In, B, and/or combinations thereof. The superlattice layer may be AlₓIn_{y}Ga_{1-x-y}N (0≤x≤1, 0≤y≤1, x + y≤1). For example, the superlattice layer may include AlN, GaN, InN, InGaN, AlGaN, AlInN, AlInGaN, and/or combinations thereof.

In some example embodiments, the superlattice layer may be formed of multiple layers of alternating layers containing different materials. For example, the superlattice layer may have a structure in which layers made of AlGaN and layers made of AlN are repeatedly stacked. For example, AlGaN/AlN/AlGaN/AlN/AlGaN/AlN may be sequentially stacked to form a superlattice layer. The number of AlGaN layers and GaN constituting the superlattice layer may be varied, and the material constituting the superlattice layer may be varied. As another example, the superlattice layer may have a structure in which layers made of AlGaN and layers made of GaN are repeatedly stacked. For example, AlGaN/GaN/AlGaN/GaN/AlGaN/GaN may be sequentially stacked to form a superlattice layer. In some example embodiments, when the superlattice layer comprises GaN, InN, AlGaN, AlInN, InGaN, AlN, AlInGaN and/or a combination thereof, the superlattice layer may have n-type semiconductor properties in which the concentration of electrons is greater than the concentration of holes, but the example embodiments are not limited thereto.

The high-resistivity layer may be positioned on the superlattice layer. The high-resistivity layer may be positioned directly on the superlattice layer. However, it is not limited to this, and other layers may be additionally positioned between the superlattice layer and the high-resistivity layer. The high-resistance layer may be positioned between the superlattice layer and the channel layer 132. The high resistance layer is a layer that prevents or reduces in likelihood a semiconductor device from deteriorating by preventing or reducing leakage current from flowing through the channel layer 132 according to some example embodiments. The high resistance layer may be made of a material with low conductivity so that the substrate 110 and the channel layer 132 may be electrically insulated. The high-resistance layer may have a resistance value of 1.0×10⁶ Ω·cm or more. For example, the resistance value of the high-resistance layer may be 1.0×10¹⁰ Ω·cm or more. As another example, the resistance value of the high-resistance layer may be greater than or equal to 1.0×10¹² Ω·cm. Resistance values may be measured by forming a measuring electrode in a high-resistance layer and allowing current to flow. The high-resistivity layer may include one or more materials selected from group III-V materials, for example, nitrides including Al, Ga, In, B, and/or combinations thereof. The high-resistivity layer may be AlₓIn_{y}Ga_{1-x-y}N (0≤x≤1, 0≤y≤1, x + y≤1). For example, the high resistivity layer may include AlN, GaN, InN, InGaN, AlGaN, AlInN, AlInGaN, and/or a combination thereof. The high-resistance layer may be composed of a single layer or multiple layers. In an embodiment, when the high resistance layer comprises GaN, InN, AlGaN, AlInN, InGaN, AlN, AlInGaN, and/or a combination thereof, the high resistance layer may have n-type semiconductor characteristics in which the concentration of electrons is greater than the concentration of holes, but the example embodiments are not limited thereto.

The barrier layer 136 may be positioned on the channel layer 132. The barrier layer 136 may be positioned directly on the channel layer 132. However, it is not limited thereto, and another layer may be additionally positioned between the channel layer 132 and the barrier layer 136. The region of the channel layer 132 overlapping the barrier layer 136 between the source electrode 173 and the drain electrode 175 may become a drift region DTR. The drift region DTR may be positioned between the source electrode 173 and the drain electrode 175. The drift region DTR may refer to a region where carriers move when a potential difference occurs between the source electrode 173 and the drain electrode 175.

The semiconductor device according to some example embodiments may be turned on/off depending on whether voltage is applied to the gate electrode 155 and/or the magnitude of the voltage applied to the gate electrode 155, thereby causing or blocking movement of carriers in the drift region DTR.

The barrier layer 136 may include one or more materials selected from group III-V materials, for example, nitrides including Al, Ga, In, B, and/or combinations thereof. The barrier layer 136 may be AlₓIn_{y}Ga_{1-x-y}N (0≤x≤1, 0≤y≤1, x + y≤1). The barrier layer 136 may include GaN, InN, AlGaN, AlInN, InGaN, AlN, AlInGaN, and/or a combination thereof. The energy band gap of the barrier layer 136 may be controlled by the composition ratio of Al and/or In.

The barrier layer 136 may include a semiconductor material having different characteristics from the channel layer 132. The barrier layer 136 may be different from the channel layer 132 in at least one of polarization characteristics, energy band gap, and/or lattice constant. For example, the barrier layer 136 may include a material having a different energy band gap than the channel layer 132. In this case, the barrier layer 136 may have a higher energy band gap than the channel layer 132 and may have a higher electric polarization rate than the channel layer 132. The two-dimensional electron gas 134 may be induced in the channel layer 132 with a relatively low electrical polarization rate by this barrier layer 136. In this respect, the barrier layer 136 may also be called a channel supply layer or a two-dimensional electron gas supply layer. The two-dimensional electron gas 134 may be formed in a portion of the channel layer 132 positioned below the interface between the channel layer 132 and the barrier layer 136. The two-dimensional electron gas 134 may have very high electron mobility.

The barrier layer 136 may be composed of a single layer or multiple layers. When the barrier layer 136 is formed of multiple layers, the materials of each layer constituting the multiple layers may have different energy band gaps. In this case, the multiple layers constituting the barrier layer 136 may be arranged so that the energy band gap of a layer is larger the closer the layer is to the channel layer 132.

The semiconductor device according to some example embodiments may include a doping region 138 extending from the upper surface of a barrier layer 136 toward the upper surface of a substrate 110. The doping region 138 may extend in a third direction DR3 perpendicular to the upper surface of the substrate 110. For example, the doping region 138 may extend from the upper surface of the barrier layer 136 to a level lower than the upper surface of the channel layer 132. The upper surface of the doping region 138 may be positioned at substantially the same level as the upper surface of the barrier layer 136. The lower surface of the doping region 138 may be positioned at a lower level than the upper surface of the channel layer 132. The lower surface of the doping region 138 may be positioned at a higher level than the lower surface of the channel layer 132.

As illustrated in FIG. 2, the doping region 138 may extend below the upper surface of the barrier layer 136. The doping region 138 may be surrounded by the barrier layer 136. The doping region 138 may further extend into an upper portion of the channel layer 132. The doping region 138 may be further surrounded by the channel layer 132. The side of the doping region 138 may be covered by the barrier layer 136 and the channel layer 132. The lower surface of the doping region 138 may be covered by a channel layer 132.

As illustrated in FIG. 1, the doping region 138 may extend in a second direction DR2 parallel to an extension direction of the source electrode 173 and the drain electrode 175 in a plan view. For example, a width of the doping region 138 in the second direction DR2 may be smaller than a width of the source electrode 173 and the drain electrode 175 in the second direction DR2, but the example embodiments are not limited thereto. In some example embodiments, the doping region 138 may extend in the second direction DR2 parallel to an extension direction of the gate electrode 155 in a plan view. For example, the doping region 138 may have a rod shape extending in the second direction DR2 in a plan view, but the example embodiments not limited thereto. The shape of the doping region 138 in a plan view may be changed in various ways.

In some example embodiments, the doping region 138 may be a region in which is doped with impurities in the barrier layer 136 and the channel layer 132. The doping region 138 may include a p-type impurity (or dopant) capable of providing holes. For example, the p-type impurity could be magnesium (Mg). In this case, the doping concentration of the doping region 138 may be lower than the doping concentration of at least a portion of the gate semiconductor layer 150. For example, the doping concentration of the doping region 138 may be lower than that of the second gate semiconductor layer 152. For example, the doping concentration of the doping region 138 may be about 1 * 10¹⁷ cm⁻³ or more and about 1*10¹⁹ cm⁻³ or less, and in some examples about 1*10¹⁷ cm⁻³ or more and about 1*10¹⁸ cm⁻³ or less.

In some example embodiments, a depth of the doping region 138 may be greater than a thickness of the barrier layer 136 and less than the sum of a thicknesses of the barrier layer 136 and the channel layer 132. A depth of the first doping region 138a may be equal to or similar to the thickness of the barrier layer 136, and a depth of the second doping region 138b may be smaller than the thickness of the channel layer 132, but the example embodiments are not limited thereto. The depth of the doping region 138 may mean the thickness in the third direction DR3 of the doping region 138.

In some example embodiments, the thickness of the doping region 138 in the third direction DR3 may be greater than a thickness of the gate semiconductor layer 150 in the third direction DR3. For example, the thickness of the doping region 138 in the third direction DR3 may be about 30 nm or more to about 70 nm or less, and for example about 40 nm or more to about 60 nm or less.

In some example embodiments, the doping region 138 may be positioned in the barrier layer 136 and the channel layer 132, but the example embodiments are not limited thereto. For example, depending on the thickness of the doping region 138 in the third direction DR3, the doping region 138 may be positioned only in the barrier layer 136.

In some example embodiments, the doping region 138 may include a first doping region 138a positioned in the barrier layer 136 and including the same material as the barrier layer 136, and a second doping region 138b positioned in the channel layer 132 and including the same material as the channel layer 132. The first doping region 138a may be a region in which the barrier layer 136 is doped with a p-type impurity, and the second doping region 138b may be a region in which the channel layer 132 is doped with a p-type impurity. For example, as the barrier layer 136 includes AlGaN and the channel layer 132 includes GaN, the first doping region 138a may be formed of a p-AlGaN layer and the second doping region 138b may be formed of a p-GaN layer.

For example, the first doping region 138a and the second doping region 138b may be formed simultaneously in the same process. The first doping region 138a and the second doping region 138b may contain the same dopant. A width of the first doping region 138a in a first direction DR1 may be the same as or similar to a width of the second doping region 138b in the first direction DR1. A width of the first doping region 138a in the second direction DR2 may be the same as or similar to a width of the second doping region 138b along the second direction DR2.

In some example embodiments, a width in the first direction DR1 and a width in the second direction DR2 of the doping region 138 may become narrower as they approach the lower surface of the doping region 138, but the example embodiments are not limited thereto.

The gate electrode 155 may be positioned on the barrier layer 136. The gate electrode 155 may overlap a portion of the barrier layer 136. The gate electrode 155 may overlap a portion of the drift region DTR of the channel layer 132. The gate electrode 155 may be positioned between the source electrode 173 and the drain electrode 175. The gate electrode 155 may be spaced apart from the source electrode 173 and the drain electrode 175 in the first direction DR1. The first direction DR1 may be a direction parallel to the upper surface of the substrate 110 or the upper surface of the channel layer 132. The gate electrode 155 may be positioned approximately at the center between the source electrode 173 and the drain electrode 175. For example, a separation distance along the first direction DR1 between the gate electrode 155 and the source electrode 173 may be similar to a separation distance along the first direction DR1 between the gate electrode 155 and the drain electrode 175. However, the position of the gate electrode 155 is not limited to this and may be changed in various ways. The gate electrode 155 may be positioned closer to the source electrode 173 than to the drain electrode 175. For example, a distance between the gate electrode 155 and the source electrode 173 may be smaller than a distance between the gate electrode 155 and the drain electrode 175.

The gate electrode 155 may extend in the second direction DR2 different from the first direction DR1 in a plan view. The second direction DR2 may be a direction parallel to the upper surface of the substrate 110 or the upper surface of the channel layer 132, and may be a direction intersecting the first direction DR1. For example, the second direction DR2 may be a direction perpendicular to the first direction DR1. The gate electrode 155 may have a rod shape extending along the second direction DR2.

The gate electrode 155 may include a conductive material. For example, the gate electrode 155 may include a metal, a metal alloy, a conductive metal nitride, a metal silicide, a doped semiconductor material, a conductive metal oxide, and/or a conductive metal nitride. For example, the gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbide nitride (TiAlC-N), titanium aluminum carbide (TiAlC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and/or combinations thereof, but is not limited thereto. The gate electrode 155 may be formed of a single layer or multiple layers.

In some example embodiments, a semiconductor device may further include a hard mask layer (not shown) positioned on the gate electrode 155. The hard mask layer may be a hard mask used for patterning a gate electrode material layer or a gate semiconductor material layer when forming a gate electrode 155. However, the hard mask layer may be removed depending on the etching conditions during the etching of the gate semiconductor material layer or depending on the cleaning conditions after the etching. For example, the hard mask layer may include silicon oxide, silicon nitride, silicon oxynitride, or a combination thereof.

The semiconductor device according to some example embodiments may further include a gate semiconductor layer 150 positioned between a barrier layer 136 and a gate electrode 155. In some example embodiments, the gate semiconductor layer 150 may be positioned on the barrier layer 136 and the doping region 138. The gate electrode 155 may be positioned on the gate semiconductor layer 150. The gate electrode 155 may be in contact with the gate semiconductor layer 150. The lower surface of the gate electrode 155 may be in contact with the gate semiconductor layer 150. However, it is not limited thereto, and another layer may be additionally positioned between the gate electrode 155 and the gate semiconductor layer 150. The gate electrode 155 may be in Schottky contact with the gate semiconductor layer 150. However, it is not limited thereto, and in some cases, the gate electrode 155 may be in ohmic contact with the gate semiconductor layer 150. The gate semiconductor layer 150 may overlap the gate electrode 155 in the third direction DR3. The third direction DR3 may be a direction perpendicular to the first direction DR1 and the second direction DR2. For example, the third direction DR3 may be a direction perpendicular to the upper surface of the substrate 110 or the upper surface of the channel layer 132. The gate electrode 155 may be patterned using the same mask as the gate semiconductor layer 150. Therefore, the gate electrode 155 may have substantially the same shape as the gate semiconductor layer 150 in a plan view. The gate electrode 155 may have substantially the same width as the gate semiconductor layer 150.

The gate semiconductor layer 150 may be positioned between the source electrode 173 and the drain electrode 175. The gate semiconductor layer 150 may be spaced apart from the source electrode 173 and the drain electrode 175. The gate semiconductor layer 150 may be positioned approximately at the center between the source electrode 173 and the drain electrode 175. For example, a separation distance along the first direction DR1 between the gate semiconductor layer 150 and the source electrode 173 may be similar to a separation distance along the first direction DR1 between the gate semiconductor layer 150 and the drain electrode 175. However, the position of the gate semiconductor layer 150 is not limited thereto and may be changed in various ways. The gate semiconductor layer 150 may be positioned closer to the source electrode 173 than to the drain electrode 175. For example, a distance between the gate semiconductor layer 150 and the source electrode 173 may be smaller than a distance between the gate semiconductor layer 150 and the drain electrode 175.

The gate semiconductor layer 150 may include one or more materials selected from group III-V materials, for example, nitrides including at least one of Al, Ga, In, and B. The gate semiconductor layer 150 may be AlₓIn_{y}Ga_{1-x-y}N (0≤x≤1, 0≤y≤1, x + y≤1). For example, the gate semiconductor layer 150 may include at least one of AlN, GaN, InN, InGaN, AlGaN, AlInN, and AlInGaN. In some example embodiments, the gate semiconductor layer 150 may include a first gate semiconductor layer 151 and a second gate semiconductor layer 152. The first gate semiconductor layer 151 may include the same material as the barrier layer 136, and the second gate semiconductor layer 152 may include a material having a different energy band gap from the barrier layer 136. The first gate semiconductor layer 151 may be a part of the barrier layer 136. The first gate semiconductor layer 151 may be formed by patterning a portion of an upper portion of the barrier layer 136 together with the second gate semiconductor layer 152. For example, the barrier layer 136 and the first gate semiconductor layer 151 may include AlGaN, and the second gate semiconductor layer 152 may include GaN. For example, the gate semiconductor layer 150 may include GaN, and the barrier layer 136 may include AlGaN. The gate semiconductor layer 150 may be doped with impurities. In this case, the impurity doped into the gate semiconductor layer 150 may be a p-type impurity capable of providing holes. For example, the first gate semiconductor layer 151 may include AlGaN doped with p-type impurities, and the second gate semiconductor layer 152 may include GaN doped with p-type impurities. For example, the first gate semiconductor layer 151 may be formed of a p-AlGaN layer, and the second gate semiconductor layer 152 may be formed of a p-GaN layer. For example, the impurity doped into the gate semiconductor layer 150 may be magnesium (Mg). In Fig. 2, the gate semiconductor layer 150 is illustrated as consisting of two layers, but the example embodiments are not limited thereto. For example, the gate semiconductor layer 150 may be formed of a single layer or three or more layers. For example, the gate semiconductor layer 150 may be composed only of a p-GaN layer.

A depletion region DPR may be formed in the channel layer 132 by the gate semiconductor layer 150. The depletion region DPR may be positioned in the drift region DTR and may have a narrower width than the drift region DTR in the first direction. As the gate semiconductor layer 150 including a p-type impurity capable of providing holes is positioned on the barrier layer 136, the depletion region DPR may be formed as electrons are pushed out to the region of the channel layer 132 overlapping the gate semiconductor layer 150. The depletion region DPR may be a region in the channel path of the channel layer 132 where the two-dimensional electron gas 134 is not formed or has a lower electron concentration than the remaining region. For example, the depletion region DPR may mean a region where the flow of two-dimensional electron gas 134 is cut off in the drift region DTR. As the depletion region DPR occurs, no current flows between the source electrode 173 and the drain electrode 175, and the channel path may be blocked or reduced. Accordingly, the semiconductor device according to some example embodiments may have normally off characteristics.

For example, the semiconductor device according to some example embodiments may be a normally-off high electron mobility transistor (HEMT). In a normal state where no voltage is applied to the gate electrode 155, a depletion region DPR exists, and the semiconductor device according to some example embodiments may be in an off state. When a voltage higher than the threshold voltage is applied to the gate electrode 155, at least a portion of the depletion region DPR disappears, and the two-dimensional electron gas 134 may be connected without disconnection in the drift region DTR. For example, the two-dimensional electron gas 134 connected along the first direction DR1 may be formed in the channel path between the source electrode 173 and the drain electrode 175, and the semiconductor device according to some example embodiments may be in an on state. In summary, the semiconductor device according to some example embodiments may include semiconductor layers having different electrical polarization characteristics, and a semiconductor layer having a relatively large polarization rate may induce the two-dimensional electron gas 134 in another semiconductor layer heterojunction therewith. This two-dimensional electron gas 134 may be used as a channel between the source electrode 173 and the drain electrode 175, and the flow of this two-dimensional electron gas 134 may be continued or interrupted by the bias voltage applied to the gate electrode 155. In the gate-off state, the flow of two-dimensional electron gas 134 is blocked, so that no current may flow between the source electrode 173 and the drain electrode 175. As the flow of two-dimensional electron gas 134 continues in the gate-on state, current may flow between the source electrode 173 and the drain electrode 175.

In some example embodiments, at least a portion of the doping region 138 may be in contact with the gate semiconductor layer 150. A first doping region 138a positioned in the barrier layer 136 may be in contact with a first gate semiconductor layer 151 positioned directly on the barrier layer 136. At least a portion of the upper surface of the first doping region 138a may be in contact with at least a portion of the lower surface of the first gate semiconductor layer 151.

In some example embodiments, at least a portion of the doping region 138 may overlap the gate electrode 155 in a third direction DR3 perpendicular to the upper surface of the substrate 110. At least a portion of the doping region 138 may overlap the gate semiconductor layer 150 in the third direction DR3 perpendicular to the upper surface of the substrate 110.

As the doping region 138 overlaps the gate semiconductor layer 150 in the third direction DR3, an interface where the first doping region 138a and the first gate semiconductor layer 151 contact may have a width along the first direction DR1 in a plan view. For example, the interface where the first doping region 138a and the first gate semiconductor layer 151 contact may have a band shape extending in the second direction DR2, but the example embodiments are not limited thereto.

The width of the depletion region DPR in the channel layer 132 along the first direction DR1 may be increased by the doping region 138. As a doping region 138 including a p-type impurity capable of providing holes is positioned in the barrier layer 136 and the channel layer 132, a depletion region DPR may be further formed as electrons are pushed out to the region of the channel layer 132 adjacent to the doping region 138.

The seed layer 115, buffer layer 120, channel layer 132, barrier layer 136, and gate semiconductor layer 150 described above may be sequentially stacked on the substrate 110. In the semiconductor device according to some example embodiments, at least one of the seed layer 115, the buffer layer 120, the channel layer 132, the barrier layer 136, and/or the gate semiconductor layer 150 may be omitted. These seed layer 115, buffer layer 120, channel layer 132, barrier layer 136, and/or gate semiconductor layer 150 may be formed of the same base semiconductor material, and the material composition ratio of each layer may be different in consideration of the role of each layer, performance required for the semiconductor device, etc.

The semiconductor device according to some example embodiments may further include a first protective layer 140 positioned over a barrier layer 136, a gate semiconductor layer 150, and a gate electrode 155. The first protective layer 140 may cover the upper surface of the barrier layer 136. The first protective layer 140 may cover the upper surface of the doping region 138. The first protective layer 140 may cover the side surface of the gate semiconductor layer 150 and may cover the upper surface and the side surface of the gate electrode 155. The barrier layer 136, doping region 138, gate semiconductor layer 150, and gate electrode 155 may be protected by the first protective layer 140 and separated from other components. The first protective layer 140 may include an insulating material. For example, the first protective layer 140 may include an oxide such as SiO₂ or Al₂O₃. As another example, the first protective layer 140 may include a nitride such as SiN or an oxynitride such as SiON. The first protective layer 140 may be composed of a single layer or multiple layers.

The source electrode 173 and the drain electrode 175 may be positioned on the channel layer 132. The source electrode 173 and the drain electrode 175 may be spaced apart from each other, and the gate electrode 155 and the gate semiconductor layer 150 may be positioned between the source electrode 173 and the drain electrode 175. The gate electrode 155 and the gate semiconductor layer 150 are spaced apart from the source electrode 173 and the drain electrode 175. The source electrode 173 may be electrically connected to the channel layer 132 on one side of the gate electrode 155. The drain electrode 175 may be electrically connected to the channel layer 132 on the other side of the gate electrode 155. The source electrode 173 and the drain electrode 175 may be positioned outside the drift region DTR of the channel layer 132. An interface between the source electrode 173 and the channel layer 132 may be one edge of the drift region DTR. Similarly, an interface between the drain electrode 175 and the channel layer 132 may be the other edge of the drift region DTR. However, the example embodiments are not limited thereto, and the source electrode 173 and the drain electrode 175 may not be positioned outside the drift region DTR of the channel layer 132. In this case, the channel layer 132 may not be recessed, and the source electrode 173 and the drain electrode 175 may be positioned on the upper surface of the channel layer 132. Alternatively, the barrier layer 136 may not be penetrated, and a portion of the barrier layer 136 may be recessed so that the source electrode 173 and the drain electrode 175 are positioned on the upper surface of the barrier layer 136. The bottom surfaces of the source electrode 173 and the drain electrode 175 may be in contact with the upper surface of the barrier layer 136. The portion of the channel layer 132 or barrier layer 136 in contact with the source electrode 173 and the drain electrode 175 may be highly doped. In this case, carriers passing through the two-dimensional electron gas 134 may be transferred to the source electrode 173 and the drain electrode 175 through a portion of the channel layer 132 and/or barrier layer 136 that is doped at a high concentration, e.g., the upper portion of the two-dimensional electron gas 134. The source electrode 173 and the drain electrode 175 may not be in direct contact with the two-dimensional electron gas 134 in a horizontal direction. The horizontal direction may mean a direction parallel to the upper surface of the channel layer 132 or the barrier layer 136. However, the example embodiments are not so limited thereto.

The source electrode 173 and the drain electrode 175 may be positioned on the first protective layer 140. Trenches penetrating the first protective layer 140 and the barrier layer 136 and recessing the upper surface of the channel layer 132 may be positioned spaced apart from each other on opposite sides of the gate electrode 155. A source electrode 173 and a drain electrode 175 may be respectively positioned in trenches positioned on opposite sides of the gate electrode 155. The source electrode 173 and the drain electrode 175 may be formed to fill the inside of the trench. In the trench, the source electrode 173 and the drain electrode 175 may be in contact with the channel layer 132 and the barrier layer 136. The channel layer 132 may form the bottom surface and side walls of the trench, and the barrier layer 136 may form the side walls of the trench. Therefore, the source electrode 173 and the drain electrode 175 may be in contact with the upper surface and the side surface of the channel layer 132. Additionally, the source electrode 173 and the drain electrode 175 may be in contact with the side surface of the barrier layer 136. For example, the source electrode 173 and the drain electrode 175 may cover the side surfaces of the channel layer 132 and the barrier layer 136. The upper surfaces of the source electrode 173 and the drain electrode 175 may protrude more than the upper surface of the first protective layer 140. In some cases, at least one of the source electrode 173 and the drain electrode 175 may cover at least a portion of the upper surface of the first protective layer 140.

The source electrode 173 and the drain electrode 175 may be spaced apart in the first direction DR1. The source electrode 173 and the drain electrode 175 may extend in the second direction DR2 in a plan view. The source electrode 173 and the drain electrode 175 may extend in a direction parallel to the gate electrode 155.

The source electrode 173 and the drain electrode 175 may include a conductive material. For example, the source electrode 173 and the drain electrode 175 may include a metal, a metal alloy, a conductive metal nitride, a metal silicide, a doped semiconductor material, a conductive metal oxide, and/or a conductive metal oxynitride. For example, the source electrode 173 and the drain electrode 175 may be formed of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbide nitride (TiAlC-N), titanium aluminum carbide (TiAlC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and/or combinations thereof, but is not limited thereto. The source electrode 173 and the drain electrode 175 may be formed of a single layer or multiple layers. The source electrode 173 and the drain electrode 175 may be in ohmic contact with the channel layer 132. The region in contact with the source electrode 173 and the drain electrode 175 in the channel layer 132 may be doped at a relatively high concentration compared to other regions.

The field dispersion layer 177 may be positioned between the source electrode 173 and the drain electrode 175. The field dispersion layer 177 may overlap the gate electrode 155 in the third direction DR3. The gate electrode 155 may be covered by the field dispersion layer 177. The field dispersion layer 177 may be electrically connected to the source electrode 173. The field dispersion layer 177 may include the same material as the source electrode 173 and may be positioned in the same layer as the source electrode 173.

However, the example embodiments are not limited thereto, and the field dispersion layer 177 may be a separate component separated from the source electrode 173. Additionally, the field dispersion layer 177 may be positioned in a different layer from the source electrode 173 and may be formed in a different process. In some example embodiments, the field dispersion layer 177 may be electrically connected to the gate electrode 155. For example, an opening overlapping the gate electrode 155 may be formed in the first protective layer 140, and the field dispersion layer 177 may be connected to the gate electrode 155 through the opening. In this case, the field dispersion layer 177 may not be connected to the source electrode 173.

The field dispersion layer 177 may disperse the electric field concentrated around the gate electrode 155. When a high voltage is applied to the drain electrode 175 in the gate-off state, an electric field may be concentrated around the gate electrode 155. When an electric field is concentrated on the gate electrode 155, leakage current may increase and breakdown voltage may decrease. The electric field concentrated around the gate electrode 155 may be dispersed by the field dispersion layer 177, thereby reducing the leakage current and increasing the breakdown voltage.

As shown in Fig. 2, the source electrode 173 and the drain electrode 175 may be formed as a double layer. For example, the source electrode 173 may include a plurality of source electrodes 173a, 173b sequentially stacked in the third direction DR3 on the channel layer 132, and the drain electrode 175 may include a plurality of drain electrodes 175a, 175b sequentially stacked in the third direction DR3 on the channel layer 132. The plurality of source electrodes 173a, 173b may include a first source electrode 173a and a second source electrode 173b, and the plurality of drain electrodes 175a, 175b may include a first drain electrode 175a and a second drain electrode 175b. However, it is not limited thereto, and the source electrode 173 and the drain electrode 175 may be formed as a single layer or may include three or more layers.

In FIG. 2, a semiconductor device according to some example embodiments are illustrated as including two field dispersion layers 177a, 177b, but the number of field dispersion layers 177 is not limited thereto. For example, the field dispersion layer 177 may include a plurality of field dispersion layers 177a, 177b that overlap the gate electrode 155 in the third direction DR3. Each of the plurality of field dispersion layers 177a, 177b may be positioned between the plurality of pairs of source electrodes 173 and drain electrodes 175. Each of the plurality of field dispersion layers 177a, 177b may be electrically connected to the plurality of source electrodes 173a, 173b. Each of the plurality of field dispersion layers 177a, 177b may be formed integrally with each of the plurality of source electrodes 173a, 173b, but the example embodiments are not necessarily limited thereto.

For example, the plurality of field dispersion layers 177a, 177b may include a first field dispersion layer 177a and a second field dispersion layer 177b. The first field dispersion layer 177a may be formed simultaneously with the first source electrode 173a in the same process, and the second field dispersion layer 177b may be formed simultaneously with the second source electrode 173b in the same process. In some example embodiments, the boundary between the first field dispersion layer 177a and the first source electrode 173a is not clear, and the first field dispersion layer 177a may be formed integrally with the first source electrode 173a. In some example embodiments, the boundary between the second field dispersion layer 177b and the second source electrode 173b is not clear, and the second field dispersion layer 177b may be formed integrally with the second source electrode 173b.

Among the plurality of field dispersion layers 177a, 177b, the second field dispersion layer 177b may entirely cover the first field dispersion layer 177a located between the second field dispersion layer 177b and the gate electrode 155. A width of the second field dispersion layer 177b may be larger than a width of the first field dispersion layer 177a. The width of the first field dispersion layer 177a and the width of the second field dispersion layer 177b may mean the length along the first direction DR1 extending from the source electrode 173 to the drain electrode 175.

The semiconductor device according to some example embodiments may further include a second protective layer 160 positioned between the plurality of field dispersion layers 177a, 177b. The plurality of field dispersion layers 177a, 177b may be spaced apart from each other in the third direction DR3 by the second protective layer 160. The second protective layer 160 may be positioned between the first field dispersion layer 177a and the second field dispersion layer 177b.

The second protective layer 160 may be positioned on the first protective layer 140 and the first field dispersion layer 177a. The second protective layer 160 may cover the upper surface of the first protective layer 140. The second protective layer 160 may cover the upper surface and the side surface of the first field dispersion layer 177a. The second protective layer 160 may cover the side surface of the first drain electrode 175a. In some cases, the second protective layer 160 may cover at least a portion of the upper surface of at least one of the first source electrode 173a and the first drain electrode 175a.

The second source electrode 173b, the second field dispersion layer 177b, and the second drain electrode 175b may be positioned on the second protective layer 160. Each of the second source electrode 173b and the second drain electrode 175b may penetrate the second protective layer 160 and contact with the upper surface of the first source electrode 173a and the first drain electrode 175a. The second field dispersion layer 177b may cover at least a portion of the upper surface of the second protective layer 160. In some cases, at least one of the second source electrode 173b and the second drain electrode 175b may cover at least a portion of the upper surface of the second protective layer 160.

The second protective layer 160 may include an insulating material. For example, the second protective layer 160 may include an oxide such as SiO₂ or Al₂O₃. As another example, the second protective layer 160 may include a nitride such as SiN or an oxynitride such as SiON. The second protective layer 160 may be composed of a single layer or multiple layers. The second protective layer 160 and the first protective layer 140 may include a same material or a different material.

Hereinafter, a first side of the doping region 138 may mean a side adjacent to the drain electrode 175 among the two sides along the first direction DR1 of the doping region 138, and a second side of the doping region 138 may mean a side adjacent to the source electrode 173 among the two sides along the first direction DR1 of the doping region 138.

In some example embodiments, the first side of the doping region 138 may be closer to the drain electrode 175 than the side of the first field dispersion layer 177a positioned between the gate electrode 155 and the drain electrode 175. The first side of the doping region 138 may be closer to the drain electrode 175 than the side of the gate electrode 155 adjacent to the drain electrode 175. The first side of the doping region 138 may be farther from the drain electrode 175 than the side of the second field dispersion layer 177b located between the gate electrode 155 and the drain electrode 175. The first side of the doping region 138 may be positioned between an extension of the side of the first field dispersion layer 177a located between the gate electrode 155 and the drain electrode 175 and an extension of the side of the second field dispersion layer 177b located between the gate electrode 155 and the drain electrode 175.

In other words, the distance between the doping region 138 and the drain electrode 175 may be shorter than the distance between the first field dispersion layer 177a and the drain electrode 175. The distance between the doping region 138 and the drain electrode 175 may be shorter than the distance between the gate electrode 155 and the drain electrode 175. The distance between the doping region 138 and the drain electrode 175 may be longer than the distance between the second field dispersion layer 177b and the drain electrode 175. Here, the distance between the doping region 138 and the drain electrode 175, the distance between the gate electrode 155 and the drain electrode 175, the distance between the first field dispersion layer 177a and the drain electrode 175, and the distance between the second field dispersion layer 177b and the drain electrode 175 may mean a distance spaced along the first direction DR1.

In some example embodiments, the second side of the doping region 138 may be farther from the source electrode 173 than the side of the gate electrode 155 adjacent to the source electrode 173, but the example embodiments are not limited thereto. In other words, the distance between the doping region 138 and the source electrode 173 may be longer than the distance between the gate electrode 155 and the source electrode 173, but the example embodiments are not limited thereto. Here, the distance between the doping region 138 and the source electrode 173, and the distance between the gate electrode 155 and the source electrode 173 may mean a distance spaced along the first direction DR1.

In some example embodiments, as the doping region 138 and the gate electrode 155 overlap along the third direction DR3, the second side of the doping region 138 may be farther from the drain electrode 175 than the side of the gate electrode 155 adjacent to the drain electrode 175, but the example embodiments are not limited thereto.

According to some example embodiments, the semiconductor device includes a p-type impurity in a barrier layer 136 and a channel layer 132 and includes a doping region 138 adjacent to a drain electrode 175 rather than a gate electrode 155 and a gate semiconductor layer 150 (e.g., between the drain electrode 175 and the gate electrode 155 and/or the gate semiconductor layer 150), so that when a high voltage is applied to the drain electrode 175, an electric field applied around the gate semiconductor layer 150 and the gate electrode 155 may be alleviated. The doping region 138 may protect the gate semiconductor layer 150 and the gate electrode 155 from a high voltage applied to the drain electrode 175.

As the doping region 138 of the semiconductor device according to some example embodiments is closer to the drain electrode 175 than to the first field dispersion layer 177a, the electric field applied to the first field dispersion layer 177a as well as the gate electrode 155 and the gate semiconductor layer 150 may be further alleviated.

For example, as the width of the doping region 138 along the first direction DR1 increases and it approaches the drain electrode 175, the effect of alleviating the electric field applied to the gate electrode 155 and the gate semiconductor layer 150 may increase, but the two-dimensional electron gas 134 may decrease. According to some example embodiments, as the doping region 138 of the semiconductor device is closer to the drain electrode 175 than the first field dispersion layer 177a and farther from the drain electrode 175 than the second field dispersion layer 177b, the electric field applied to the gate electrode 155, the gate semiconductor layer 150, and the first field dispersion layer 177a may be alleviated, while minimizing or otherwise reducing the reduction of the two-dimensional electron gas 134 by the doping region 138.

As the electric field applied to the periphery of the gate electrode 155 and the gate semiconductor layer 150 is alleviated by the doping region 138, the number of field dispersion layers 177 may be reduced. In addition, as the electric field applied to the periphery of the gate electrode 155 and the gate semiconductor layer 150 is alleviated by the doping region 138, the distance between the gate electrode 155 and the drain electrode 175 may be reduced. The semiconductor device according to some example embodiments may have an increase in Rₒₙ resistance due to including a doping region 138, but the increase in Rₒₙ resistance may be compensated for by reducing the distance between the gate electrode 155 and the drain electrode 175.

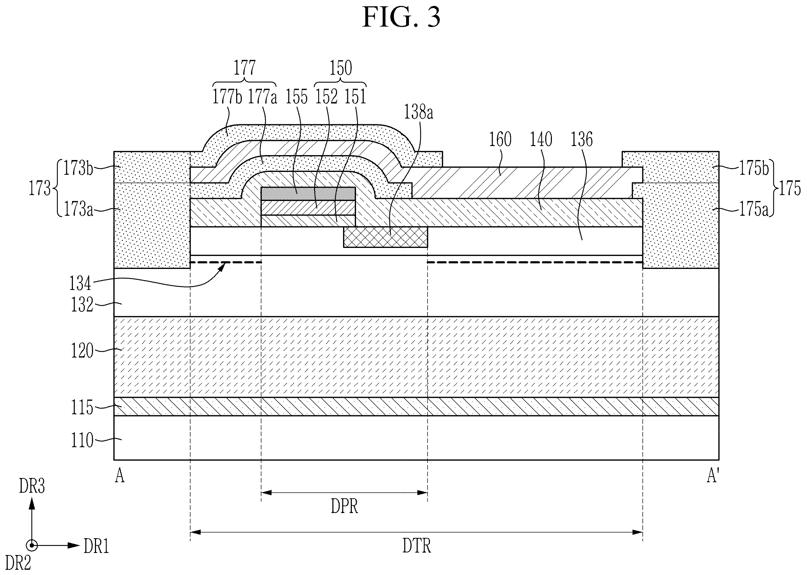

Hereinafter, variations of the semiconductor device according to some example embodiments shown in FIGS. 1 and 2 will be described with reference to FIGS. 3, 4, and 5. FIG. 3 shows a variation of the cross-section of the semiconductor device according to some example embodiments illustrated in FIGS. 1 and 2, and FIGS. 4 and 5 show variations of the plan-view of the semiconductor device according to some example embodiments illustrated in FIGS. 1 and 2.

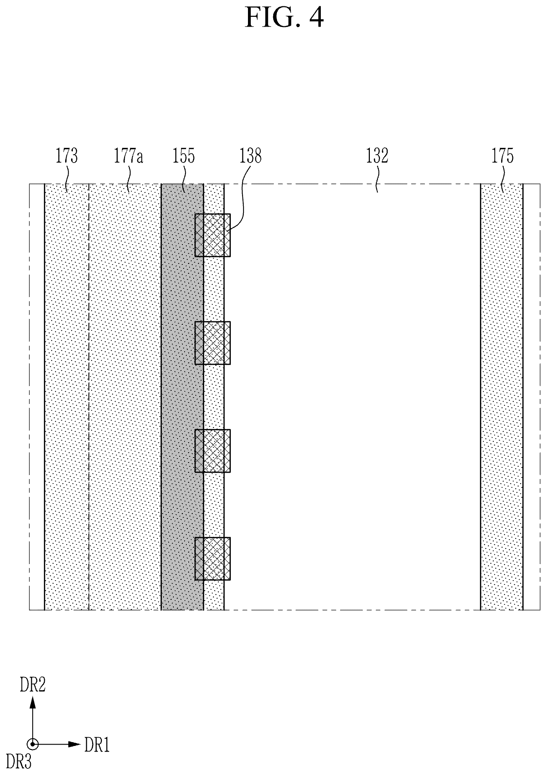

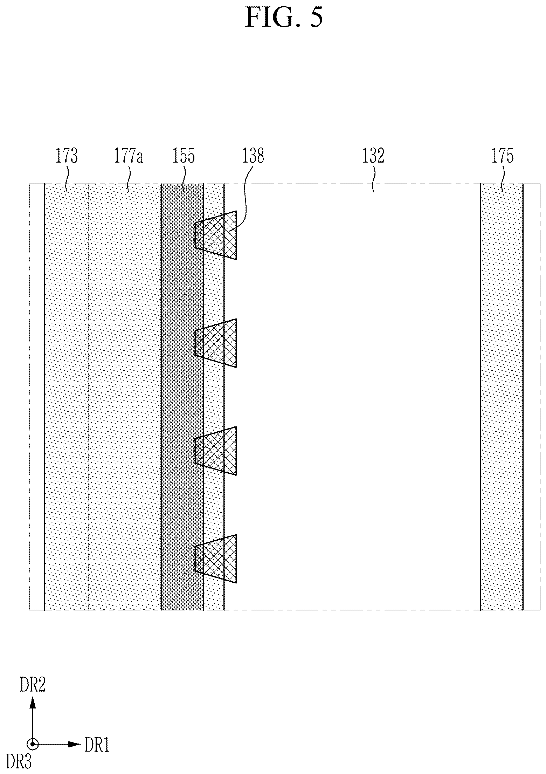

FIG. 3 is a cross-sectional view of a semiconductor device according to some example embodiments taken along line A-A' of FIG. 1. FIGS. 4 and 5 are each a plan view of a semiconductor device according to some example embodiments. The example embodiments illustrated in FIGS. 3, 4, and 5 have a significant number of parts that are the same as those in the example embodiments shown in Figs. 1 and 2, a detailed description thereof will be omitted, and the differences will be mainly described. Additionally, the same reference numerals are used for the same components as in the previous example embodiments. In some example embodiments illustrated in FIG. 3, the depth of the doping region 138 may be somewhat different from the previous example embodiments. In some example embodiments illustrated in FIGS. 4 and 5, the shape of the doping region 138 in a plan view may be somewhat different from the previous example embodiments.

Referring to FIG. 3, the doping region 138 of the semiconductor device according to some example embodiments may be positioned in the barrier layer 136 and may include only a first doping region 138a including the same material as the barrier layer 136. In some example embodiments illustrated in FIG. 2, the doping region 138 is formed of a p-AlGaN layer and a p-GaN layer, whereas in the example embodiments illustrated in FIG. 3, the doping region 138 may be formed of only a p-AlGaN layer. For example, the channel layer 132 may not include a region doped with a p-type impurity. For example, in an implant process for forming a doping region 138, the depth (thickness along the third direction DR3) of the doping region 138 may be controlled by controlling the energy for injecting impurities. The depth of the doping region 138 in the example embodiments illustrated in FIG. 3 may be shallower than the depth of the doping region 138 in the example embodiments illustrated in FIG. 2. In this case, the energy for injecting impurities to form the doping region 138 in the example embodiments illustrated in FIG. 3 may be less than the energy for injecting impurities to form the doping region 138 in the example embodiments illustrated in FIG. 2.

In some example embodiments, the depletion region DPR may extend to a region of the channel layer 132 that overlaps the first doping region 138a in the third direction DR3, but the example embodiments are not limited thereto. For example, depending on the concentration of the first doping region 138, the depletion region DPR may be positioned only in the channel layer 132 that overlaps the gate semiconductor layer 150 in the third direction DR3. For example, the two-dimensional electron gas 134 may be positioned in the region of the channel layer 132 overlapping the first doping region 138a in the third direction DR3.

The following description of the first doping region 138a may be considered as a description of the doping region 138. The first doping region 138a may extend in the third direction DR3 from the upper surface of the barrier layer 136 toward the upper surface of the channel layer 132. The upper surface of the first doping region 138a may be positioned at substantially the same level as the upper surface of the barrier layer 136, and the lower surface of the first doping region 138a may be positioned at the same level as the upper surface of the channel layer 132 or at a level higher than the upper surface of the channel layer 132. The lower surface of the first doping region 138a may be positioned at the same level as the lower surface of the barrier layer 136 or at a higher level than the lower surface of the barrier layer 136.

Referring to FIGS. 4 and 5, the semiconductor device according to some example embodiments may include a plurality of doping regions 138 spaced apart and arranged along the second direction DR2 parallel to the extension direction of the source electrode 173 and the drain electrode 175. In some example embodiments, at least a portion of each of the plurality of doping regions 138 may overlap a gate electrode 155 extending along the second direction DR2 in the third direction DR3. One side of each of the plurality of doping regions 138 may be closer to the drain electrode 175 than the side of the gate electrode 155 adjacent to the drain electrode 175. In some example embodiments, one side of each of the plurality of doping regions 138 may be closer to the drain electrode 175 than the side of the first field dispersion layer 177a adjacent to the drain electrode 175.

Referring to FIG. 4, the shape of each of the plurality of doping regions 138 in a plan view may be rectangular, but the example embodiments are not limited thereto. The shape of each of the plurality of doping regions 138 in a plan view may be varied.

Referring to FIG. 5, the width of each of the plurality of doping regions 138 in a plan view may increase as it gets closer to the drain electrode 175. Here, the width of the doping region 138 may mean the width along the second direction DR2. For example, the shape of each of the plurality of doping regions 138 in a plan view may be a trapezoid whose width in the second direction DR2 becomes wider as it approaches the drain electrode 175, but the example embodiments are not limited thereto. The shape of each of the plurality of doping regions 138 in a plan view may be changed in various ways, such as a triangle or fan shape, with the width increasing in the second direction DR2 as it approaches the drain electrode 175.

In some example embodiments, as the width of the doping region 138 along the second direction DR2 increases closer to the drain electrode 175 to which a high voltage is applied, a strong electric field may be widely dispersed, so that the electric field relaxation effect of the doping region 138 may be further increased.

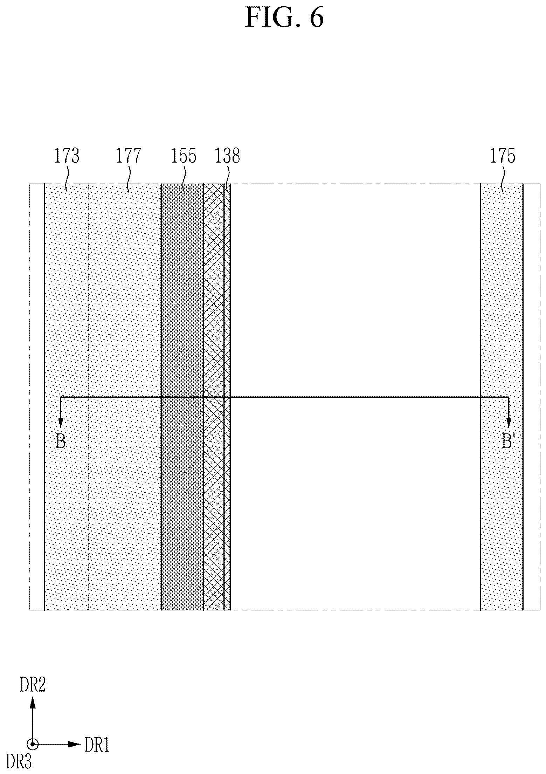

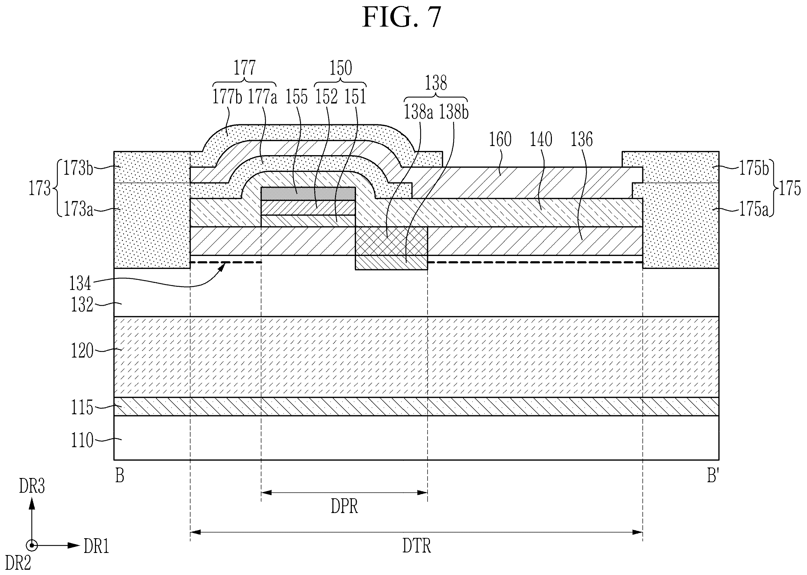

Hereinafter, with reference to FIGS. 6 and 7, a description will be given of a modified example of a semiconductor device according to the example embodiments illustrated in FIGS. 1 and 2.

FIG. 6 is a plan view of a semiconductor device according to some example embodiments, and FIG. 7 is a cross-sectional view of a semiconductor device according to some example embodiments taken along line B-B' of FIG. 6. For convenience, only the source electrode 173, drain electrode 175, gate electrode 155, doping region 138, and first field dispersion layer 177a positioned on the channel layer 132 are illustrated in FIG. 6, and other components are omitted. The example embodiments illustrated in FIGS. 6 and 7 have a significant number of parts that are the same as those in the example embodiments shown in FIGS. 1 and 2, a detailed description thereof will be omitted, and the differences will be mainly described. Additionally, the same reference numerals are used for the same components as in the previous example embodiments. The example embodiments illustrated in FIGS. 6 and 7 may differ from the previous example embodiments in some respects in that the doping region 138 and the gate semiconductor layer 150 do not overlap in the third direction DR3.

Referring to FIGS. 6 and 7, one side of the doping region 138 may be closer to the drain electrode 175 than the side of the first field dispersion layer 177a positioned between the gate electrode 155 and the drain electrode 175. In the example embodiments illustrated in FIGS. 6 and 7, unlike the example embodiments illustrated in FIGS. 1 and 2, the second side of the doping region 138 may be positioned on an extension of the side of the gate electrode 155 adjacent to the drain electrode 175. The second side of the doping region 138 and the side of the gate electrode 155 adjacent to the drain electrode 175 may have substantially the same distance from the drain electrode 175.

The doping region 138 may be in contact with the gate semiconductor layer 150. The first doping region 138a may be in contact with the first gate semiconductor layer 151. In some example embodiments, the lower surface of the first doping region 138a and the upper surface of the first gate semiconductor layer 151 may have a tangent line extending along the second direction DR2. The tangent line of the first doping region 138a and the first gate semiconductor layer 151 may be positioned on an extension line of the side surface of the gate electrode 155 adjacent to the drain electrode 175.

In some example embodiments, the doping region 138 may be electrically connected to the gate semiconductor layer 150 and the gate electrode 155 through a tangent line between the doping region 138 and the gate semiconductor layer 150, so that the doping region 138 may not be floated by being injected with holes.

As the doping region 138 contacts with the gate semiconductor layer 150, the depletion region formed by the gate semiconductor layer 150 and the depletion region formed by the doping region 138 may be connected, and a single depletion region DPR may be formed. The depletion region DPR may be defined as a region of the channel layer 132 from an extension of the side surface of the gate semiconductor layer 150 adjacent to the source electrode 173 to an extension of the side surface of the doping region 138 adjacent to the drain electrode 175.

In some example embodiments, the doping region 138 and the gate semiconductor layer 150 may not overlap in the third direction DR3. In the example embodiments illustrated in FIGS. 1 and 2, the doping region 138 covers at least a portion of the lower surface of the gate semiconductor layer 150, but in the example embodiments illustrated in FIGS. 6 and 7, the doping region 138 may not cover the lower surface of the gate semiconductor layer 150.

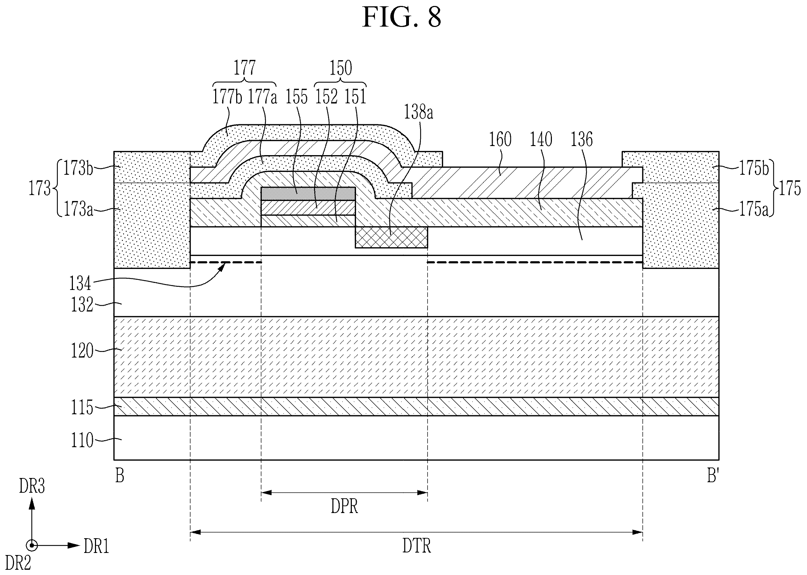

Hereinafter, a modified example of the semiconductor device according to the example embodiments shown in FIGS. 6 and 7 will be described with reference to FIGS. 8, 9, and 10. FIG. 8 shows a variation of the cross-section of the semiconductor device according to the example embodiments illustrated in FIGS. 6 and 7, and FIGS. 9 and 10 show variations of the plan-view of the semiconductor device according to the example embodiments illustrated in FIGS. 6 and 7.

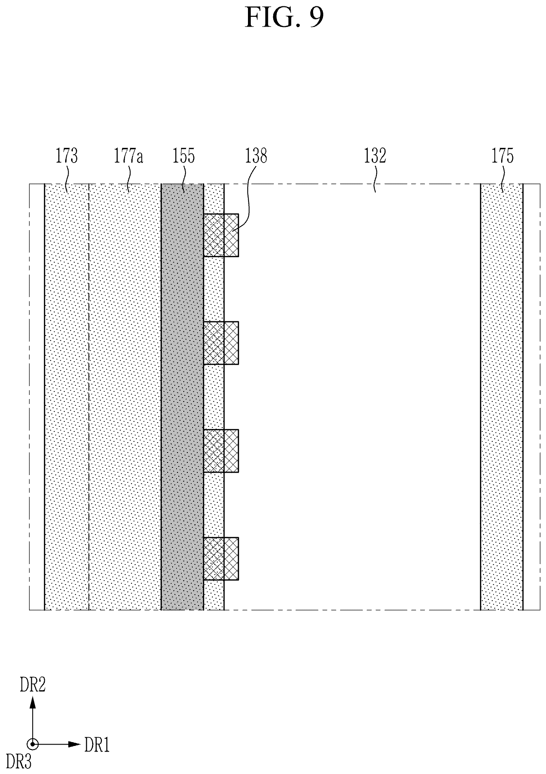

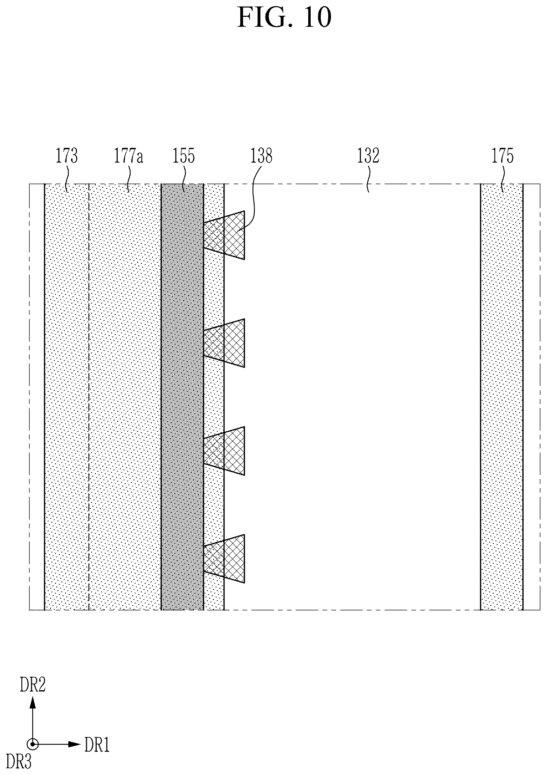

FIG. 8 is a cross-sectional view of a semiconductor device according to some example embodiments taken along line B-B' of FIG. 6. FIGS. 9 and 10 are each a plan view of a semiconductor device according to some example embodiments. The example embodiments illustrated in FIGS. 8, 9, and 10 have a significant number of parts that are the same as those in the example embodiments shown in FIGS. 6 and 7, a detailed description thereof will be omitted, and the differences will be mainly described. Additionally, the same reference numerals are used for the same components as in the previous example embodiments. In the example embodiments illustrated in Fig. 8, the depth of the doping region 138 may be somewhat different from the previous example embodiments. In the example embodiments illustrated in FIGS. 9 and 10, the shape of the doping region 138 in a plan view may be somewhat different from the previous example embodiments.

Referring to FIG. 8, the doping region 138 of the semiconductor device according to some example embodiments may be positioned in the barrier layer 136 and may include only a first doping region 138a including the same material as the barrier layer 136. Unlike the example embodiments illustrated in FIG. 7, in which a part of the doping region 138 is positioned in the channel layer 132 and further includes a second doping region 138b containing the same material as the channel layer 132, in the example embodiments illustrated in FIG. 8, the doping region 138 may not be positioned in the channel layer 132. For example, the channel layer 132 may not include a region doped with a p-type impurity. For example, as the barrier layer 136 includes AlGaN, the doping region 138 may be composed only of a p-AlGaN layer. The depth of the doping region 138 in the example embodiments illustrated in FIG. 8 may be shallower than the depth of the doping region 138 in the example embodiments illustrated in FIG. 7. In some example embodiments, the depth of the doping region 138 may be less than the thickness of the barrier layer 136.

In some example embodiments, the depletion region DPR may extend to a region of the channel layer 132 that overlaps the first doping region 138a in the third direction DR3, but the example embodiments are not limited thereto. For example, depending on the concentration of the first doping region 138, the depletion region DPR may be positioned only in the channel layer 132 that overlaps the gate semiconductor layer 150 in the third direction DR3. For example, the two-dimensional electron gas 134 may be positioned in the region of the channel layer 132 overlapping the first doping region 138a in the third direction DR3.

The following description of the first doping region 138a may be considered as a description of the doping region 138. The first doping region 138a may extend in the third direction DR3 from the upper surface of the barrier layer 136 toward the upper surface of the channel layer 132. The upper surface of the first doping region 138a may be positioned at substantially the same level as the upper surface of the barrier layer 136, and the lower surface of the first doping region 138a may be positioned at the same level as the upper surface of the channel layer 132 or at a level higher than the upper surface of the channel layer 132. The lower surface of the first doping region 138a may be positioned at the same level as the lower surface of the barrier layer 136 or at a higher level than the lower surface of the barrier layer 136.

Referring to FIGS. 9 and 10, a semiconductor device according to some example embodiments may include a plurality of doping regions 138 spaced apart and arranged along the second direction DR2 parallel to the extension direction of the source electrode 173 and the drain electrode 175. In some example embodiments, each of the plurality of doping regions 138 may be in contact with the gate electrode 155 in the first direction DR1, which extends along the second direction DR2 in a plan view. One side of each of the plurality of doping regions 138 may be closer to the drain electrode 175 than the side of the gate electrode 155 adjacent to the drain electrode 175, and the other side of each of the plurality of doping regions 138 may have a distance from the drain electrode 175 substantially the same as the side of the gate electrode 155 adjacent to the drain electrode 175. One side of each of the plurality of doping regions 138 may be farther from the drain electrode 175 than the side of the first field dispersion layer 177a adjacent to the drain electrode 175.

Referring to FIG. 9, the shape of each of the plurality of doping regions 138 in a plan view may be rectangular, but the example embodiments are not limited thereto. The shape of each of the multiple doping regions 138 in a plan view may be varied.

Referring to FIG. 10, the width of each of the plurality of doping regions 138 in a plan view may become larger as it approaches the drain electrode 175. Here, the width of the doping region 138 may mean the width along the second direction DR2. For example, the shape of each of the plurality of doping regions 138 in a plan view may be a trapezoid whose width in the second direction DR2 becomes wider as it approaches the drain electrode 175, but the example embodiments are not limited thereto. The shape of each of the plurality of doping regions 138 in a plan view may be changed in various ways, such as a triangle or fan shape, with the width increasing in the second direction DR2 as it approaches the drain electrode 175.

However, the example embodiments are not limited thereto, and the width of each of the plurality of doping regions 138 along the second direction DR2 may decrease as it approaches the drain electrode 175.

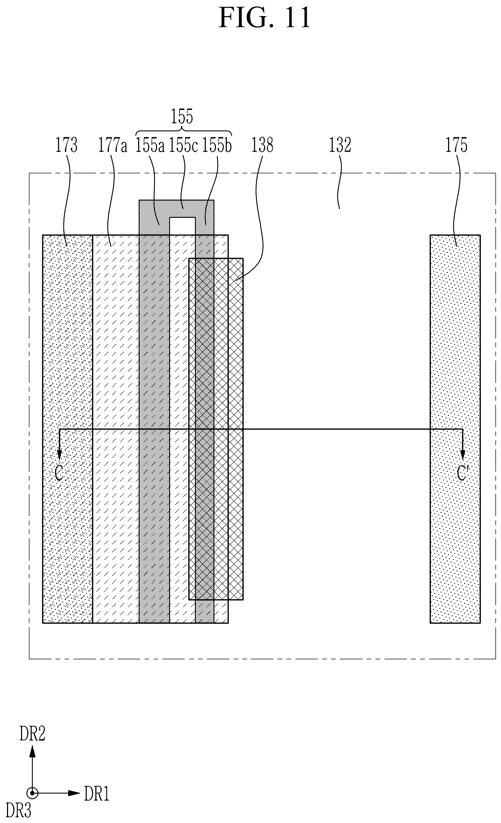

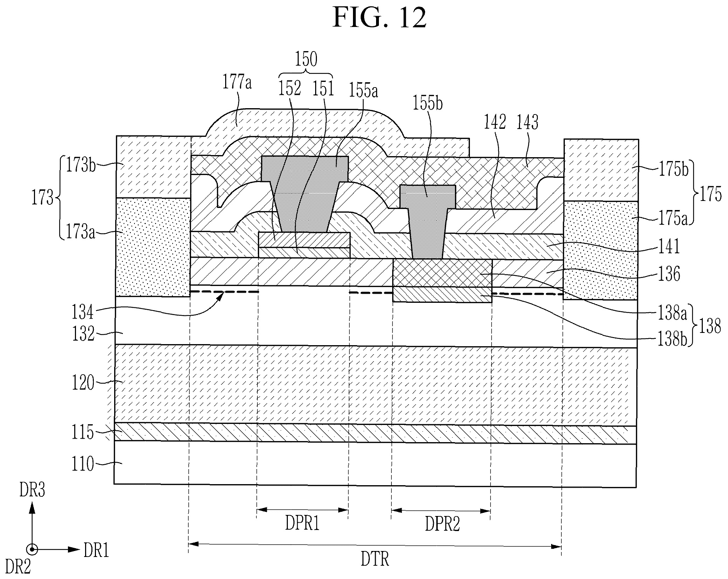

Hereinafter, with reference to FIGS. 11 and 12, a description will be given of a modified example of the semiconductor device according to the example embodiments illustrated in FIGS. 1 and 2.

FIG. 11 is a plan view of a semiconductor device according to some example embodiments, and FIG. 12 is a cross-sectional view of the semiconductor device according to some example embodiments taken along line C-C' of FIG. 11. For convenience, only the source electrode 173, drain electrode 175, gate electrode 155, doping region 138, and first field dispersion layer 177a positioned on the channel layer 132 are illustrated in FIG. 11, and other components are omitted.

The example embodiments illustrated in FIGS. 11 and 12 have a significant number of parts that are the same as the example embodiments illustrated in FIGS. 1 and 2, a detailed description thereof will be omitted, and the differences will be mainly described. Additionally, the same reference numerals are used for the same components as in the previous example embodiments. In the example embodiments illustrated in FIGS. 11 and 12, the shape of the gate electrode 155 and the positional relationship between the doping region 138 and the gate semiconductor layer 150 may be somewhat different from the previous example embodiments.

Referring to FIGS. 11 and 12, a gate electrode 155 of a semiconductor device according to some example embodiments may include a first portion 155a and a second portion 155b extending in the second direction DR2 between a source electrode 173 and a drain electrode 175 and spaced apart from each other in the first direction DR1, and a third portion 155c connecting the first portion 155a and the second portion 155b. Among the first portion 155a and the second portion 155b, the first portion 155a may be closer to the source electrode 173, and the second portion 155b may be closer to the drain electrode 175. The region between the source electrode 173 and the drain electrode 175 in a plan view may be defined as an active region, and the length of the active region along the second direction DR2 may be substantially the same as the length of the source electrode 173 and the drain electrode 175 along the second direction DR2. The first portion 155a and the second portion 155b may extend further outwardly of the active region along the second direction DR2, and the third portion 155c may connect the first portion 155a and the second portion 155b outwardly of the active region. In a plan view, the gate electrode 155 may have approximately an 'n' shape.

In some example embodiments, the doping region 138 may overlap the second portion 155b of the gate electrode 155 in the third direction DR3. A first side of the doping region 138 may be closer to the drain electrode 175 than the side of the second portion 155b adjacent to the drain electrode 175. A first side of the doping region 138 may be closer to the drain electrode 175 than the side of the first field dispersion layer 177a adjacent to the drain electrode 175. A second side of the doping region 138 may be positioned between the first portion 155a and the second portion 155b. The second side of the doping region 138 may be farther from the drain electrode 175 than the side of the second portion 155b adjacent to the source electrode 173.

In some example embodiments illustrated in FIG. 12, the doping region 138 may extend in the third direction DR3 from the upper surface of the barrier layer 136 toward the upper surface of the substrate 110. The upper surface of the doping region 138 may be positioned at substantially the same level as the upper surface of the barrier layer 136. The lower surface of the doping region 138 may be positioned at a higher level than the lower surface of the channel layer 132. In some example embodiments, the lower surface of the doping region 138 may be positioned at a lower level than the upper surface of the channel layer 132. In other words, the lower surface of the doping region 138 may be positioned at a lower level than the lower surface of the barrier layer 136.

The doping region 138 may include a first doping region 138a positioned in the barrier layer 136 and including the same material as the barrier layer 136, and a second doping region 138b positioned in the channel layer 132 and including the same material as the channel layer 132. The first doping region 138a may be a region doped with a p-type impurity in the barrier layer 136, and the second doping region 138b may be a region doped with a p-type impurity in the channel layer 132. For example, as the barrier layer 136 includes AlGaN and the channel layer 132 includes GaN, the first doping region 138a may be formed of a p-AlGaN layer and the second doping region 138b may be formed of a p-GaN layer.

A gate semiconductor layer 150 may be positioned on the barrier layer 136. In some example embodiments, the gate semiconductor layer 150 may be positioned on the upper surface of the barrier layer 136 positioned between the source electrode 173 and the doping region 138. The gate semiconductor layer 150 may include a first gate semiconductor layer 151 and a second gate semiconductor layer 152. The first gate semiconductor layer 151 may be positioned on an upper surface of a barrier layer 136, and the second gate semiconductor layer 152 may be positioned on the first gate semiconductor layer 151. The gate semiconductor layer 150 may in some examples not be in contact with the doping region 138. The gate semiconductor layer 150 may in some examples not overlap with the doping region 138 in the third direction DR3. In the example embodiments illustrated in FIG. 12, unlike the example embodiments illustrated in FIG. 2, the doping region 138 may be spaced apart from the gate semiconductor layer 150 toward the drain electrode 175. The doping region 138 may be spaced apart from the gate semiconductor layer 150 in the first direction DR1.

In some example embodiments, as the doping region 138 is spaced apart from the gate semiconductor layer 150, a first depletion region DPR1 formed by the gate semiconductor layer 150 and a second depletion region DPR2 formed by the doping region 138 may be separated. The first depletion region DPR1 may be a region of the channel layer 132 that overlaps the gate semiconductor layer 150 in the third direction DR3, and the second depletion region DPR2 may be a region of the channel layer 132 that overlaps the doping region 138 in the third direction DR3. The first depletion region DPR1 and the second depletion region DPR2 may be positioned so as to be spaced apart in the first direction DR1 in the drift region DTR. Among the first depletion region DPR1 and the second depletion region DPR2, the first depletion region DPR1 may be closer to the source electrode 173, and the second depletion region DPR2 may be closer to the drain electrode 175.

In some example embodiments, the doping region 138 and the gate semiconductor layer 150 are spaced apart, but in some example embodiments the doping region 138 and the gate semiconductor layer 150 may be connected by the gate electrode 155. Each of the doping region 138 and the gate semiconductor layer 150 may be electrically connected to the gate electrode 155. As the doping region 138 is electrically connected to the gate electrode 155, holes may be injected and the doping region 138 may not float.

The semiconductor device according to some example embodiments may include a first protective layer 141 and a second protective layer 142 positioned on a barrier layer 136, a doping region 138, and a gate semiconductor layer 150. The first protective layer 141 may cover the upper surface of the barrier layer 136. The first protective layer 141 may cover the upper surface of the doping region 138. The first protective layer 141 may cover a side surface of the gate semiconductor layer 150 and a portion of the upper surface of the gate semiconductor layer 150. The second protective layer 142 may be positioned on the first protective layer 141. The first source electrode 173a and the first drain electrode 175a may be positioned on the side surface of the first protective layer 141. In some cases, the first source electrode 173a and the first drain electrode 175a may also be partially positioned on the upper surface of the first protective layer 141. For example, the first source electrode 173a and the first drain electrode 175a may cover a side surface of the first protective layer 141 and a portion of the upper surface of the first protective layer 141. The second protective layer 142 may be positioned on the side surfaces of the first source electrode 173a and the first drain electrode 175a. In some cases, the second protective layer 142 may also be partially positioned on the upper surfaces of the first source electrode 173a and the first drain electrode 175a. For example, the second protective layer 142 may cover the side surfaces of the first source electrode 173a and the first drain electrode 175a and a portion of the upper surfaces of the first source electrode 173a and the first drain electrode 175a.

The gate electrode 155 may penetrate the second protective layer 142 and the first protective layer 141 and contact with the gate semiconductor layer 150 and the doping region 138. The first portion 155a of the gate electrode 155 may penetrate the second protective layer 142 and the first protective layer 141 and contact with the gate semiconductor layer 150. The lower surface of the first portion 155a of the gate electrode 155 may be in contact with the upper surface of the second gate semiconductor layer 152. The second portion 155b of the gate electrode 155 may penetrate the second protective layer 142 and the first protective layer 141 and contact with the doping region 138. The lower surface of the second portion 155b of the gate electrode 155 may be in contact with the upper surface of the first doping region 138a. A portion of the gate electrode 155 may cover a portion of the upper surface of the second protective layer 142.

The semiconductor device according to some example embodiments may include a third protective layer 143 positioned on the second protective layer 142 and the gate electrode 155. The third protective layer 143 may cover the upper surface of the second protective layer 142. The third protective layer 143 may cover the upper surface and the side surface of the gate electrode 155. The second source electrode 173b may penetrate the third protective layer 143 and the second protective layer 142 and contact with the upper surface of the first source electrode 173a. The second drain electrode 175b may penetrate the third protective layer 143 and the second protective layer 142 and contact with the upper surface of the first drain electrode 175a. The second source electrode 173b and the second drain electrode 175b may be positioned on the side surface of the second protective layer 142 and the side surface of the third protective layer 143.

Each of the first protective layer 141, the second protective layer 142, and the third protective layer 143 may include an insulating material. For example, each of the first protective layer 141, the second protective layer 142, and the third protective layer 143 may include an oxide such as SiO₂ and/or Al₂O₃. As another example, each of the first protective layer 141, the second protective layer 142, and the third protective layer 143 may include a nitride such as SiN or an oxynitride such as SiON. Each of the first protective layer 141, the second protective layer 142, and the third protective layer 143 may be formed of a single layer or multiple layers. The first protective layer 141, the second protective layer 142, and the third protective layer 143 may include a same material, or at least one of the first protective layer 141, the second protective layer 142, and the third protective layer 143 may include a different material.

The first field dispersion layer 177a may be positioned on the third protective layer 143. The first field dispersion layer 177a may extend from the side of the second source electrode 173b toward the drain electrode 175. The boundary between the first field dispersion layer 177a and the second source electrode 173b may not clear, and the first field dispersion layer 177a may be formed integrally with the second source electrode 173b. The first field dispersion layer 177a may overlap the gate electrode 155 in the third direction DR3. In some example embodiments, the first portion 155a and the second portion 155b of the gate electrode 155 positioned between the source electrode 173 and the drain electrode 175 may be covered by the first field dispersion layer 177a. The third portion 155c of the gate electrode 155 may not be covered by the first field dispersion layer 177a.

In some example embodiments, a first side of the doping region 138 may be closer to the drain electrode 175 than the side of the second portion 155b of the gate electrode 155 adjacent to the drain electrode 175. The first side of the doping region 138 may be closer to the drain electrode 175 than the side of the first field dispersion layer 177a adjacent to the drain electrode 175. The side of the first field dispersion layer 177a adjacent to the drain electrode 175 may be closer to the drain electrode 175 than the side of the second portion 155b of the gate electrode 155 adjacent to the drain electrode 175.

Although not shown, the semiconductor device according to some example embodiments may include a plurality of field dispersion layers. For example, the semiconductor device according to some example embodiments may further include a second field dispersion layer that entirely covers the first field dispersion layer 177a. The second field dispersion layer may extend in the first direction DR1 from the source electrode 173 toward the drain electrode 175, and a length of the second field dispersion layer along the first direction DR1 between the source electrode 173 and the drain electrode 175 may be longer than a length of the first field dispersion layer along the first direction DR1. The side of the second field dispersion layer adjacent to the drain electrode 175 may be closer to the drain electrode 175 than one side of the doping region 138 adjacent to the drain electrode 175.

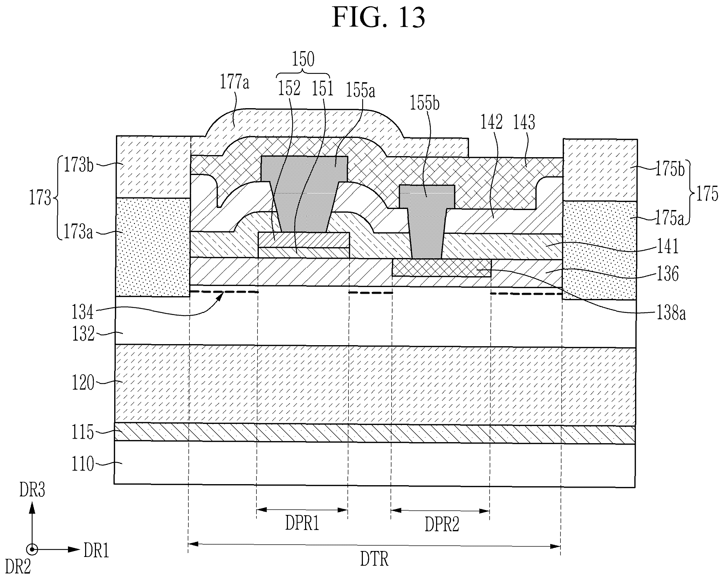

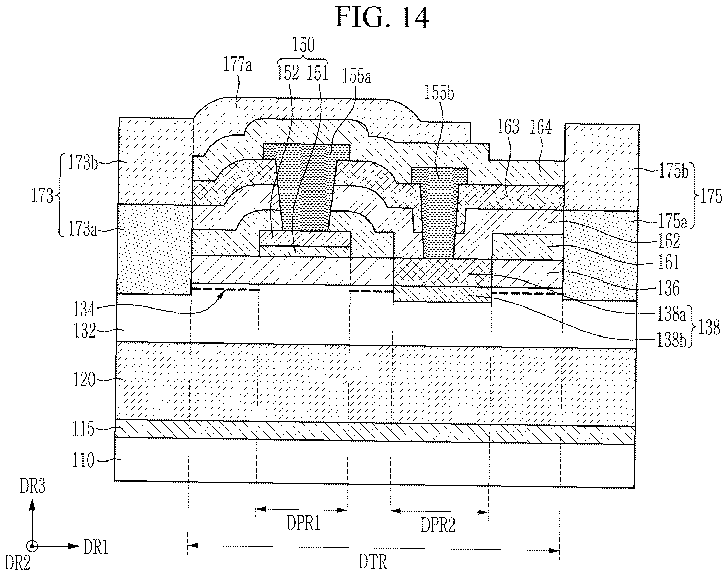

Hereinafter, a modified example of the semiconductor device according to the example embodiments shown in FIGS. 11 and 12 will be described with reference to FIGS. 13, 14, 15, 16, and 17. FIGS. 13 and 14 illustrate variations of the cross-section of the semiconductor device according to the example embodiments illustrated in FIGS. 1 and 2, and FIGS. 15, 16, and 17 illustrate variations of the plan-view of the semiconductor device according to the example embodiments illustrated in FIGS. 11 and 12.

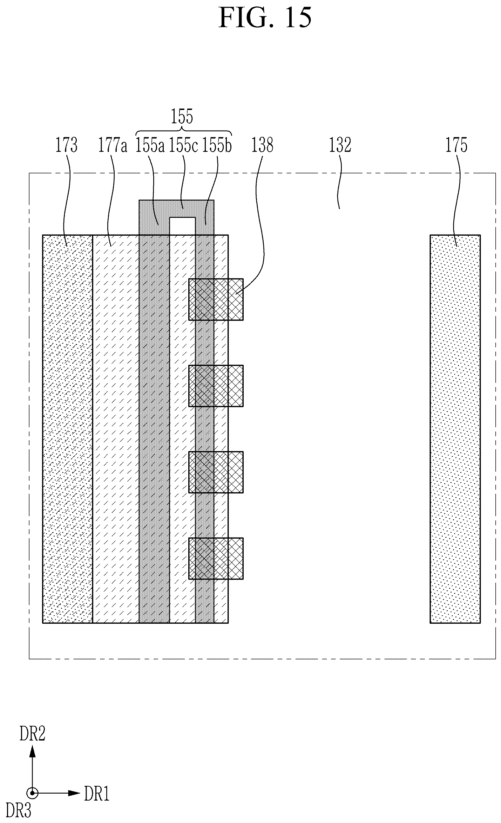

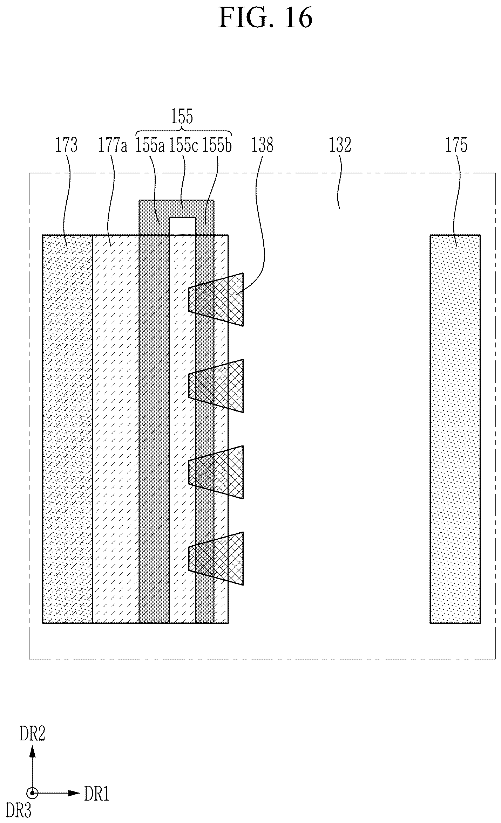

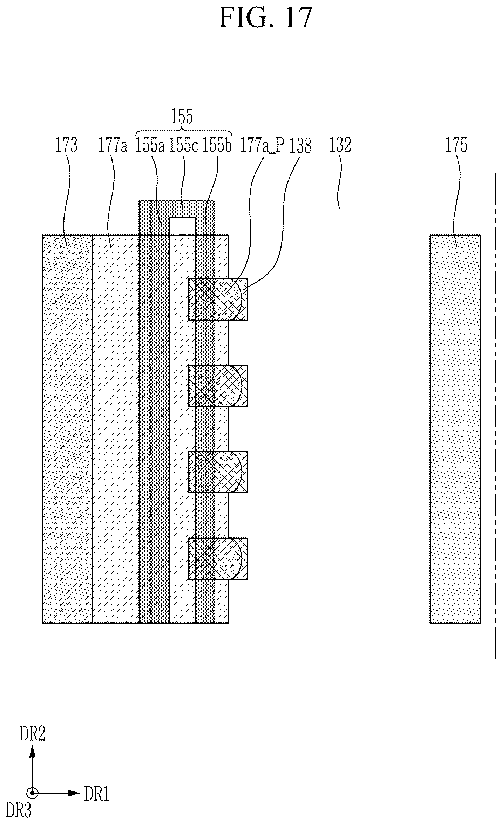

FIGS. 13 and 14 are each a cross-sectional view of a semiconductor device according to some example embodiments taken along line C-C' of FIG. 11. FIGS. 15, 16, and 17 are each a plan view of a semiconductor device according to some example embodiments. The example embodiments illustrated in FIGS. 13, 14, 15, 16, and 17 have a significant number of parts that are the same as those in the example embodiments shown in FIGS. 11 and 12, a detailed description thereof will be omitted, and the differences will be mainly described. Additionally, the same reference numerals are used for the same components as in the previous example embodiments. In the example embodiments illustrated in Fig. 13, the depth of the doping region 138 may be somewhat different from the previous example embodiments. In the example embodiments illustrated in Fig. 14, the number and structure of the protective layers may be partially different from the previous example embodiments. In the example embodiments illustrated in FIGS. 15 and 16, the shape of the doping region 138 in a plan view may be somewhat different from the previous example embodiments. In the example embodiments illustrated in Fig. 17, the shape of the doping region 138 in a plan view and the shape of the first field dispersion layer 177a in a plan view may be somewhat different from the previous example embodiments.

Referring to FIG. 13, the doping region 138 of the semiconductor device according to some example embodiments may be positioned in the barrier layer 136 and may include only the first doping region 138a including the same material as the barrier layer 136. Unlike the example embodiments illustrated in FIG. 12, in which a part of the doping region 138 is positioned in the channel layer 132 and further includes the second doping region 138b containing the same material as the channel layer 132, in the example embodiments illustrated in FIG. 13, the doping region 138 may not be positioned in the channel layer 132. For example, the channel layer 132 may not include a region doped with a p-type impurity. For example, as the barrier layer 136 includes AlGaN, the doping region 138 may be composed only of a p-AlGaN layer. The depth of the doping region 138 in the example embodiments illustrated in FIG. 13 may be shallower than the depth of the doping region 138 in the example embodiments illustrated in FIG. 12. In some example embodiments, the depth of the doping region 138 may be less than the thickness of the barrier layer 136.

In some example embodiments, a second depletion region DPR2 may be formed in a region of the channel layer 132 that overlaps the first doping region 138a in the third direction DR3, but the example embodiments are not limited thereto. For example, depending on the concentration of the first doping region 138, the second depletion region DPR2 may not be formed, and only the first depletion region DPR1 may be formed. For example, the two-dimensional electron gas 134 may be positioned in the region of the channel layer 132 overlapping the first doping region 138a in the third direction DR3.

The following description of the first doping region 138a may be considered as a description of the doping region 138. The first doping region 138a may extend in the third direction DR3 from the upper surface of the barrier layer 136 toward the upper surface of the channel layer 132. The upper surface of the first doping region 138a may be positioned at substantially the same level as the upper surface of the barrier layer 136, and the lower surface of the first doping region 138a may be positioned at the same level as the upper surface of the channel layer 132 or at a level higher than the upper surface of the channel layer 132. The lower surface of the first doping region 138a may be positioned at the same level as the lower surface of the barrier layer 136 or at a higher level than the lower surface of the barrier layer 136.

Referring to FIG. 14, the semiconductor device according to some example embodiments may include a first protective layer 161, a second protective layer 162, a third protective layer 163, and a fourth protective layer 164 between the barrier layer 136 and the first field dispersion layer 177a. Unlike the example embodiments illustrated in FIG. 12 in which three protective layers are positioned between the barrier layer 136 and the first field dispersion layer 177a, the example embodiments illustrated in FIG. 14 may have four protective layers positioned between the barrier layer 136 and the first field dispersion layer 177a.

In some example embodiments, the first protective layer 161 may be positioned on the barrier layer 136 and the gate semiconductor layer 150. The first protective layer 161 may cover the upper surface of the barrier layer 136. The first protective layer 161 may cover a side surface of the gate semiconductor layer 150 and a portion of the upper surface of the gate semiconductor layer 150. Unlike the example embodiments illustrated in FIG. 12 in which the first protective layer 141 covers the upper surface of the doping region 138, in the example embodiments illustrated in FIG. 14, the first protective layer 161 may not cover the upper surface of the doping region 138.

In some example embodiments, the second protective layer 162 may be positioned on the first protective layer 161. Unlike the example embodiments illustrated in FIG. 12, where the second protective layer 142 is separated from the upper surface of the doping region 138 by the first protective layer 141, in the example embodiments illustrated in FIG. 14, the second protective layer 162 may be in contact with the upper surface of the doping region 138. Unlike the example embodiments illustrated in FIG. 12, in which the first protective layer 141 is in contact with the side surface of the second portion 155b of the gate electrode 155, in the example embodiments illustrated in FIG. 14, the first protective layer 161 may be spaced from the side surface of the second portion 155b of the gate electrode 155 by the second protective layer 162.

In some example embodiments, the second protective layer 162 may be positioned on the side surface of the first source electrode 173a and the side surface of the first drain electrode 175a, but the second protective layer 162 may not be positioned on the upper surface of the first source electrode 173a and the upper surface of the first drain electrode 175a.

In some example embodiments, the third protective layer 163 may be further positioned on the side of the gate electrode 155. The third protective layer 163 may be positioned on the second protective layer 162. The third protective layer 163 may be positioned on the side surface of the first source electrode 173a and the side surface of the first drain electrode 175a. In some cases, the third protective layer 163 may also be partially positioned on the upper surface of the first source electrode 173a and the upper surface of the first drain electrode 175a.

The gate electrode 155 may penetrate at least one of the third protective layer 163, the second protective layer 162, and the first protective layer 161 and contact with the gate semiconductor layer 150 and the doping region 138. The first portion 155a of the gate electrode 155 may penetrate the third protective layer 163, the second protective layer 162, and the first protective layer 161 to contact with the gate semiconductor layer 150. The second portion 155b of the gate electrode 155 may penetrate the third protective layer 163 and the second protective layer 162 and contact with the doping region 138. A portion of the gate electrode 155 may cover a portion of the upper surface of the third protective layer 163.

In some example embodiments, the fourth protective layer 164 may be positioned on the third protective layer 163 and the gate electrode 155. The fourth protective layer 164 may cover the upper surface of the third protective layer 163. The fourth protective layer 164 may cover the upper surface and the side surface of the gate electrode 155. The second source electrode 173b may penetrate the fourth protective layer 164 and the third protective layer 163 and contact with the upper surface of the first source electrode 173a. The second drain electrode 175b may penetrate the fourth protective layer 164 and the third protective layer 163 and contact with the upper surface of the first drain electrode 175a. The second source electrode 173b and the second drain electrode 175b may be positioned on the side surface of the fourth protective layer 164 and the side surface of the third protective layer 163. The first field dispersion layer 177a may be positioned on the fourth protective layer 164.

Each of the first protective layer 161, the second protective layer 162, the third protective layer 163, and the fourth protective layer 164 may include an insulating material. For example, each of the first protective layer 161, the second protective layer 162, the third protective layer 163, and the fourth protective layer 164 may include an oxide such as SiO₂ and/or Al₂O₃. As another example, each of the first protective layer 161, the second protective layer 162, the third protective layer 163, and the fourth protective layer 164 may include a nitride such as SiN and/or an oxynitride such as SiON. Each of the first protective layer 161, the second protective layer 162, the third protective layer 163, and the fourth protective layer 164 may be formed of a single layer or multiple layers. The first protective layer 161, the second protective layer 162, the third protective layer 163, and the fourth protective layer 164 may include a same material, or at least one of the first protective layer 161, the second protective layer 162, the third protective layer 163, and the fourth protective layer 164 may include a different material.

Referring to FIGS. 15, 16, and 17, the semiconductor device according to some example embodiments may include a plurality of doping regions 138 spaced apart and arranged along the second direction DR2 parallel to the extension direction of the source electrode 173 and the drain electrode 175. In some example embodiments, each of the plurality of doping regions 138 may overlap a second portion 155b of the gate electrode 155 in the third direction DR3, which extends along the second direction DR2 in a plan view. One side of each of the plurality of doping regions 138 may be closer to the drain electrode 175 than the side of the second portion 155b of the gate electrode 155 adjacent to the drain electrode 175. In some example embodiments, one side of each of the plurality of doping regions 138 may be closer to the drain electrode 175 than the side of the first field dispersion layer 177a adjacent to the drain electrode 175.

Referring to FIGS. 15 and 17, the shape of each of the plurality of doping regions 138 in a plan view may be rectangular, but the example embodiments are not limited thereto. The shape of each of the multiple doping regions 138 in a plan view may be varied.

Referring to FIG. 16, the width of each of the plurality of doping regions 138 in a plan view may become larger as it approaches the drain electrode 175. Here, the width of the doping region 138 may mean the width along the second direction DR2. For example, the shape of each of the plurality of doping regions 138 in a plan view may be a trapezoid whose width in the second direction DR2 becomes wider as it approaches the drain electrode 175, but the example embodiments are not limited thereto. The shape of each of the plurality of doping regions 138 in a plan view may be changed in various ways, such as a triangle or fan shape, with the width increasing in the second direction DR2 as it approaches the drain electrode 175.

Referring to FIG. 17, the first field dispersion layer 177a may include a protrusion 177a_P protruding toward the drain electrode 175 in a plan view. The first field dispersion layer 177a may include a plurality of protrusions 177a_P, and the plurality of protrusions 177a_P may be portions that overlap with a plurality of doping regions 138 in the third direction DR3. In some example embodiments, a first side of the doping region 138 may be closer to the drain electrode 175 than the side of the protrusion 177a_P adjacent to the drain electrode 175.

For example, the shape of the protrusion 177a_P in a plan view may be a semicircle, but is not limited thereto, and the planar shape of the protrusion 177a_P may be variously changed to a triangle, a square, etc.

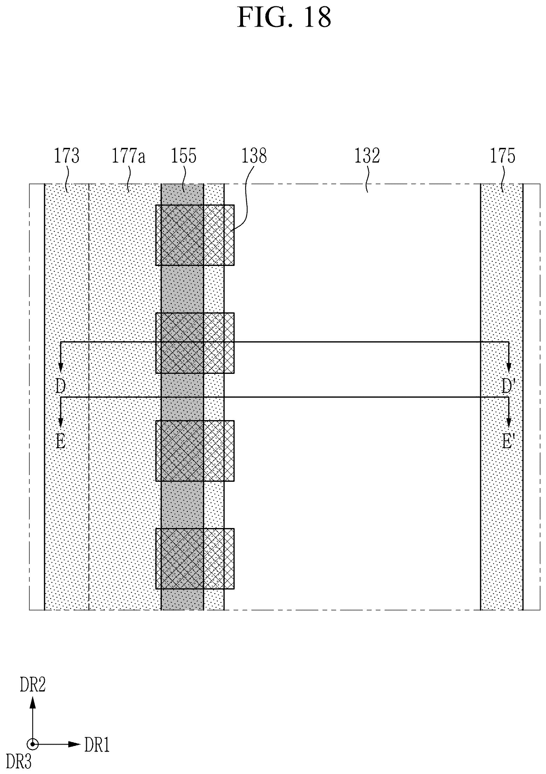

Hereinafter, variations of the semiconductor device according to the example embodiments shown in FIGS. 1 and 2 will be described with reference to FIGS. 18, 19, and 20.

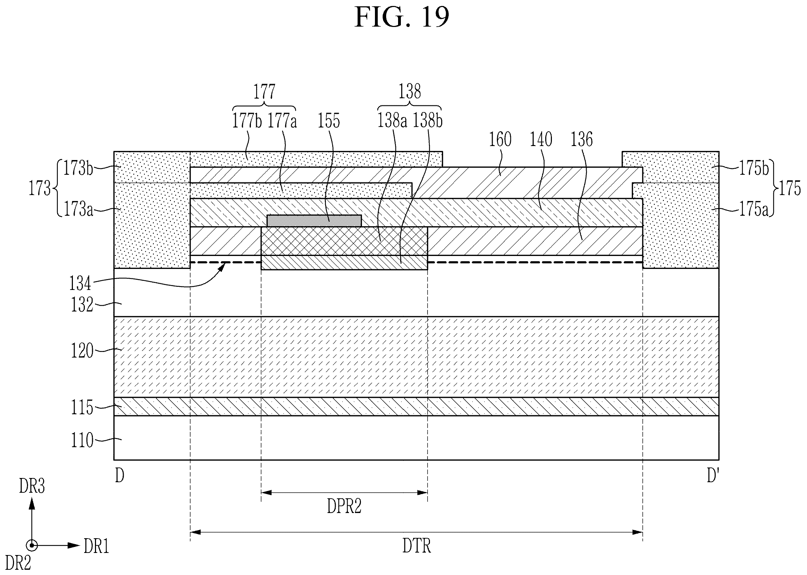

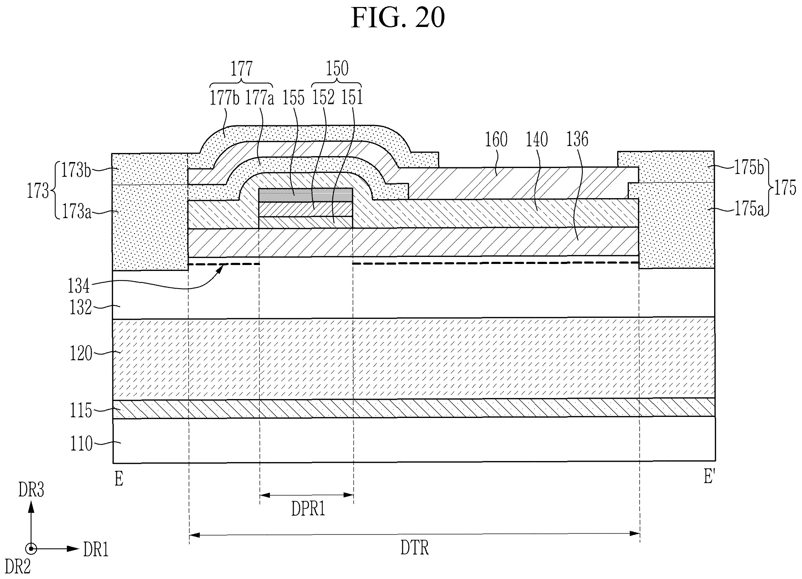

FIG. 18 is a plan view of a semiconductor device according to some example embodiments, FIG. 19 is a cross-sectional view of a semiconductor device according to some example embodiments taken along line D-D' of FIG. 18, and FIG. 20 is a cross-sectional view of a semiconductor device according to some example embodiments taken along line E-E' of FIG. 18. For convenience, only the source electrode 173, drain electrode 175, gate electrode 155, doping region 138, and first field dispersion layer 177a positioned on the channel layer 132 are illustrated in FIG. 18, and other components are omitted.

The example embodiments illustrated in FIGS. 18, 19, and 20 have a significant number of parts that are the same as the example embodiments shown in FIGS. 1 and 2, a detailed description thereof will be omitted, and the differences will be mainly described. Additionally, the same reference numerals are used for the same components as in the previous example embodiments. In the example embodiments illustrated in FIGS. 18, 19, and 20, the shape of the doping region 138 in a plan view and the positional relationship between the doping region 138, the gate semiconductor layer 150, and the gate electrode 155 may be somewhat different from the previous example embodiments.

Referring to FIGS. 18, 19, and 20, the semiconductor device according to some example embodiments may include a plurality of doping regions 138 and a plurality of gate semiconductor layers 150 spaced apart and arranged along the second direction DR2 parallel to the extension direction of the source electrode 173 and the drain electrode 175. In a plan view, the plurality of doping regions 138 and the plurality of gate semiconductor layers 150 may be alternately arranged along the second direction DR2. The doping region 138 may be positioned between two gate semiconductor layers 150 adjacent to each other in the second direction DR2 in a plan view. The gate semiconductor layer 150 may be positioned between two doping regions 138 adjacent to each other in the second direction DR2 in a plan view. Unlike the example embodiments illustrated in FIGS. 1 and 2, where the doping region 138 and the gate semiconductor layer 150 overlap in the third direction DR3, in the example embodiments illustrated in FIGS. 18, 19, and 20, the doping region 138 and the gate semiconductor layer 150 may not overlap in the third direction DR3. The gate electrode 155 may extend in the second direction DR2 across the plurality of doping regions 138 and the plurality of gate semiconductor layers 150. The gate electrode 155 may overlap with the plurality of doping regions 138 and the plurality of gate semiconductor layers 150 in the third direction DR3. The gate electrode 155 may be in contact with the plurality of doping regions 138 and the plurality of gate semiconductor layers 150.

In some example embodiments, a plurality of first depletion regions DPR1 formed by the plurality of gate semiconductor layers 150 and a plurality of second depletion regions DPR2 formed by the plurality of doping regions 138 may be alternately arranged along the second direction DR2. The plurality of doping regions 138 and the plurality of gate semiconductor layers 150 spaced apart and arranged along the second direction DR2 may be electrically connected to a single gate electrode 155. As the doping region 138 is electrically connected to the gate electrode 155, holes may be injected and the doping region 138 may not float.

In some example embodiments, the gate semiconductor layer 150 and the doping region 138 that are adjacent to each other in the second direction DR2 in a plan view may be in contact in the second direction DR2, but the example embodiments are not limited thereto. The gate semiconductor layer 150 and the doping region 138 adjacent to each other in the second direction DR2 in a plan view may be positioned spaced apart from each other in the second direction DR2.

In some example embodiments, the doping region 138 may include a first doping region 138a positioned in the barrier layer 136 and including the same material as the barrier layer 136, and a second doping region 138b positioned in the channel layer 132 and including the same material as the channel layer 132, but the example embodiments are not limited thereto. For example, the doping region 138 may include only the first doping region 138a.

In some example embodiments, a gate electrode 155 may be positioned on an upper surface of the doping region 138. In the example embodiments illustrated in FIG. 19, unlike the example embodiments illustrated in FIG. 2, the lower surface of the gate electrode 155 and the upper surface of the first doping region 138a may be in contact. The gate semiconductor layer 150 may not be positioned between the lower surface of the gate electrode 155 and the upper surface of the first doping region 138a.

In some example embodiments, a first side of the doping region 138 may be closer to the drain electrode 175 than the side of the first field dispersion layer 177a adjacent to the drain electrode 175. The first side of the doping region 138 may be farther from the drain electrode 175 than the side of the second field dispersion layer 177b adjacent to the drain electrode 175. A second side of the doping region 138 may be closer to the source electrode 173 than the side of the gate electrode 155 adjacent to the source electrode 173.

In some example embodiments, the gate electrode 155 may be positioned on the upper surface of the gate semiconductor layer 150. In some example embodiments, the gate semiconductor layer 150 may include a first gate semiconductor layer 151 positioned on the barrier layer 136 and a second gate semiconductor layer 152 positioned on the first gate semiconductor layer 151, but the example embodiments are not limited thereto. For example, the gate semiconductor layer 150 may be formed of a single layer or may be formed of three or more layers.

In some example embodiments, the lower surface of the first gate semiconductor layer 151 may be entirely in contact with the upper surface of the barrier layer 136. In some example embodiments illustrated in FIG. 20, unlike the example embodiments illustrated in FIG. 2, the doping region 138 and the gate semiconductor layer 150 may not overlap in the third direction DR3. In some examples the doping region 138 may not cover the lower surface of the gate semiconductor layer 150.

In some example embodiments, a portion of the gate electrode 155 in contact with the gate semiconductor layer 150 may be positioned at a higher level than a portion of the gate electrode 155 in contact with the doping region 138. The lower surface of the portion of the gate electrode 155 that contacts with the gate semiconductor layer 150 may be positioned at a higher level than the upper surface of the barrier layer 136. The lower surface of the portion of the gate electrode 155 in contact with the doping region 138 may be positioned at substantially the same level as the upper surface of the barrier layer 136.

In some example embodiments, a portion of the field dispersion layer 177 that overlaps a portion of the gate electrode 155 in contact with the gate semiconductor layer 150 in the third direction DR3 may be positioned at a higher level than a portion of the gate electrode 155 in contact with the doping region 138 and a portion of the field dispersion layer 177 that overlaps a portion of the gate electrode 155 in the third direction DR3.

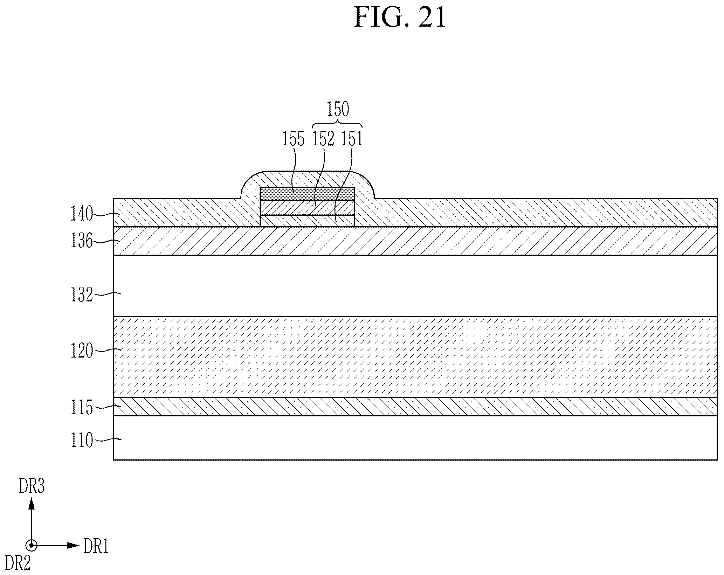

Hereinafter, the manufacturing method of some example embodiments illustrated in FIGS. 1 and 2 and some example embodiments illustrated in FIGS. 6 and 7 will be described with reference to FIGS. 21, 22, 23, 24, 25, 26, and 27.

FIGS. 21, 22, 23, 24, 25, 26, and 27 are cross-sectional views showing a manufacturing process of a semiconductor device according to some example embodiments.

Referring to FIG. 21, a seed layer 115, a buffer layer 120, a channel layer 132, and a barrier layer 136 may be sequentially formed on a substrate 110. Thereafter, a gate semiconductor layer 150 and a gate electrode 155 may be formed on the barrier layer 136. Thereafter, a first protective layer 140 may be formed on the barrier layer 136, the gate semiconductor layer 150, and the gate electrode 155.

For example, the seed layer 115, buffer layer 120, channel layer 132, barrier layer 136, and gate semiconductor material layer may be formed sequentially using an epitaxial growth method. The seed layer 115 may be first formed on a substrate 110, and the buffer layer 120 may be formed on the seed layer 115. The buffer layer 120 may include a superlattice layer and a high-resistance layer. The channel layer 132 may be formed on the buffer layer 120, the barrier layer 136 may be formed on the channel layer 132, and a gate semiconductor material layer may be formed on the barrier layer 136.

For example, the seed layer 115, buffer layer 120, channel layer 132, barrier layer 136, and gate semiconductor material layer may be formed using a metal organic chemical vapor deposition (MOCVD), hydride vapor phase epitaxy (HVPE), and/or molecular beam epitaxy (MBE) process.

The seed layer 115, buffer layer 120, channel layer 132, barrier layer 136, and gate semiconductor material layer may be made of the same base semiconductor material. However, the material composition ratio of each layer may be different depending on the role of each layer and the performance required for the semiconductor device.

For example, the substrate 110 may include Si, the seed layer 115 may include AlN, and the superlattice layer of the buffer layer 120 may have a structure in which layers made of AlGaN and layers made of GaN are repeatedly stacked. The high-resistance layer of the buffer layer 120 may include GaN, the channel layer 132 may include GaN, and the barrier layer 136 may include AlGaN. Because the lattice structure of Si and the lattice structure of GaN are different, it may not be easy to grow the channel layer 132 made of GaN directly on the substrate 110 made of Si. Therefore, by first forming the seed layer 115 or the buffer layer 120 on the substrate 110 and then forming the channel layer 132, the lattice structure of the channel layer 132 may be stably formed.

The channel layer 132 and the barrier layer 136 may be doped with impurities or may not be doped. The gate semiconductor material layer may include GaN and may be doped with impurities. The gate semiconductor material layer may be doped with a p-type impurity, for example, magnesium (Mg). In this case, a portion adjacent to the upper surface of the barrier layer 136 may be doped together with the gate semiconductor material layer. For example, the upper part of the barrier layer 136 may also include a p-type impurity, for example, magnesium (Mg).

Afterwards, a gate electrode material layer may be formed on the gate semiconductor material layer. For example, the gate electrode material layer may be formed using, electron beam evaporation (E-beam evaporation), sputtering, physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) processes, but is not limited thereto.

The gate electrode material layer may include a conductive material. For example, the gate electrode material layer may include a metal, a metal alloy, a conductive metal nitride, a metal silicide, a doped semiconductor material, a conductive metal oxide, or a conductive metal oxynitride.

Thereafter, the gate semiconductor material layer and the gate electrode material layer may be etched to form a gate semiconductor layer 150 and a gate electrode 155, respectively. For example, a hard mask may be formed on a gate electrode material layer, a photoresist pattern may be formed on the hard mask, the hard mask and the gate electrode material layer may be patterned using the photoresist pattern, and the gate semiconductor material layer may be patterned using the hard mask, thereby forming the gate semiconductor layer 150 and the gate electrode 155, respectively. When patterning the gate semiconductor material layer, the upper portion of the barrier layer 136 may be patterned together. The gate semiconductor layer 150 may include a first gate semiconductor layer 151 formed by patterning the upper portion of the barrier layer 136, and a second gate semiconductor layer 152 formed by patterning a gate semiconductor material layer.

For example, the hard mask may be an insulating material deposited by plasma enhanced chemical vapor deposition, or a spin-on hardmask layer (SOH) formed by a spin coating process. The hard mask may include silicon oxide, silicon nitride, silicon oxynitride, or a combination thereof.

For example, etching of the gate semiconductor material layer and the gate electrode material layer may be performed by dry etching using an etching gas. The etching gas may contain fluoride gas or chloride gas. For example, the fluoride gas may include, for example, SF₆, CHF₃, CF₄, or a mixed gas thereof, the chloride gas may include Cl₂, BCl₃, or a mixed gas thereof, the gate electrode material layer may be etched using SF₆ gas, and the gate semiconductor material layer may be etched using a mixed gas of Cl₂ and O₂ or a mixed gas of BCL₃ and SF₆.

In some example embodiments, after etching the gate semiconductor material layer and the gate electrode material layer, a treatment process may be performed to remove byproducts and reduce damage to the barrier layer 136 due to dry etching. For example, byproduct may be removed through an ashing or stripping process. The ashing process and stripping process may be performed sequentially. For example, an ashing process may be performed first to remove the oxygen (O₂) plasma treatment process or the ozone (O₃) treatment process, and then the stripping process may be performed. Apart from the ashing process or strip process, dry and wet treatment processes may be performed. For example, the treatment process may include a dry cleaning process using, for example, N₂O plasma, N₂ plasma, NH₃ plasma, or O₂ plasma, or a wet cleaning process using diluted HF (DHF), BOE, and/or ammonia water (NH₄OH). During this process, the hard mask remaining on the gate electrode 155 may be removed.

Thereafter, a first protective layer 140 may be formed on the barrier layer 136, the gate semiconductor layer 150, and the gate electrode 155. The first protective layer 140 may be formed using a deposition process. The first protective layer 140 may include an insulating material. For example, the first protective layer 140 may include a material such as SiO₂, SiN, SiON, and/or Al₂O₃. The first protective layer 140 is shown as a single layer, but in some example embodiments the first protective layer 140 may be formed of multiple layers in some cases. In this case, different materials may be sequentially deposited to form a first protective layer 140. Alternatively, by using the same material and varying the deposition conditions, a first protective layer 140 composed of multiple layers with different properties may be formed. In particular, the portion of the first protective layer 140 adjacent to the barrier layer 136 may be made of an insulating material of much better quality than other portions. This is to prevent or reduce in likelihood electrons forming a channel from being trapped in the channel layer 132 positioned below the barrier layer 136. The portion of the first protective layer 140 in contact with the barrier layer 136 may be made of SiO₂.

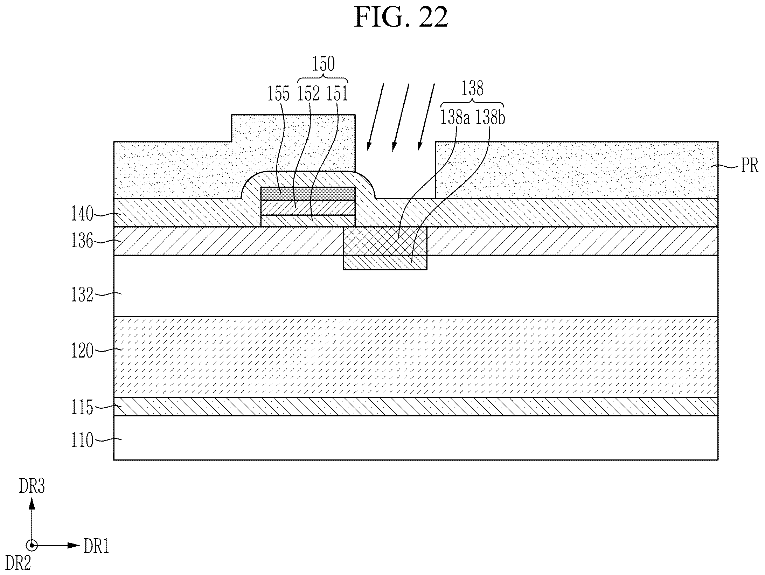

Referring to FIG. 22, a doping region 138 may be formed in the barrier layer 136 and the channel layer 132.

In some example embodiments, the doping region 138 may be formed by an ion implantation process (IIP). First, a region where a doping region 138 is formed may be defined by forming a photoresist pattern PR on the upper surface of the first protective layer 140 using a photolithography process. For example, an area corresponding to an opening of the photoresist pattern PR may be defined as an area where a doping region 138 is formed. The upper surface of the first protective layer 140 overlapping the gate electrode 155 and the gate semiconductor layer 150 in the third direction DR3 may be covered by the photoresist pattern PR. The upper surface of the first protective layer 140 adjacent to the side surface of the gate electrode 155 and the gate semiconductor layer 150 may be exposed by the opening of the photoresist pattern PR. Afterwards, ions may be injected into the region. Here, the ions may be otherwise referred to as dopants or impurities. The doping type of the doping region 138 may be p type. The doping region 138 may include a p-type impurity, for example, magnesium (Mg).

The doping concentration of the doping region 138 may be higher than the doping concentration of the gate semiconductor layer 150. For example, the doping concentration of the doping region 138 may be about 1*10¹⁷cm⁻³ or more and about 1*10¹⁹cm⁻³ or less, and in some examples about 5*10¹⁷cm⁻³ or more and about 5*10¹⁸cm⁻³ or less.

The doping region 138 may have a depth. For example, the depth of the doping region 138 may be about 30 nm or more and about 70 nm or less, and for example, about 40 nm or more and about 60 nm or less. The depth of the doping region 138 may mean the thickness along the third direction DR3. In this case, the depth of the doping region 138 may be determined by the number of ions injected and/or the energy with which the ions are injected (e.g., the speed at which the ions are accelerated). For example, ions may be injected to a level lower than the upper surface of the channel layer 132.

In some example embodiments, the doping region 138 may extend in the third direction DR3 from the upper surface of the barrier layer 136 toward the upper surface of the substrate 110. The upper surface of the doping region 138 may be positioned at substantially the same level as the upper surface of the barrier layer 136. The lower surface of the doping region 138 may be positioned at a lower level than the upper surface of the channel layer 132. The lower surface of the doping region 138 may be positioned at a lower level than the lower surface of the barrier layer 136. The lower surface of the doping region 138 may be positioned at a higher level than the lower surface of the channel layer 132.

In some example embodiments, the doping region 138 may include a first doping region 138a positioned in the barrier layer 136 and including the same material as the barrier layer 136, and a second doping region 138b positioned in the channel layer 132 and including the same material as the channel layer 132. For example, the barrier layer 136 may include AlGaN and the channel layer 132 may include GaN. Accordingly, the first doping region 138a may include p-AlGaN, and the second doping region 138b may include p-GaN.

In some example embodiments, the depth of the doping region 138 may be greater than the thickness of the barrier layer 136 and less than the sum of the thicknesses of the barrier layer 136 and the channel layer 132. The depth of the first doping region 138a may be same as or similar to the thickness of the barrier layer 136, and the depth of the second doping region 138b may be smaller than the depth of the channel layer 132.

However, the example embodiments are not limited thereto, and the depth of the doping region 138 may be variously changed depending on the number of ions and/or the energy with which the ions are injected. For example, the number of ions and/or the energy with which the ions are injected may be reduced so that the ions are injected only to a level higher than the upper surface of the channel layer 132 (or the lower surface of the barrier layer 136). In this case, as illustrated in FIG. 3, the doping region 138 may include only a first doping region 138a positioned in the barrier layer 136 and including the same material as the barrier layer 136.

In some example embodiments, the doping region 138 may be in contact with the gate semiconductor layer 150. The upper surface of the first doping region 138a may be in contact with the lower surface of the first gate semiconductor layer 151.

In some example embodiments, ions may be implanted in a direction oblique to the direction perpendicular to the upper surface of the substrate 110. By injecting ions in a direction oblique to the direction perpendicular to the upper surface of the substrate 110, ions may be injected into the lower portion of the gate electrode 155 and the gate semiconductor layer 150. Accordingly, the doping region 138 may overlap the gate electrode 155 and the gate semiconductor layer 150 in the third direction DR3.

The area where the doping region 138 overlaps the gate semiconductor layer 150 and the gate electrode 155 may be determined by the angle at which ions are injected. For example, when the angle with respect to the central axis perpendicular to the upper surface of the substrate 110 increases, the area where the doping region 138 overlaps with the gate semiconductor layer 150 and the gate electrode 155 may increase. As another example, when the angle with respect to the central axis perpendicular to the upper surface of the substrate 110 decreases, the area where the doping region 138 overlaps with the gate semiconductor layer 150 and the gate electrode 155 may decrease.

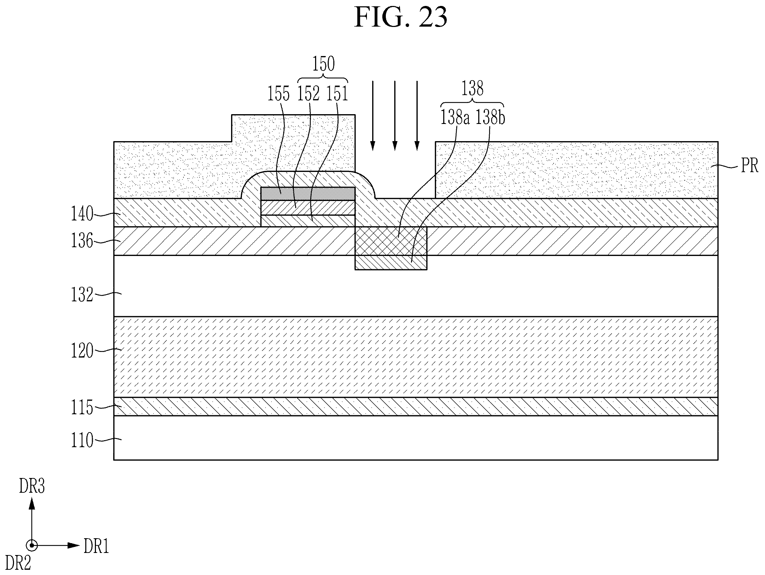

For example, referring to FIG. 23, ions may be injected in a direction perpendicular to the upper surface of the substrate 110. In this case, the doping region 138 may not overlap with the gate semiconductor layer 150 and the gate electrode 155. The doping region 138 may have a tangent line in contact with the gate semiconductor layer 150. For example, the tangent line of the doping region 138 and the gate semiconductor layer 150 may extend in the second direction DR2. After the implant process as illustrated in Fig. 23 is performed, a subsequent process may be performed to manufacture the semiconductor device according to the example embodiments illustrated in Fig. 7.

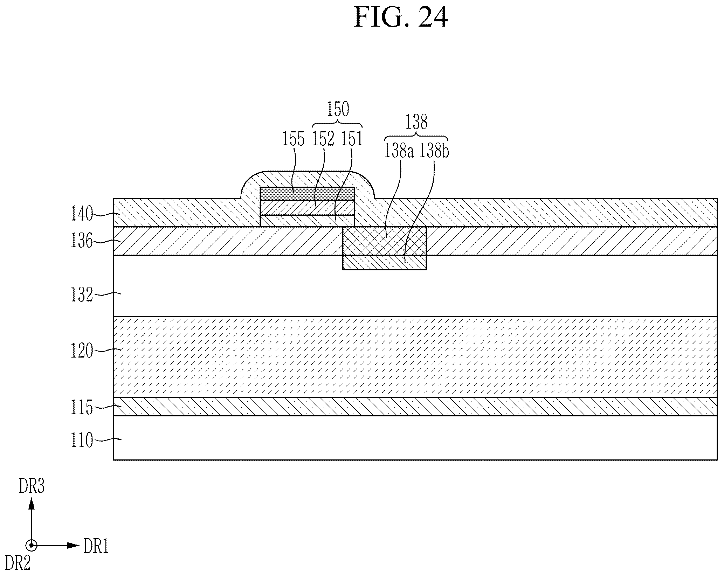

Referring to FIG. 24, the photoresist pattern PR may be removed. For example, the photoresist pattern PR may be removed through an ashing or strip process.

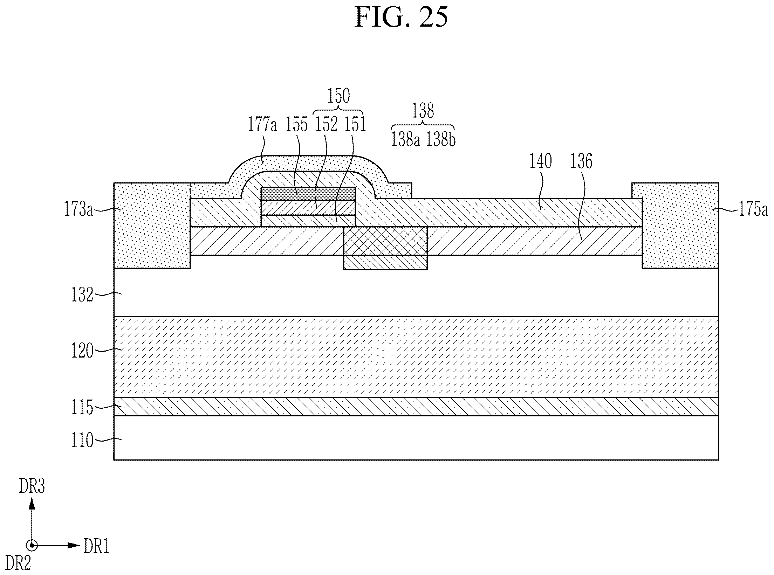

Referring to FIG. 25, the first protective layer 140 may be patterned to form a trench, and a first source electrode 173a and a first drain electrode 175a may be formed in the trench. In the process of forming a trench, not only the first protective layer 140 but also a portion of the barrier layer 136 and the channel layer 132 may be patterned together. Additionally, the first field dispersion layer 177a may be formed together in the process of forming the first source electrode 173a and the first drain electrode 175a. The first field dispersion layer 177a may overlap the gate electrode 155 in the third direction DR3. One side of the first field dispersion layer 177a may be closer to the first drain electrode 175a than the side of the gate electrode 155 adjacent to the first drain electrode 175a. The distance between the first field dispersion layer 177a and the first drain electrode 175a may be shorter than the distance between the gate electrode 155 and the first drain electrode 175a.

The first source electrode 173a and the first drain electrode 175a may be in ohmic contact with the channel layer 132. The region in contact with the first source electrode 173a and the first drain electrode 175a in the barrier layer 136 and the channel layer 132 may be doped at a relatively high concentration compared to other regions. For example, the barrier layer 136 and the channel layer 132 may be doped by an ion implant process, an annealing process, etc. However, it is not limited thereto, and the doping process of the barrier layer 136 and the channel layer 132 may be performed by various other processes. The doping process of the barrier layer 136 and the channel layer 132 may be performed before forming the first source electrode 173a and the first drain electrode 175a. In some cases, the channel layer 132 may not be doped.

The first source electrode 173a, the first drain electrode 175a, and the first field dispersion layer 177a may include a conductive material. For example, the first source electrode 173a, the first drain electrode 175a, and the first field dispersion layer 177a may include a metal, a metal alloy, a conductive metal nitride, a metal silicide, a doped semiconductor material, a conductive metal oxide, and/or a conductive metal oxynitride.

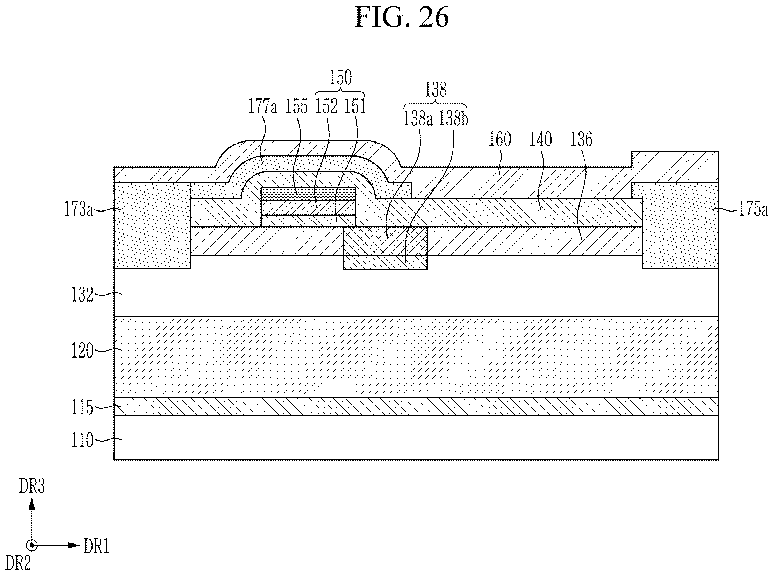

Referring to FIG. 26, a second protective layer 160 may be formed on the first protective layer 140, the first source electrode 173a, the first drain electrode 175a, and the first field dispersion layer 177a. The second protective layer 160 may be formed using a deposition process. The second protective layer 160 may include an insulating material. The second protective layer 160 and the first protective layer 140 may include a same material or a different material.

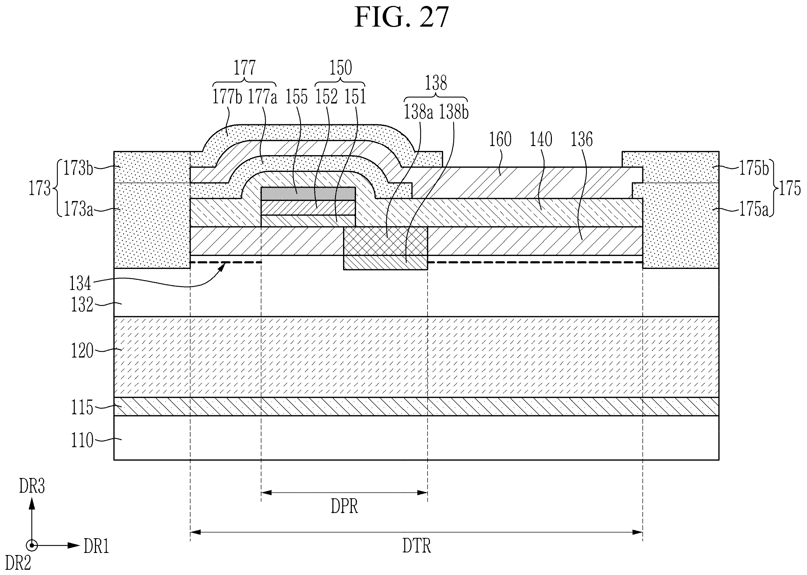

Referring to FIG. 27, a second protective layer 160 may be patterned to form a trench, and a second source electrode 173b and a second drain electrode 175b may be formed in the trench, and a second field dispersion layer 177b may be formed together. The source electrode 173 may include the first source electrode 173a and the second source electrode 173b. The drain electrode 175 may include the first drain electrode 175a and the second drain electrode 175b. The field dispersion layer 177 may include the first field dispersion layer 177a and the second field dispersion layer 177b.

The second field dispersion layer 177b may overlap the first field dispersion layer 177a in the third direction DR3. One side of the second field dispersion layer 177b may be closer to the drain electrode 175 than the side of the first field dispersion layer 177a adjacent to the drain electrode 175. The distance between the second field dispersion layer 177b and the drain electrode 175 may be shorter than the distance between the first field dispersion layer 177a and the drain electrode 175.

In some example embodiments, a first side of the doping region 138 may be closer to the drain electrode 175 than the side of the first field dispersion layer 177a positioned between the gate electrode 155 and the drain electrode 175. The distance between the doping region 138 and the drain electrode 175 may be shorter than the distance between the first field dispersion layer 177a and the drain electrode 175.

In some example embodiments, the first side of the doping region 138 may be further from the drain electrode 175 than the side of the second field dispersion layer 177b positioned between the gate electrode 155 and the drain electrode 175. The distance between the doping region 138 and the drain electrode 175 may be longer than the distance between the second field dispersion layer 177b and the drain electrode 175.

In some example embodiments, a two-dimensional electron gas 134 may be formed in the channel layer 132 adjacent to the barrier layer 136. The two-dimensional electron gas 134 may be located at the interface between the channel layer 132 and the barrier layer 136. The two-dimensional electron gas 134 may be located in the drift region DTR between the source electrode 173 and the drain electrode 175. Electrons may be pushed out near the interface between the channel layer 132 and the barrier layer 136 overlapping the gate semiconductor layer 150 and the doping region 138 by the gate semiconductor layer 150 and the doping region 138 including the p-type impurity. Accordingly, a depletion region DPR in which the two-dimensional electron gas 134 is cut off may be formed in the channel layer 132. The semiconductor device according to some example embodiments may have a normally off characteristic. For example, the semiconductor device according to some example embodiments may be a normally-off high electron mobility transistor (HEMT). In the gate-off state, the two-dimensional electron gas 134 may be located in the drift region DTR excluding the depletion region DPR of the channel layer 132. In the gate-on state, the flow of two-dimensional electron gas 134 continues in the depletion region DPR, so that the two-dimensional electron gas 134 may be located entirely in the drift region DTR.

In some example embodiments, as the doping region 138 overlaps the gate semiconductor layer 150 in the third direction DR3, the depletion region formed by the doping region 138 and the depletion region formed by the gate semiconductor layer 150 may be connected.

In some example embodiments, as the doping region 138 contacts with the gate semiconductor layer 150, the doping region 138 may be electrically connected to the gate semiconductor layer 150 and the gate electrode 155. Accordingly, the doping region 138 may not be floated due to hole injection.

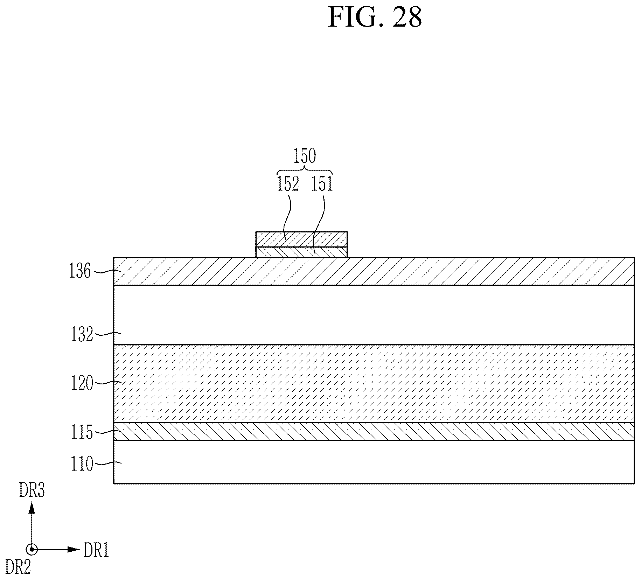

Hereinafter, a manufacturing method of the embodiment shown in FIGS. 11 and 12 will be described with reference to FIGS. 28, 29, 30, 31, 32, 33, and 34.

FIGS. 28, 29, 30, 31, 32, 33, and 34 are cross-sectional views showing a manufacturing process of a semiconductor device according to some example embodiments.

Referring to FIG. 28, a seed layer 115, a buffer layer 120, a channel layer 132, and a barrier layer 136 may be sequentially formed on a substrate 110. Afterwards, a gate semiconductor layer 150 may be formed on the barrier layer 136. The contents described above with reference to FIG. 21 may be substantially identically applied to the process of forming the seed layer 115, the buffer layer 120, the channel layer 132, the barrier layer 136, and the gate semiconductor layer 150, and therefore, redundant descriptions are omitted.

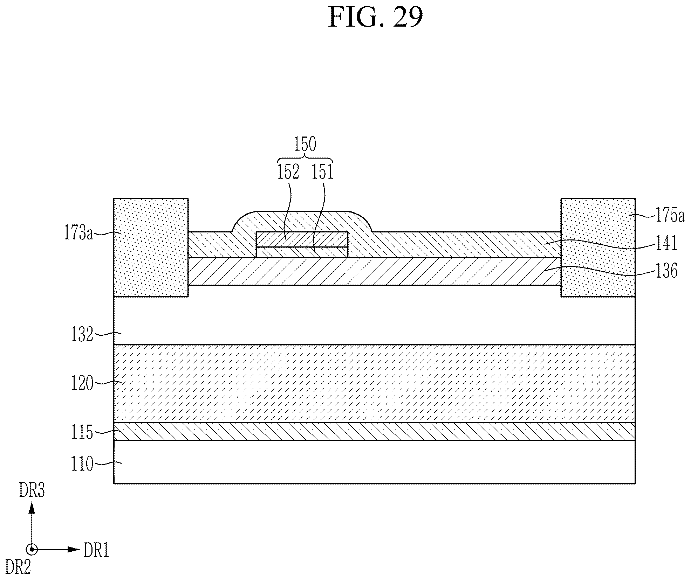

Referring to FIG. 29, a first protective layer 141 may be formed, and a first source electrode 173a and a first drain electrode 175a may be formed.

First, a first protective layer 141 may be formed on the barrier layer 136 and the gate semiconductor layer 150. The first protective layer 141 may be formed using a deposition process. The first protective layer 141 may include an insulating material. For example, the first protective layer 141 may include a material such as SiO₂, SiN, SiON, and/or Al₂O₃. The first protective layer 141 is shown as a single layer, but in some example embodiments the first protective layer 141 may be formed of multiple layers in some cases. In this case, different materials may be sequentially deposited to form a first protective layer 141. Alternatively, by using the same material and varying the deposition conditions, a first protective layer 141 composed of multiple layers with different properties may be formed. In particular, the portion of the first protective layer 141 adjacent to the barrier layer 136 may be made of an insulating material of much better quality than other portions. This is to prevent or reduce in likelihood electrons from forming a channel from being trapped in the channel layer 132 positioned below the barrier layer 136. The portion of the first protective layer 141 in contact with the barrier layer 136 may be made of SiO₂.

Thereafter, the first protective layer 140 may be patterned to form a trench, and a first source electrode 173a and a first drain electrode 175a may be formed in the trench. In the process of forming a trench, not only the first protective layer 140 but also a portion of the barrier layer 136 and the channel layer 132 may be patterned together. The first source electrode 173a and the first drain electrode 175a may be in ohmic contact with the channel layer 132. The region in contact with the first source electrode 173a and the first drain electrode 175a in the barrier layer 136 and the channel layer 132 may be doped at a relatively high concentration compared to other regions. For example, the barrier layer 136 and the channel layer 132 may be doped by an ion implant process, an annealing process, etc. However, it is not limited thereto, and the doping process of the barrier layer 136 and the channel layer 132 may be performed by various other processes. The doping process of the barrier layer 136 and the channel layer 132 may be performed before forming the first source electrode 173a and the first drain electrode 175a. In some cases, the channel layer 132 may not be doped.

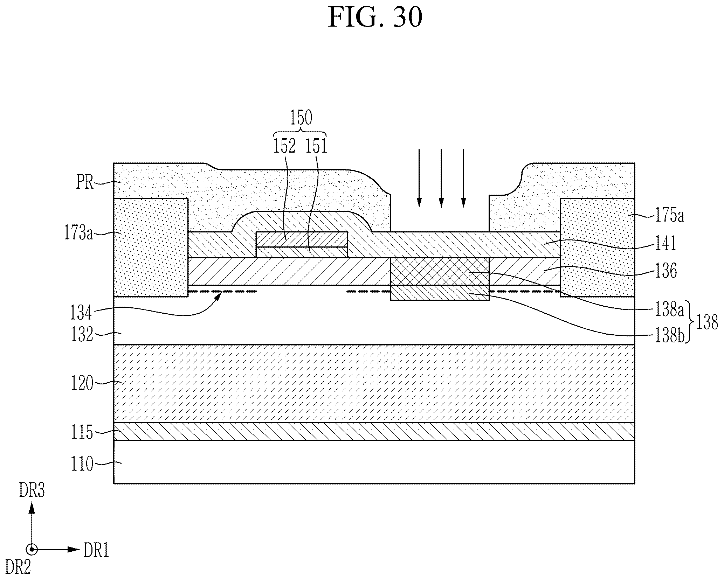

Referring to FIG. 30, a doping region 138 may be formed in the barrier layer 136 and the channel layer 132.

In some example embodiments, the doping region 138 may be formed by an ion implantation process (IIP). First, a region where a doping region 138 is formed may be defined by forming a photoresist pattern PR on the first protective layer 141, the first source electrode 173a, and the first drain electrode 175a using a photolithography process. For example, a region corresponding to an opening of a photoresist pattern PR may be defined as the region where a doping region 138 is formed. The upper surface of the first protective layer 140 overlapping the gate semiconductor layer 150 in the third direction DR3 may be covered by the photoresist pattern PR. The upper surface of the first protective layer 140 between the gate semiconductor layer 150 and the first drain electrode 175a may be exposed by the opening of the photoresist pattern PR. Afterwards, ions may be injected into the region. Here, the doping type, doping concentration, and depth of the doping region 138 may be substantially identically applied to the contents described above with reference to FIG. 22, so redundant descriptions are omitted.

In some example embodiments, a two-dimensional electron gas 134 may be formed in the channel layer 132 adjacent to the barrier layer 136. The two-dimensional electron gas 134 may be located at the interface between the channel layer 132 and the barrier layer 136. The two-dimensional electron gas 134 may be located in the drift region between the source electrode 173 and the drain electrode 175. Electrons may be pushed out near the interface between the channel layer 132 and the barrier layer 136 overlapping the gate semiconductor layer 150 and the doping region 138 by the gate semiconductor layer 150 and the doping region 138 including the p-type impurity. Accordingly, a depletion region in which a two-dimensional electron gas 134 is cut off may be formed in the channel layer 132. The semiconductor device according to some example embodiments may have a normally off characteristic. For example, the semiconductor device according to some example embodiments may be a normally-off high electron mobility transistor (HEMT). In the gate-off state, the two-dimensional electron gas 134 may be located in the drift region excluding the depletion region of the channel layer 132. In the gate-on state, the flow of two-dimensional electron gas 134 continues in the depletion region, so that the two-dimensional electron gas 134 may be located entirely in the drift region.

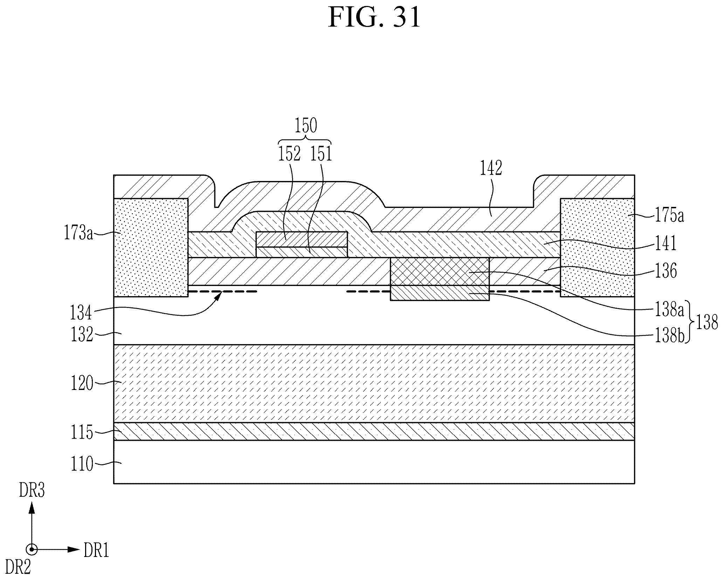

Referring to FIG. 31, a second protective layer 142 may be formed on the first protective layer 141, the first source electrode 173a, and the first drain electrode 175a. The second protective layer 142 may be formed using a deposition process. The second protective layer 142 may be formed to cover the upper surface of the first protective layer 141 and the upper surface and the side surface of the first source electrode 173a and the first drain electrode 175a.

The second protective layer 142 may include an insulating material. The second protective layer 142 and the first protective layer 141 may include a same material or a different material from.

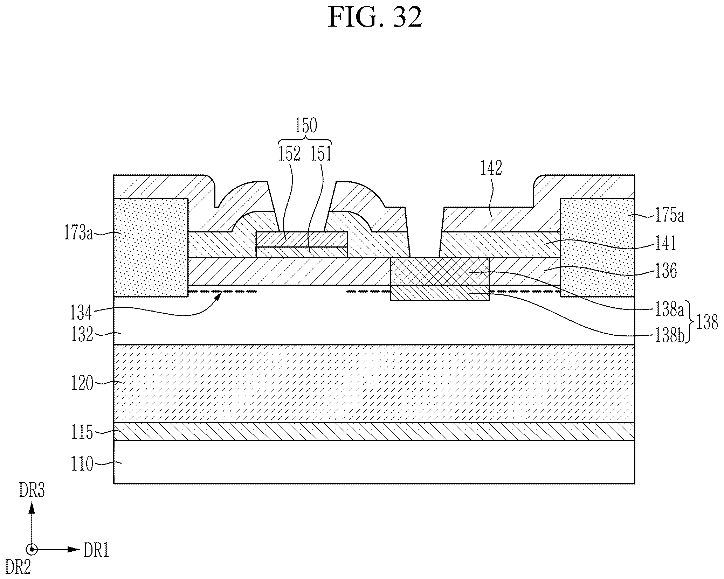

Referring to FIG. 32, a trench may be formed by patterning the second protective layer 142 and the first protective layer 141. The sidewalls of the trench may be defined by the side surface of the second protective layer 142 and the side surface of the first protective layer 141, and the bottom surface of the trench may be defined by the upper surface of the gate semiconductor layer 150 and the upper surface of the doping region 138.

The trench may include a first trench portion extending in the second direction DR2 on the upper surface of the gate semiconductor layer 150, and a second trench portion extending in the second direction DR2 on the upper surface of the doping region 138.

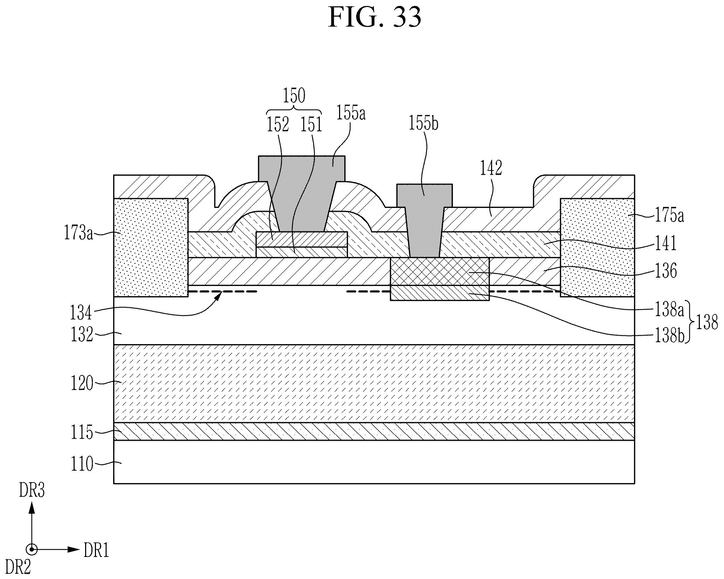

Referring to FIG. 33, a gate electrode 155 may be formed in a trench. The gate electrode 155 may include a first portion 155a formed in the first trench portion, a second portion 155b formed in the second trench portion, and a third portion 155c connecting the first portion 155a and the second portion 155b outside an active region. The region between the first source electrode 173a and the first drain electrode 175a may be defined as the active area. Each of the first part 155a and the second part 155b extends in the second direction DR2, and the third part 155c may connect the first part 155a and the second part 155b in the first direction DR1. The first portion 155a may be in contact with the upper surface of the gate semiconductor layer 150. The first portion 155a may be in contact with the upper surface of the second gate semiconductor layer 152. The second portion 155b may be in contact with the upper surface of the doping region 138. The second portion 155b may be in contact with the upper surface of the first doping region 138a.

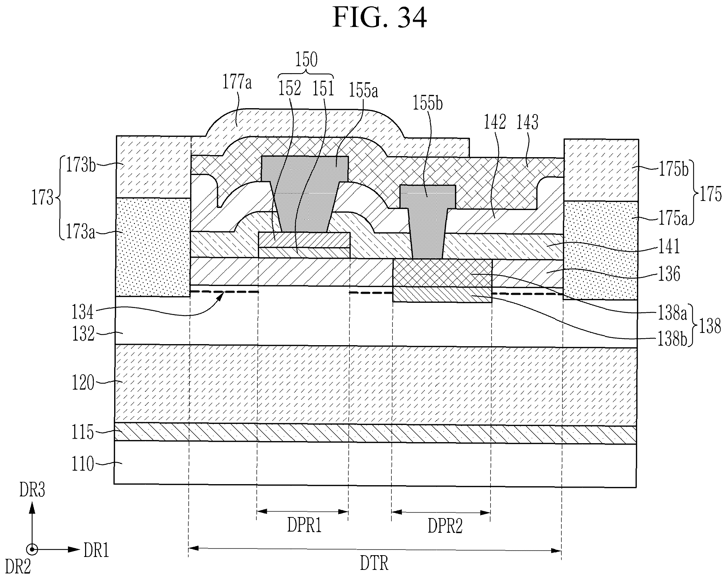

Referring to FIG. 34, a third protective layer 143 may be formed, and a second source electrode 173b, a second drain electrode 175b, and a first field dispersion layer 177a may be formed.

First, a third protective layer 143 may be formed on the second protective layer 142 and the gate electrode 155. The third protective layer 143 may be formed using a deposition process. The third protective layer 143 may be formed to cover the upper surface of the second protective layer 142 and the upper surface and the side surface of the gate electrode 155.

The third protective layer 143 may include an insulating material. The third protective layer 143 may include the same material as at least one of the first protective layer 141 and the second protective layer 142, or the third protective layer 143 may include a material different from the first protective layer 141 and the second protective layer 142.

Thereafter, the third protective layer 143 and the second protective layer 142 may be patterned to form a second source electrode 173b, a second drain electrode 175b, and a first field dispersion layer 177a together. The source electrode 173 may include the first source electrode 173a and the second source electrode 173b. The drain electrode 175 may include the first drain electrode 175a and the second drain electrode 175b.

The first field dispersion layer 177a may overlap the gate electrode 155 in the third direction DR3. One side of the first field dispersion layer 177a may be closer to the drain electrode 175 than the side of the gate electrode 155 adjacent to the drain electrode 175. The distance between the first field dispersion layer 177a and the drain electrode 175 may be shorter than the distance between the gate electrode 155 and the drain electrode 175.

In some example embodiments, one side of the doping region 138 may be closer to the drain electrode 175 than the side of the first field dispersion layer 177a positioned between the gate electrode 155 and the drain electrode 175. The distance between the doping region 138 and the drain electrode 175 may be shorter than the distance between the first field dispersion layer 177a and the drain electrode 175.

In some example embodiments, the doping region 138 may be spaced from the gate semiconductor layer 150 toward the drain electrode 175. The doping region 138 may be spaced apart from the gate semiconductor layer 150 in the first direction DR1. The upper surface of the doping region 138a may not be in contact with the lower surface of the first gate semiconductor layer 151. Accordingly, the first depletion region DPR1 formed by the gate semiconductor layer 150 and the second depletion region DPR2 formed by the doping region 138 may be positioned spaced apart from each other in the drift region DTR.

In some example embodiments, the doping region 138 may be electrically connected to the gate electrode 155. As the doping region 138 is electrically connected to the gate electrode 155, holes may be injected and the doping region 138 may not float. The doping region 138 may be further connected to the gate semiconductor layer 150 by the gate electrode 155.

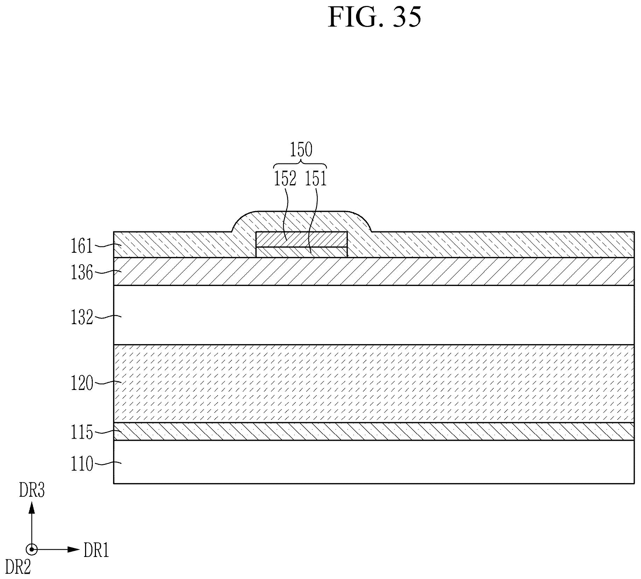

Hereinafter, manufacturing methods of the example embodiments illustrated in FIG. 14 will be described with reference to FIGS. 35, 36, 37, 38, 39, 40, 41, 42, 43, 44, and 45.

FIG. 35, FIG. 36, FIG. 37, FIG. 38, FIG. 39, FIG. 40, FIG. 41, FIG. 42, FIG. 43, FIG. 44, and FIG. 45 are cross-sectional views showing manufacturing processes of semiconductor devices according to some example embodiments.

Referring to FIG. 35, a seed layer 115, a buffer layer 120, a channel layer 132, and a barrier layer 136 may be sequentially formed on a substrate 110. Afterwards, a gate semiconductor layer 150 may be formed on the barrier layer 136. The contents described above with reference to FIG. 21 may be substantially identically applied to the process of forming the seed layer 115, the buffer layer 120, the channel layer 132, the barrier layer 136, and the gate semiconductor layer 150, and therefore, redundant descriptions are omitted.

Thereafter, a first protective layer 161 may be formed on the barrier layer 136 and the gate semiconductor layer 150. The first protective layer 161 may be formed using a deposition process. The first protective layer 161 may include an insulating material. For example, the first protective layer 161 may include a material such as SiO₂, SiN, SiON, or Al₂O₃. The first protective layer 161 is shown as a single layer, but in some example embodiments the first protective layer 161 may be formed of multiple layers in some cases. In this case, different materials may be sequentially deposited to form a first protective layer 161. Alternatively, by using the same material and varying the deposition conditions, a first protective layer 161 composed of multiple layers with different properties may be formed. In particular, the portion of the first protective layer 161 adjacent to the barrier layer 136 may be made of an insulating material of much better quality than other portions. This is to prevent or reduce electrons forming a channel from being trapped in the channel layer 132 located below the barrier layer 136. The portion of the first protective layer 161 in contact with the barrier layer 136 may be made of SiO₂.

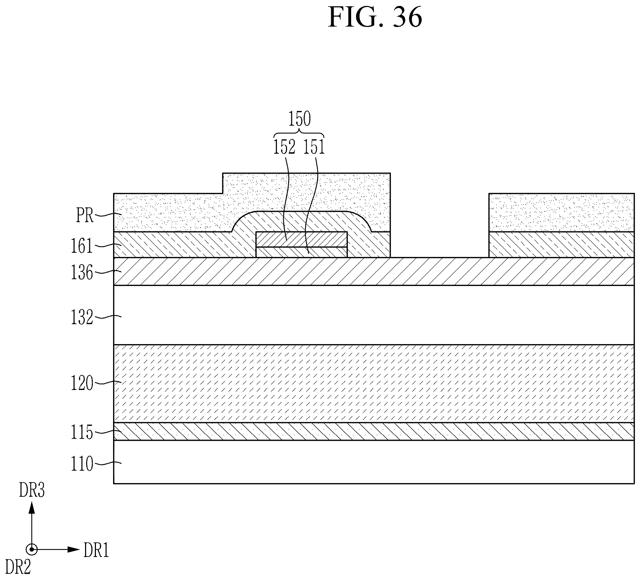

Referring to FIG. 36, a photoresist pattern PR may be formed on the first protective layer 161, and the first protective layer 161 may be patterned using the photoresist pattern PR.

First, the region where the doping region 138 is formed may be defined by forming a photoresist pattern PR. For example, a region corresponding to an opening of the photoresist pattern PR may be defined as the region where a doping region 138 is formed. The upper surface of the first protective layer 161 overlapping the gate semiconductor layer 150 in the third direction DR3 may be covered by the photoresist pattern PR. The upper surface of the first protective layer 161 between the gate semiconductor layer 150 and the first drain electrode 175a may be exposed by the opening of the photoresist pattern PR. Afterwards, a portion of the exposed first protective layer 161 may be etched to form a trench.

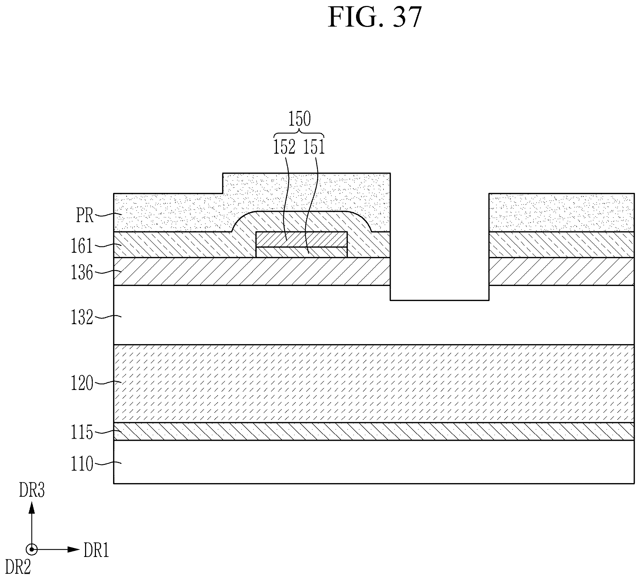

Referring to FIG. 37, the barrier layer 136 and the channel layer 132 may be etched to form a deeper trench. In some example embodiments, the barrier layer 136 may be penetrated by a trench, and the upper surface of the channel layer 132 may be recessed. The channel layer 132 may not be penetrated by a trench. The bottom surface of the trench may be positioned at a level lower than the upper surface of the channel layer 132 and at a level higher than the lower surface of the channel layer 132. The side surface of the barrier layer 136 and the side surface and upper surface of the channel layer 132 may be exposed through the trench.

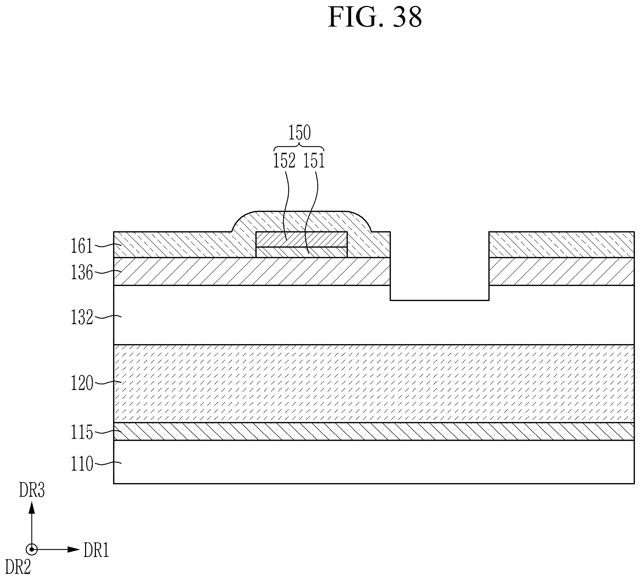

Referring to FIG. 38, the photoresist pattern PR may be removed. For example, the photoresist pattern PR may be removed through an ashing or strip process.

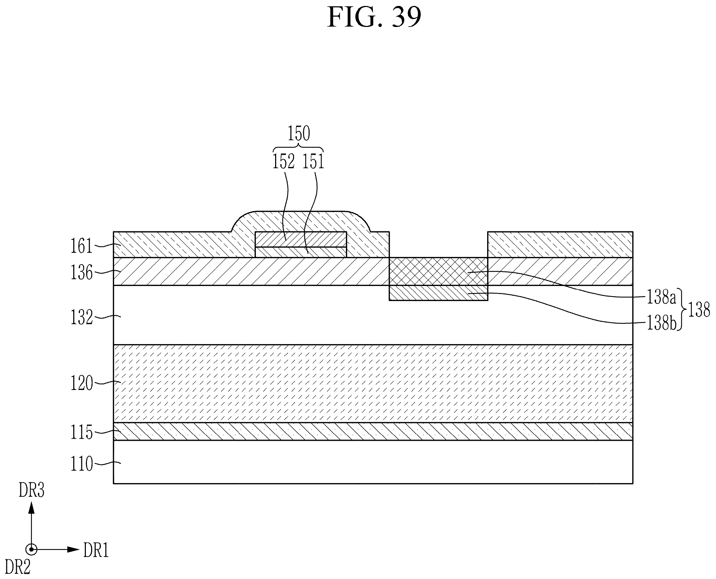

Referring to FIG. 39, a doping region 138 may be formed on the upper surface of the channel layer 132 exposed through the trench using an epitaxial growth method. In this case, a p-type dopant may be added together with the precursor during the epitaxial growth process. The dopant may be, for example, a magnesium source. For example, a second doping region 138b may be grown by supplying a Ga source, an N source, and a Mg source to the chamber to a level substantially equal to the interface between the channel layer 132 and the barrier layer 136. A first doping region 138a may be grown by further supplying an Al source to the chamber from the same level as the interface between the channel layer 132 and the barrier layer 136 to the same level as the upper surface of the barrier layer 136.

In some example embodiments, the doping region 138 may include a first doping region 138a positioned in the barrier layer 136 and including the same material and p-type dopant as the barrier layer 136, and a second doping region 138b positioned in the channel layer 132 and including the same material and p-type dopant as the channel layer 132. For example, the barrier layer 136 may include AlGaN and the channel layer 132 may include GaN. Accordingly, the first doping region 138a may include p-AlGaN, and the second doping region 138b may include p-GaN.

As the doping concentration and depth of the doping region 138 may be substantially identically applied to the contents described above with reference to FIG. 22, redundant descriptions are omitted.

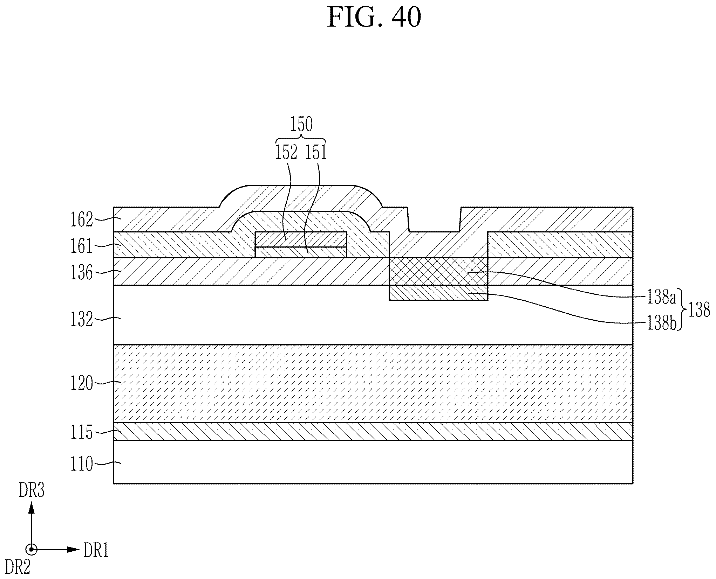

Referring to FIG. 40, a second protective layer 162 may be formed on the first protective layer 161 and the doping region 138. The second protective layer 162 may be formed using a deposition process. The second protective layer 162 may be formed to cover the upper surface and the side surface of the first protective layer 161 and the upper surface of the doping region 138.

The second protective layer 162 may include an insulating material. The second protective layer 162 and the first protective layer 161 may include a same material or a different material from each other.

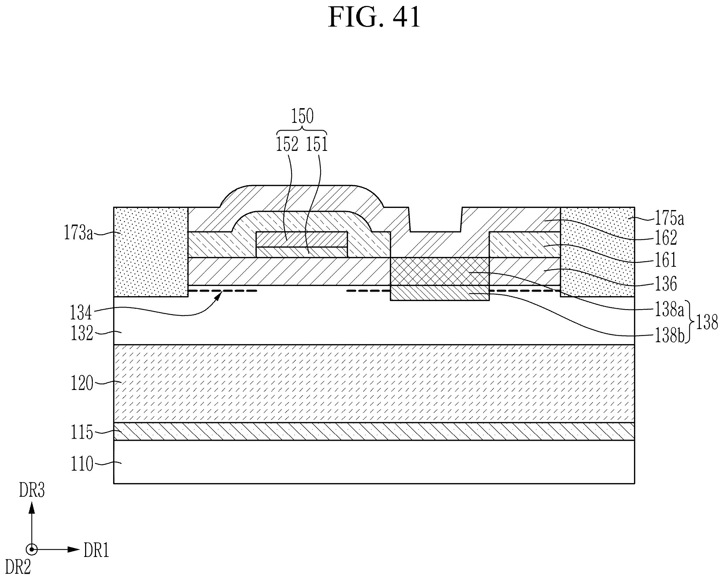

Referring to FIG. 41, the second protective layer 162 and the first protective layer 161 may be patterned to form a trench, and a first source electrode 173a and a first drain electrode 175a may be formed in the trench. The first source electrode 173a and the first drain electrode 175a may be in ohmic contact with the channel layer 132. The region in contact with the first source electrode 173a and the first drain electrode 175a in the barrier layer 136 and the channel layer 132 may be doped at a relatively high concentration compared to other regions. For example, the barrier layer 136 and the channel layer 132 may be doped by an ion implant process, an annealing process, etc. However, it is not limited thereto, and the doping process of the barrier layer 136 and the channel layer 132 may be performed by various other processes. The doping process of the barrier layer 136 and the channel layer 132 may be performed before forming the first source electrode 173a and the first drain electrode 175a. In some cases, the channel layer 132 may not be doped.

In some example embodiments, a two-dimensional electron gas 134 may be formed in the channel layer 132 adjacent to the barrier layer 136. The two-dimensional electron gas 134 may be located at the interface between the channel layer 132 and the barrier layer 136. The two-dimensional electron gas 134 may be located in the drift region between the source electrode 173 and the drain electrode 175. Electrons may be pushed out near the interface between the channel layer 132 and the barrier layer 136 overlapping the gate semiconductor layer 150 and the doping region 138 by the gate semiconductor layer 150 and the doping region 138 including the p-type impurity. Accordingly, a depletion region in which the two-dimensional electron gas 134 is cut off may be formed in the channel layer 132. The semiconductor device according to some example embodiments may have a normally off characteristic. For example, the semiconductor device according to some example embodiments may be a normally-off high electron mobility transistor (HEMT). In the gate-off state, the two-dimensional electron gas 134 may be located in the drift region excluding the depletion region of the channel layer 132. In the gate-on state, the flow of two-dimensional electron gas 134 continues in at least a portion of the depletion region, so that the two-dimensional electron gas 134 may be connected in the drift region.

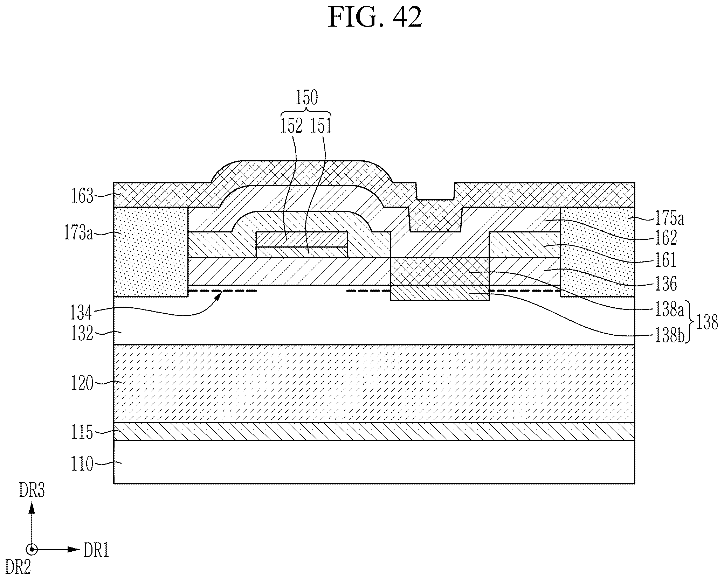

Referring to FIG. 42, a third protective layer 163 may be formed on the second protective layer 162, the first source electrode 173a, and the first drain electrode 175a. The third protective layer 163 may be formed using a deposition process. The third protective layer 163 may be formed to cover the upper surface of the second protective layer 162 and the upper surface of the first source electrode 173a and the upper surface of the first drain electrode 175a.

The third protective layer 163 may include an insulating material. The third protective layer 163 may include the same material as at least one of the first protective layer 161 and the second protective layer 162, or the third protective layer 163 may include a material different from the first protective layer 161 and the second protective layer 162.

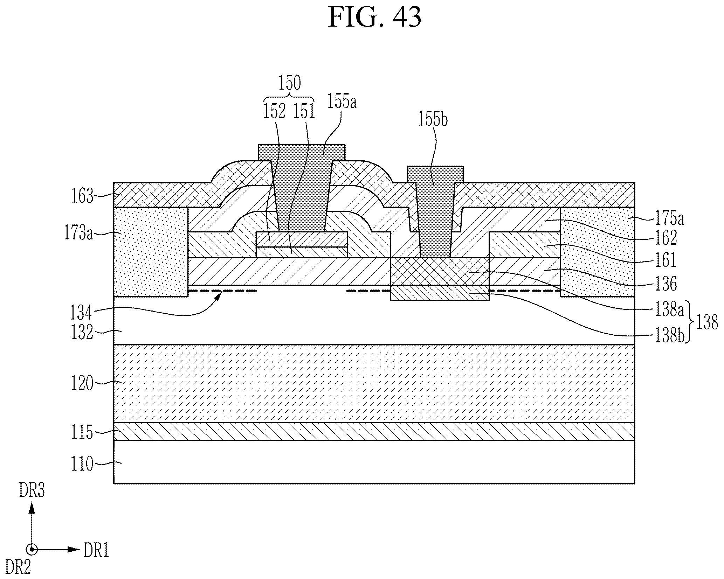

Referring to FIG. 43, the third protective layer 163, the second protective layer 142, and the first protective layer 141 may be patterned to form a trench, and a gate electrode 155 may be formed in the trench.

The trench may include a first trench portion extending in the second direction DR2 on the upper surface of the gate semiconductor layer 150, and a second trench portion extending in the second direction DR2 on the upper surface of the doping region 138.

The gate electrode 155 may include a first portion 155a formed in the first trench portion, a second portion 155b formed in the second trench portion, and a third portion 155c connecting the first portion 155a and the second portion 155b outside an active region. The region between the first source electrode 173a and the first drain electrode 175a may be defined as the active area. Each of the first part 155a and the second part 155b extends in the second direction DR2, and the third part 155c may connect the first part 155a and the second part 155b in the first direction DR1.

The first portion 155a may be in contact with the upper surface of the gate semiconductor layer 150. The lower surface of the first portion 155a may be in contact with the upper surface of the second gate semiconductor layer 152. The side of the first portion 155a may be in contact with the first protective layer 161, the second protective layer 162, and the third protective layer 163.

The second portion 155b may be in contact with the upper surface of the doping region 138. The lower surface of the second portion 155b may be in contact with the upper surface of the first doping region 138a. The side of the second portion 155b may be in contact with the second protective layer 162 and the third protective layer 163. In some example embodiments, the side of the second portion 155b may not be in contact with the first protective layer 161. The side of the second portion 155b may be separated from the first protective layer 161 by the second protective layer 162.

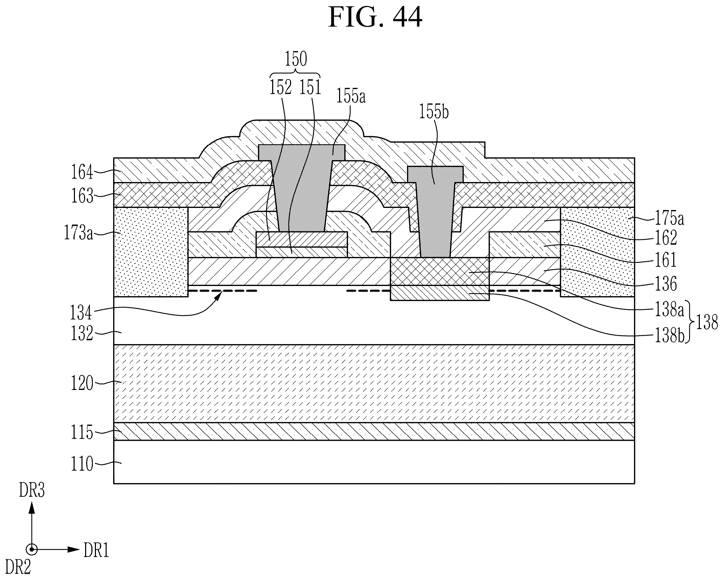

Referring to Fig. 44, a fourth protective layer 164 may be formed. The fourth protective layer 164 may be formed using a deposition process. The fourth protective layer 164 may be formed to cover the upper surface of the third protective layer 163 and the upper surface and the side surface of the gate electrode 155.

The fourth protective layer 164 may include an insulating material. The fourth protective layer 164 may include the same material as at least one of the first protective layer 161, the second protective layer 162, and the third protective layer 163, or may include a material different from the first protective layer 161, the second protective layer 162, and the third protective layer 163.

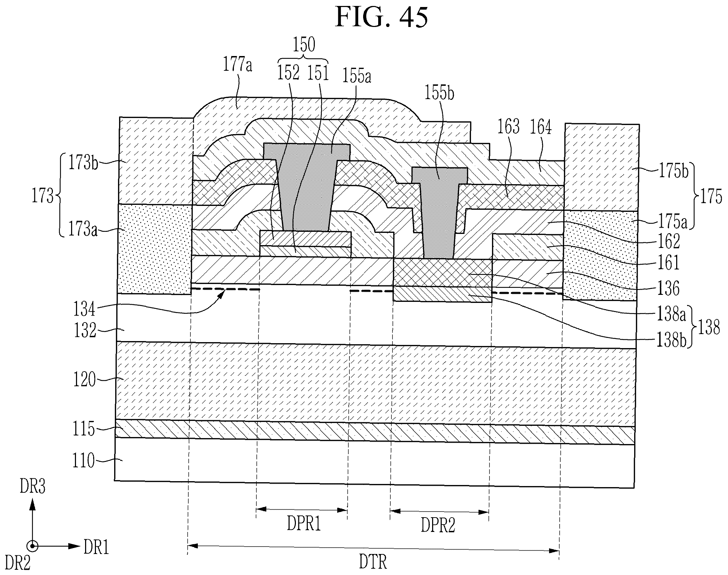

Referring to FIG. 45, the fourth protective layer 164 and the third protective layer 163 may be patterned to form a second source electrode 173b, a second drain electrode 175b, and a first field dispersion layer 177a together. The source electrode 173 may include the first source electrode 173a and the second source electrode 173b. The drain electrode 175 may include the first drain electrode 175a and the second drain electrode 175b.

The first field dispersion layer 177a may overlap the gate electrode 155 in the third direction DR3. One side of the first field dispersion layer 177a may be closer to the drain electrode 175 than the side of the gate electrode 155 adjacent to the drain electrode 175. The distance between the first field dispersion layer 177a and the drain electrode 175 may be shorter than the distance between the gate electrode 155 and the drain electrode 175.

In some example embodiments, one side of the doping region 138 may be closer to the drain electrode 175 than the side of the first field dispersion layer 177a positioned between the gate electrode 155 and the drain electrode 175. The distance between the doping region 138 and the drain electrode 175 may be shorter than the distance between the first field dispersion layer 177a and the drain electrode 175.

In some example embodiments, the doping region 138 may be spaced from the gate semiconductor layer 150 toward the drain electrode 175. The doping region 138 may be spaced apart from the gate semiconductor layer 150 in the first direction DR1. The upper surface of the doping region 138 may not be in contact with the lower surface of the gate semiconductor layer 150. Accordingly, the first depletion region DPR1 formed by the gate semiconductor layer 150 and the second depletion region DPR2 formed by the doping region 138 may be positioned spaced apart from each other in the drift region DTR.

In some example embodiments, the doping region 138 may be electrically connected to the gate electrode 155. As the doping region 138 is electrically connected to the gate electrode 155, holes may be injected and the doping region 138 may not float. The doping region 138 may be further connected to the gate semiconductor layer 150 by the gate electrode 155.

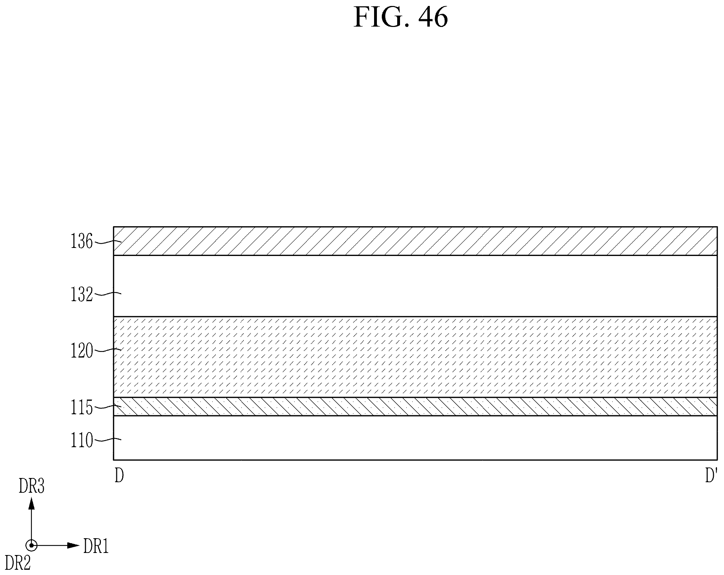

Hereinafter, the manufacturing methods of the example embodiments illustrated in FIGS. 18 to 20 will be described with reference to FIGS. 46, 47, 48, 49, 50, 51, 52, 53, 54, 55, 56, 57, 58, 59, 60, and 61.

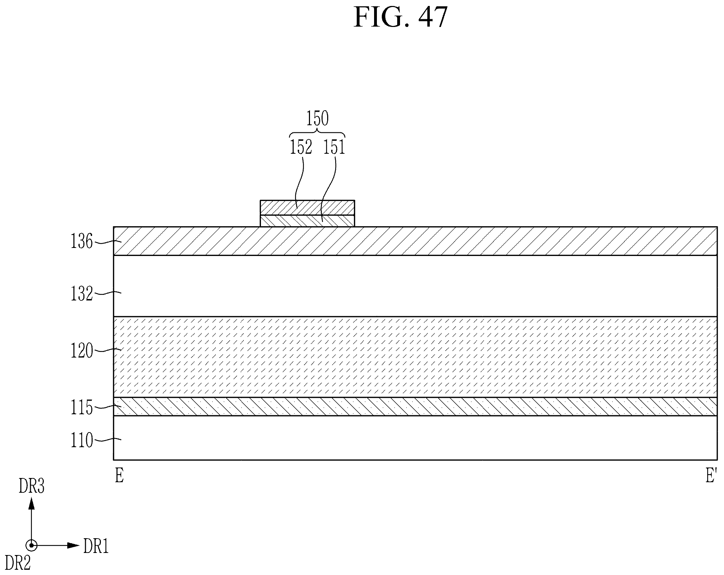

FIG. 46, FIG. 47, FIG. 48, FIG. 49, FIG. 50, FIG. 51, FIG. 52, FIG. 53, FIG. 54, FIG. 55, FIG. 56, FIG. 57, FIG. 58, FIG. 59, FIG. 60, and FIG. 61 are cross-sectional views showing manufacturing processes of semiconductor devices according to some example embodiments. FIG. 46, FIG. 48, FIG. 50, FIG. 52, FIG. 54, FIG. 56, FIG. 58, and FIG. 60 are cross-sectional views taken along the line D-D' of FIG. 18 in each process. FIG. 47, FIG. 49, FIG. 51, FIG. 53, FIG. 55, FIG. 57, FIG. 59, and FIG. 61 are cross-sectional views taken along the line E-E' of FIG. 18 in each process.

Referring to FIG. 46 and FIG. 47, a seed layer 115, a buffer layer 120, a channel layer 132, and a barrier layer 136 may be sequentially formed on a substrate 110. The contents described above with reference to FIG. 21 may be substantially identically applied to the process of forming the seed layer 115, the buffer layer 120, the channel layer 132, and the barrier layer 136, and therefore, redundant descriptions are omitted.

Thereafter, a plurality of gate semiconductor layers 150 may be formed on the barrier layer 136. For example, a gate semiconductor material layer may be formed on a barrier layer 136, and the gate semiconductor material layer may be patterned to form the plurality of gate semiconductor layers 150. In some example embodiments, the plurality of gate semiconductor layers 150 may be spaced apart and arranged along the second direction DR2. Accordingly, in Fig. 47, the gate semiconductor layer 150 may not be positioned on the barrier layer 136.

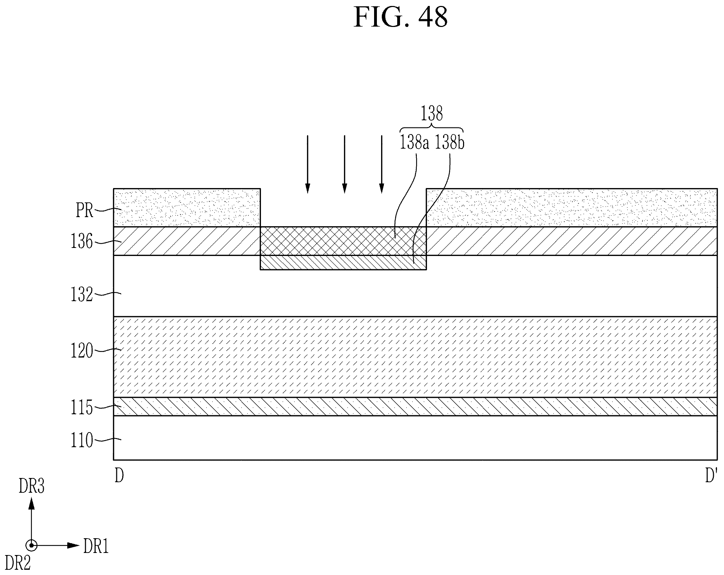

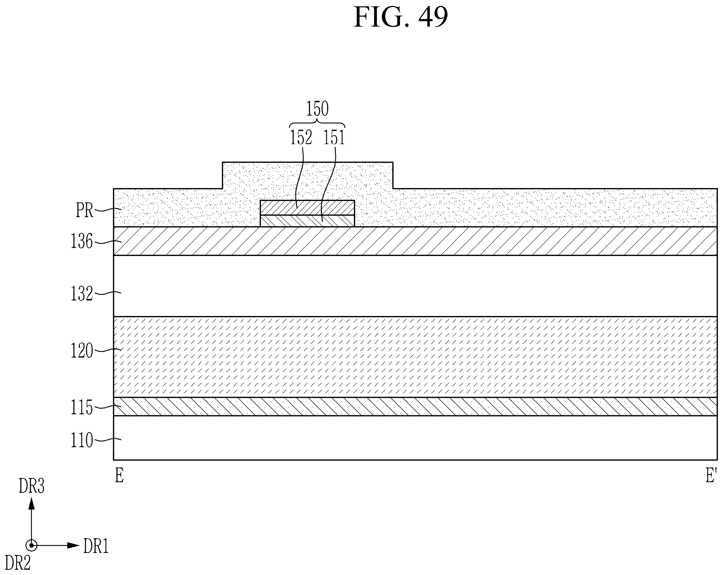

Referring to FIG. 48 and FIG. 49, a doping region 138 may be formed in the barrier layer 136 and the channel layer 132.

In some example embodiments, the doping region 138 may be formed by an ion implantation process (IIP). First, a region where a doping region 138 is formed may be defined by forming a photoresist pattern PR on a barrier layer 136 and a gate semiconductor layer 150 using a photolithography process. For example, a region corresponding to an opening of a photoresist pattern PR may be defined as the region where a doping region 138 is formed. The gate semiconductor layer 150 and the barrier layer 136 overlapping the gate semiconductor layer 150 in the third direction DR3 may be covered by the photoresist pattern PR. The upper surface of the barrier layer 136 between the plurality of gate semiconductor layers 150 may be exposed by the opening of the photoresist pattern PR. Afterwards, ions may be injected into the region.

In some example embodiments, a plurality of doping regions 138 may be formed to be alternately arranged with the plurality of gate semiconductor layers 150 along the second direction DR2. In a plan view, the doping region 138 and the gate semiconductor layer 150 may be in contact in the second direction DR2, but the example embodiments are not limited thereto. In some cases, the doping region 138 and the gate semiconductor layer 150 may be spaced apart in the second direction DR2 in a plan view.

As the doping type, doping concentration, and depth of the doping region 138 may be substantially identically applied to the contents described above with reference to FIG. 22, redundant descriptions are omitted.

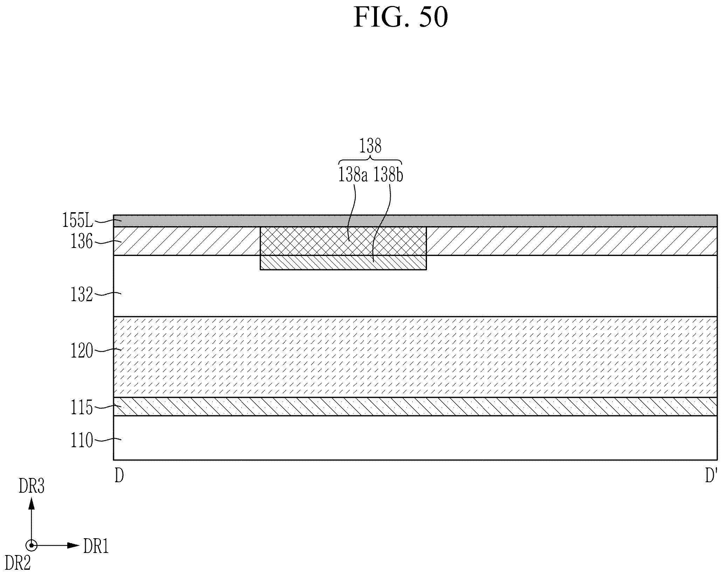

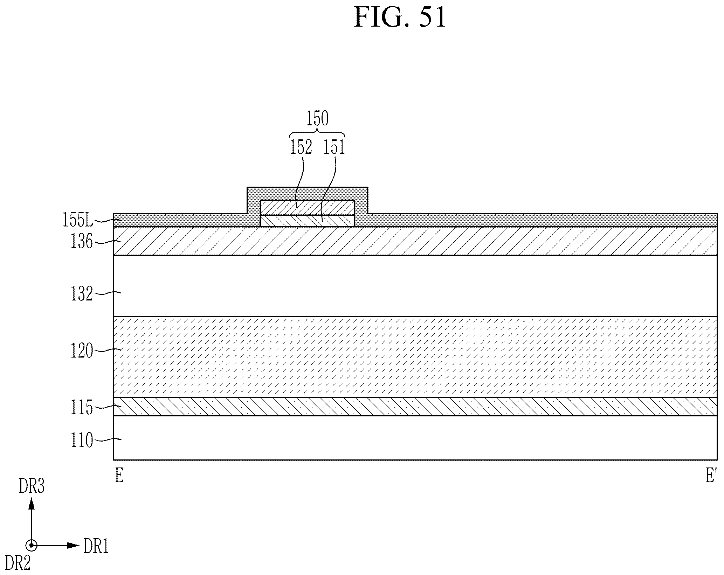

Referring to FIGS. 50 and 51, the photoresist pattern PR may be removed and a gate electrode material layer 155L may be formed.

For example, the photoresist pattern PR may be removed using an ashing or stripping process. After the photoresist pattern PR is removed, a gate electrode material layer 155L may be formed on the barrier layer 136, the doping region 138, and the gate semiconductor layer 150. For example, the gate electrode material layer 155L may be formed using electron beam evaporation (E-beam evaporation), sputtering, physical vapor deposition (PVD), thermal chemical vapor deposition (thermal CVD), low pressure chemical vapor deposition (LP-CVD), plasma enhanced chemical vapor deposition (PE-CVD), and/or atomic layer deposition (ALD) process, but the example embodiments are not limited thereto.

The gate electrode material layer 155L may be formed to cover the upper surface of the barrier layer 136, the upper surface of the doping region 138, and the upper surface and the side surface of the gate semiconductor layer 150.

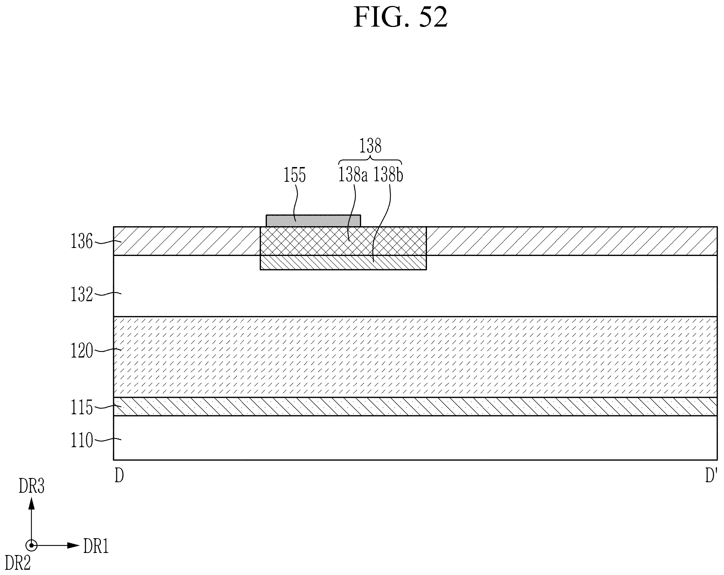

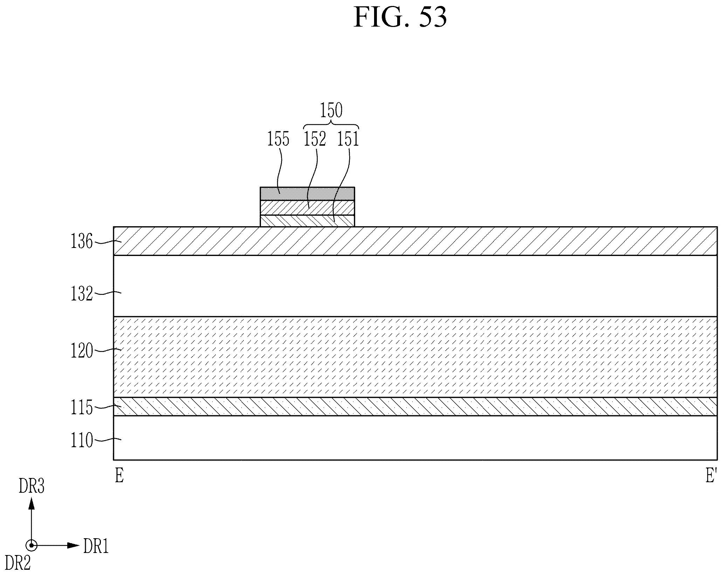

Referring to FIGS. 52 and 53, a gate electrode 155 may be formed by etching a gate electrode material layer. For example, a photoresist pattern may be formed on a gate electrode material layer, and the gate electrode material layer may be patterned using the photoresist pattern to form a gate electrode 155. In some example embodiments, the gate electrode 155 may extend along the second direction DR2. The gate electrode 155 may be in contact with the plurality of doping regions 138 and the plurality of gate semiconductor layers 150 that are alternately arranged along the second direction DR2. The lower surface of the gate electrode 155 may be in contact with the upper surfaces of the plurality of doping regions 138 and the upper surfaces of the plurality of gate semiconductor layers 150.

In some example embodiments, the gate electrode 155 may overlap the doping region 138 in the third direction DR3. A width of the gate electrode 155 along the first direction DR1 may be smaller than the width of the doping region 138 along the first direction DR1. The gate electrode 155 may entirely overlap with the doping region 138. The entire lower surface of the gate electrode 155 may be in contact with the upper surface of the doping region 138.

In some example embodiments, the gate electrode 155 may overlap the gate semiconductor layer 150 in the third direction DR3. For example, the width of the gate electrode 155 along the first direction DR1 may be substantially the same as the width of the gate semiconductor layer 150 along the first direction DR1, but the example embodiments are not limited thereto. In some cases, the width of the gate electrode 155 along the first direction DR1 may be smaller than the width of the gate semiconductor layer 150 along the first direction DR1.

In some example embodiments, a portion of the gate electrode 155 in contact with the gate semiconductor layer 150 may be positioned at a higher level than a portion of the gate electrode 155 in contact with the doping region 138. The lower surface of the portion of the gate electrode 155 that contacts with the gate semiconductor layer 150 may be positioned at a higher level than the upper surface of the barrier layer 136. The lower surface of the portion of the gate electrode 155 in contact with the doping region 138 may be positioned at substantially the same level as the upper surface of the barrier layer 136.

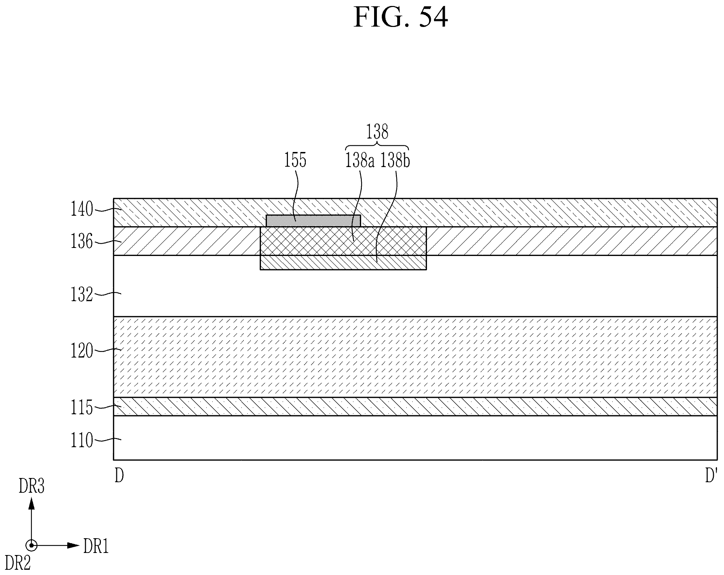

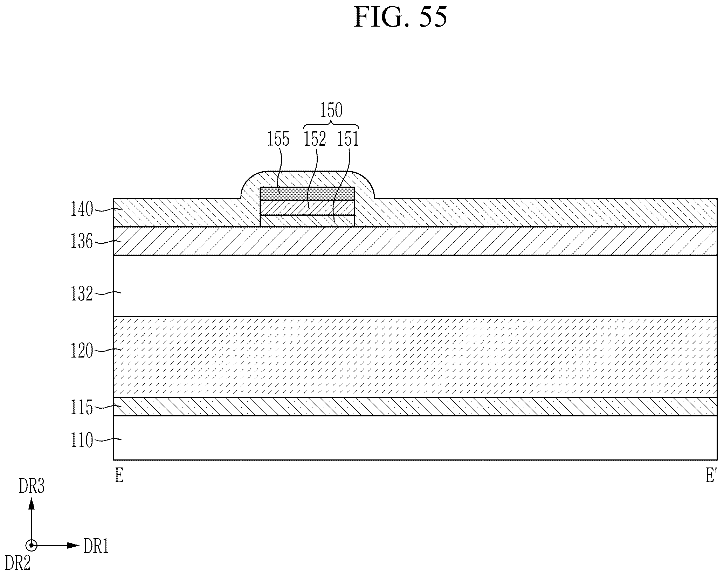

Referring to FIG. 54 and FIG. 55, a first protective layer 140 may be formed on the barrier layer 136, the doping region 138, the gate semiconductor layer 150, and the gate electrode 155. The first protective layer 140 may be formed using a deposition process. The first protective layer 140 may cover the upper surface of the barrier layer 136, the upper surface of the doping region 138, and the upper surface of the gate electrode 155. The first protective layer 140 may cover the side surface of the gate semiconductor layer 150 and the side surface of the gate electrode 155. In some cases, the first protective layer 140 may further cover a portion of the upper surface of the gate semiconductor layer 150 that is not covered by the gate electrode 155.

The first protective layer 140 may include an insulating material. For example, the first protective layer 140 may include a material such as SiO₂, SiN, SiON, or Al₂O₃. The first protective layer 140 is shown as a single layer, but in some example embodiments the first protective layer 140 may be formed of multiple layers in some cases. In this case, different materials may be sequentially deposited to form a first protective layer 140. Alternatively, by using the same material and varying the deposition conditions, a first protective layer 140 composed of multiple layers with different properties may be formed. In particular, the portion of the first protective layer 140 adjacent to the barrier layer 136 may be made of an insulating material of much better quality than other portions. This is to prevent or reduce electrons forming a channel from being trapped in the channel layer 132 located below the barrier layer 136. The portion of the first protective layer 140 in contact with the barrier layer 136 may be made of SiO₂.

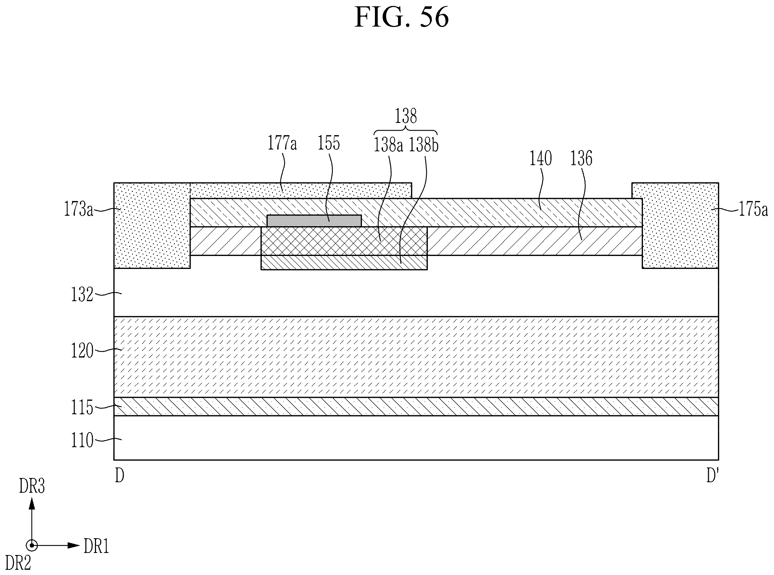

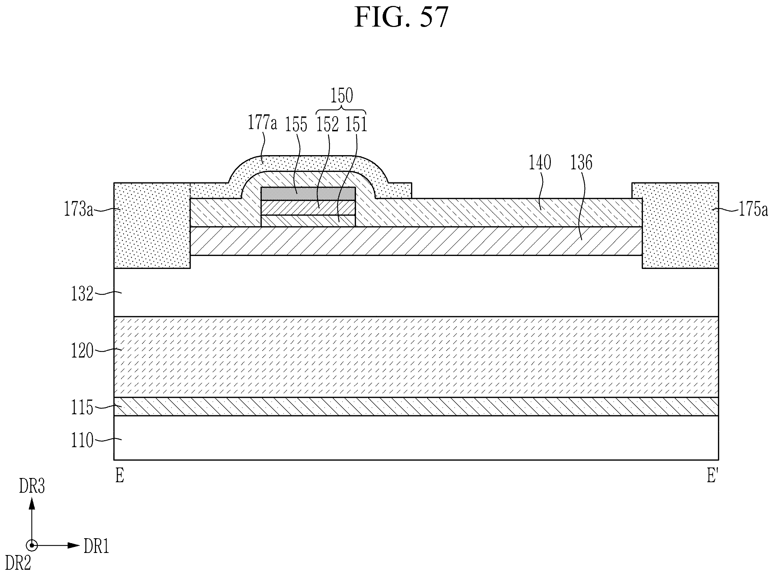

Referring to FIG. 56 and FIG. 57, a first protective layer 140 may be patterned to form a trench, and a first source electrode 173a and a first drain electrode 175a may be formed in the trench. In the process of forming a trench, not only the first protective layer 140 but also a portion of the barrier layer 136 and the channel layer 132 may be patterned together. The first source electrode 173a and the first drain electrode 175a may be in ohmic contact with the channel layer 132. The region in contact with the first source electrode 173a and the first drain electrode 175a in the barrier layer 136 and the channel layer 132 may be doped at a relatively high concentration compared to other regions. For example, the channel layer 132 may be doped by an ion implant process, an annealing process, etc. However, it is not limited thereto, and the doping process of the barrier layer 136 and the channel layer 132 may be performed by various other processes. The doping process of the barrier layer 136 and the channel layer 132 may be performed before forming the first source electrode 173a and the first drain electrode 175a. In some cases, the channel layer 132 may not be doped.

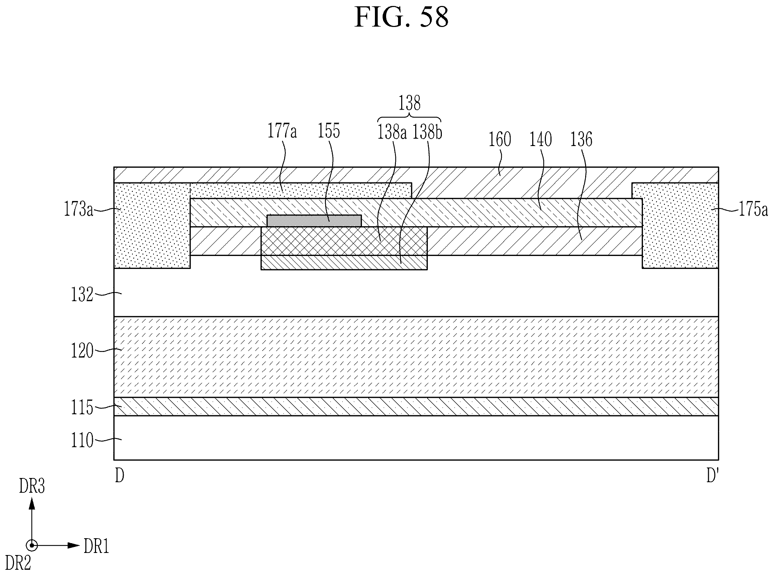

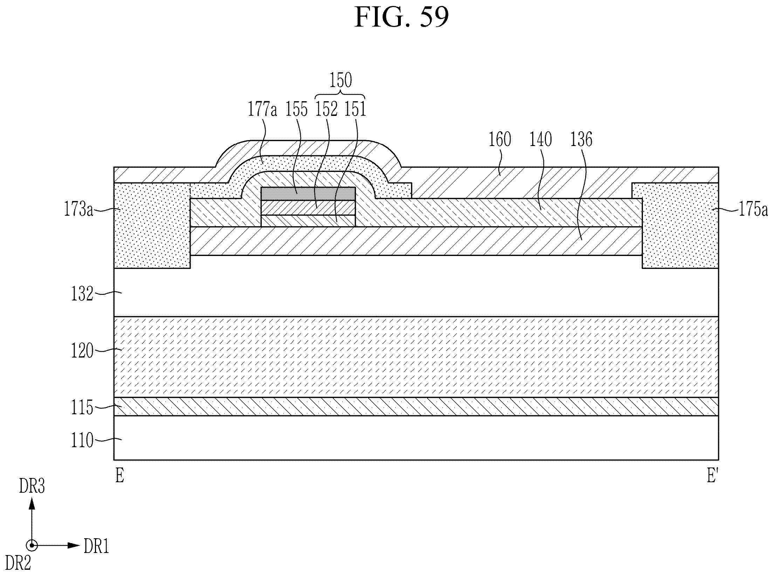

Referring to FIG. 58 and FIG. 59, a second protective layer 160 may be formed on the first protective layer 140, the first source electrode 173a, the first drain electrode 175a, and the first field dispersion layer 177a. The second protective layer 160 may be formed using a deposition process. The second protective layer 160 may include an insulating material. The second protective layer 160 and the first protective layer 140 may include a same material or a different material.

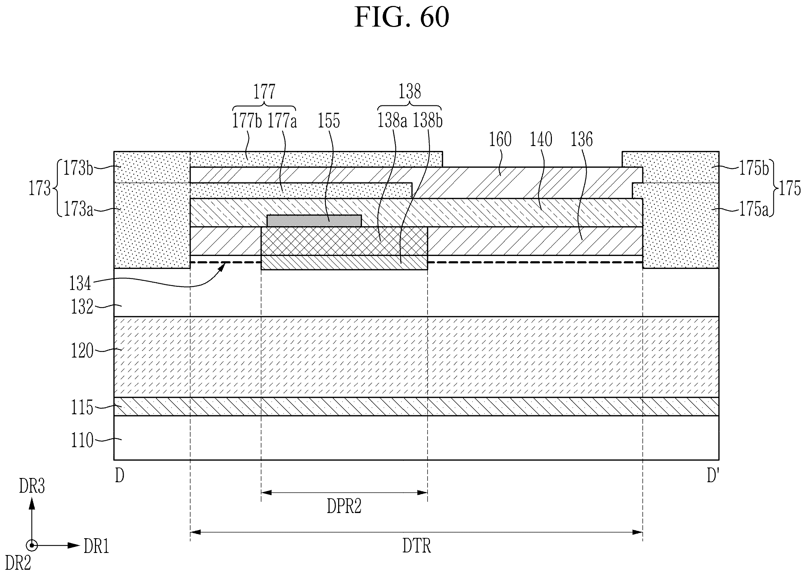

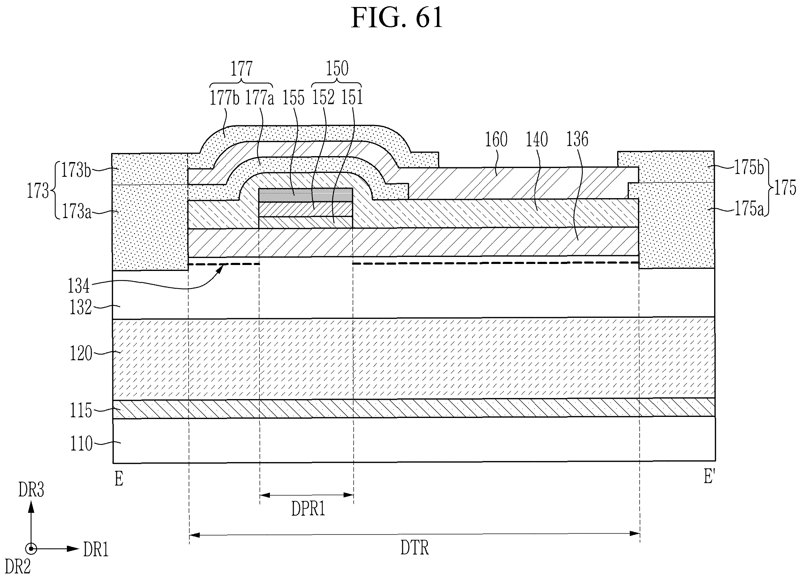

Referring to FIG. 60 and FIG. 61, a second protective layer 160 may be patterned to form a trench, and a second source electrode 173b and a second drain electrode 175b may be formed in the trench, and a second field dispersion layer 177b may be formed together. The source electrode 173 may include the first source electrode 173a and the second source electrode 173b. The drain electrode 175 may include the first drain electrode 175a and the second drain electrode 175b. The field dispersion layer 177 may include the first field dispersion layer 177a and the second field dispersion layer 177b.

The second field dispersion layer 177b may overlap the first field dispersion layer 177a in the third direction DR3. One side of the second field dispersion layer 177b may be closer to the drain electrode 175 than the side of the first field dispersion layer 177a adjacent to the drain electrode 175. The distance between the second field dispersion layer 177b and the drain electrode 175 may be shorter than the distance between the first field dispersion layer 177a and the drain electrode 175.

In some example embodiments, a portion of the field dispersion layer 177 that overlaps a portion of the gate electrode 155 in contact with the gate semiconductor layer 150 in the third direction DR3 may be positioned at a higher level than a portion of the field dispersion layer 177 that overlaps a portion of the gate electrode 155 in contact with the doping region 138 in the third direction DR3.

In some example embodiments, one side of the doping region 138 may be closer to the drain electrode 175 than the side of the first field dispersion layer 177a positioned between the gate electrode 155 and the drain electrode 175. The distance between the doping region 138 and the drain electrode 175 may be shorter than the distance between the first field dispersion layer 177a and the drain electrode 175.

In some example embodiments, one side of the doping region 138 may be further from the drain electrode 175 than a side of the second field dispersion layer 177b positioned between the gate electrode 155 and the drain electrode 175. The distance between the doping region 138 and the drain electrode 175 may be longer than the distance between the second field dispersion layer 177b and the drain electrode 175.

In some example embodiments, a two-dimensional electron gas 134 may be formed in the channel layer 132 adjacent to the barrier layer 136. The two-dimensional electron gas 134 may be located at the interface between the channel layer 132 and the barrier layer 136. The two-dimensional electron gas 134 may be located in the drift region DTR between the source electrode 173 and the drain electrode 175. Electrons may be pushed out near the interface between the channel layer 132 and the barrier layer 136 overlapping the gate semiconductor layer 150 and the doping region 138 by the gate semiconductor layer 150 and the doping region 138 including the p-type impurity. Accordingly, a first depletion region DPR1 and a second depletion region DPR2 in which the two-dimensional electron gas 134 is cut off may be formed in the channel layer 132. The semiconductor device according to some example embodiments may have a normally off characteristic. For example, the semiconductor device according to some example embodiments may be a normally-off high electron mobility transistor (HEMT). In the gate-off state, the two-dimensional electron gas 134 may be located in the drift region DTR excluding the first depletion region DPR1 and the second depletion region DPR2 of the channel layer 132. In the gate-on state, the flow of two-dimensional electron gas 134 continues in the first depletion region DPR1, so that the two-dimensional electron gas 134 may be connected in the drift region DTR. In the gate-on state, the two-dimensional electron gas 134 may or may not be located in the second depletion region DPR2.

In some example embodiments, as the plurality of doping regions 138 and the plurality of gate semiconductor layers 150 are alternately arranged along the second direction DR2, a plurality of first depletion regions DPR1 formed by the plurality of gate semiconductor layers 150 and a plurality of second depletion regions DPR2 formed by the plurality of doping regions 138 may be alternately arranged along the second direction DR2. The plurality of doping regions 138 and the plurality of gate semiconductor layers 150 spaced apart and arranged along the second direction DR2 may be electrically connected to a single gate electrode 155. As the plurality of doping regions 138 are electrically connected to the gate electrode 155, holes may be injected and the plurality of doping regions 138 may not float.

Although some example embodiments of the disclosure have been described in detail above, the scope of the disclosure is not limited thereto, and various modifications and improvements made by those skilled in the art using the basic concept of the disclosure defined in the following claims also fall in the scope of the disclosure.

Embodiments are set out in the following clauses:
Clause 1.A semiconductor device comprising:
   a substrate;
   a channel layer on the substrate;
   a barrier layer on the channel layer;
   a gate electrode on the barrier layer;
   a source electrode and a drain electrode on opposite sides of the gate electrode, the source electrode and the drain electrode connected to the channel layer;
   a first field dispersion layer connected to the source electrode, the first field dispersion layer extending from above the gate electrode toward the drain electrode; and
   a doping region buried below an upper surface of the barrier layer,
   wherein a distance between the doping region and the drain electrode is shorter than a distance between the first field dispersion layer and the drain electrode.
Clause 2.The semiconductor device of clause 1, wherein
   a side surface of the doping region is covered by the barrier layer and the channel layer, and
   wherein a lower surface of the doping region is covered by the channel layer.
Clause 3.The semiconductor device of clause 1 or clause 2, further comprising:
   a second field dispersion layer connected to the source electrode and extending from above the first field dispersion layer toward the drain electrode,
   wherein a distance between the doping region and the drain electrode is longer than a distance between the second field dispersion layer and the drain electrode.
Clause 4.A semiconductor device comprising:
   a substrate;
   a channel layer on the substrate;
   a barrier layer on the channel layer;
   a gate electrode on the barrier layer;
   a source electrode and a drain electrode located on opposite sides of the gate electrode, the source electrode and the drain electrode are connected to the channel layer;
   a first field dispersion layer connected to the source electrode, the first field dispersion layer extending from above the gate electrode toward the drain electrode; and
   a doping region surrounded by the barrier layer,
   wherein at least a portion of the doping region overlaps the gate electrode in a direction perpendicular to an upper surface of the substrate,
   wherein an upper surface of the doping region is at a same level as an upper surface of the barrier layer, and
   wherein one side of the doped region is closer to the drain electrode than a side surface of the first field dispersion layer, the side surface of the first field dispersion layer is between the gate electrode and the drain electrode.
Clause 5. The semiconductor device of clause 4, wherein a lower surface of the doping region is at a level lower than an upper surface of the channel layer.

## Claims

1. A semiconductor device comprising:
a substrate (110);
a channel layer (132) on the substrate (110);
a barrier layer (136) on the channel layer (132);
a gate electrode (155) on the barrier layer (136);
a source electrode (173) and a drain electrode (175) on opposite sides of the gate electrode (155), the source electrode (173) and the drain electrode (175) are connected to the channel layer (132);
a first field dispersion layer (177a) connected to the source electrode (173), the first field dispersion layer (177a) extending from above the gate electrode (155) toward the drain electrode (175); and
a doping region (138) extending from an upper surface of the barrier layer (136) toward an upper surface of the substrate (110),
wherein one side surface of the doping region (138) is closer to the drain electrode (175) than a side surface of the first field dispersion layer (177a), the one side surface of the doping region (138) is between the gate electrode (155) and the drain electrode (175).

2. The semiconductor device of claim 1, further comprising:
a gate semiconductor layer (150) between the barrier layer (136) and the gate electrode (155),
wherein at least a portion of the doping region (138) is in contact with the gate semiconductor layer (150).

3. The semiconductor device of claim 2, wherein at least a portion of the doping region (138) overlaps with the gate electrode (155) and the gate semiconductor layer (150) in a direction perpendicular to the upper surface of the substrate (110).

4. The semiconductor device of any preceding claim, further comprising:
a second field dispersion layer (177b) connected to the source electrode (173) and extending toward the drain electrode (175), the second field dispersion layer (177b) on the first field dispersion layer (177a),
wherein the one side surface of the doping region (138) is spaced apart from the drain electrode (175) by a first distance,
a side surface of the second field dispersion layer (177b) is spaced apart from the drain electrode (175) by a second distance,
the first distance is greater than the second distance, and
the side surface of the second field dispersion layer (177b) is between the gate electrode (155) and the drain electrode (175).

5. The semiconductor device of any preceding claim, wherein a lower surface of the doping region (138) is at a level lower than an upper surface of the channel layer (132).

6. The semiconductor device of claim 5, wherein the doping region (138) includes:
a first doping region (138a) in the barrier layer (136), the first doping region (138a) includes a same material as the barrier layer (138), and
a second doping region (138b) in the channel layer (132), the second doping region (138b) includes a same material as the channel layer (132),
wherein the first doping region (138a) and the second doping region (138b) include a same dopant.

7. The semiconductor device of any of claims 1-4, wherein a lower surface of the doping region (138) is at a level higher than a lower surface of the barrier layer (136).

8. The semiconductor device of any preceding claim, wherein the doping region (138) extends in a direction parallel to an extension direction of the source electrode (173) and the drain electrode (175) in a plan view.

9. The semiconductor device of any preceding claim, wherein
the doping region (138) includes a plurality of doping regions (138), and
the plurality of doping regions (138) are spaced apart from each other in a second direction (DR2) parallel to an extension direction of the source electrode (173) and the drain electrode (175) in a plan view.

10. The semiconductor device of claim 9, wherein a width of each of the plurality of doping regions (138) in the second direction (DR2) increases in a first direction (DR1) approaching the drain electrode (175).

11. The semiconductor device of claim 9 or claim 10, wherein portions of the first field dispersion layer (177a) overlapping the plurality of doping regions (138) in a plan view protrude toward the drain electrode (175).

12. The semiconductor device of claim 1, further comprising:
a gate semiconductor layer (150) between the barrier layer (136) and the gate electrode (155), and
a protective layer (141) covering a side surface and an upper surface of the gate semiconductor layer (150),
wherein the doping region (138) is spaced apart from the gate semiconductor layer (150) toward the drain electrode (175).

13. The semiconductor device of claim 12, wherein the gate electrode (155) includes:
a first portion (155a) penetrating the protective layer (141) and contacting the gate semiconductor layer (150),
a second portion (155b) penetrating the protective layer (141) and contacting the doped region (138), and
a third portion (155c) connecting the first portion (155a) and the second portion (155b).

14. The semiconductor device of claim 1, further comprising:
a plurality of gate semiconductor layers (150) spaced apart from each other in a direction parallel to an extension direction of the source electrode (173) and drain electrode (175), and
a plurality of doping regions (138) arranged alternately with the plurality of gate semiconductor layers (150),
wherein the gate electrode (155) contacts the plurality of gate semiconductor layers (150) and the plurality of doping regions (138), the gate electrode (155) extends in the direction parallel to the extension direction of the source electrode (173) and the drain electrode (175).

15. The semiconductor device of claim 14, wherein a portion of the gate electrode (155) contacting the plurality of gate semiconductor layers (150) is at a level higher than a portion of the gate electrode (155) contacting the plurality of doping regions (138).
